(19) Europäisches Patentamt
European Patent Office
Office européen des brevets

(11) **EP 4 495 920 A1**

(12) **EUROPEAN PATENT APPLICATION**
published in accordance with Art. 153(4) EPC

(43) Date of publication:
**22.01.2025 Bulletin 2025/04**

(21) Application number: **23770673.4**

(22) Date of filing: **10.03.2023**

(51) International Patent Classification (IPC):
*G09F 9/30* (2006.01)    *G09F 9/302* (2006.01)
*H05B 33/02* (2006.01)    *H05B 33/04* (2006.01)
*H05B 33/12* (2006.01)    *H05B 33/22* (2006.01)
*H10K 50/00* (2023.01)    *H10K 59/00* (2023.01)

(52) Cooperative Patent Classification (CPC):
G09F 9/30; G09F 9/302; H05B 33/02; H05B 33/04;
H05B 33/12; H05B 33/22; H10K 50/00; H10K 59/00

(86) International application number:
**PCT/JP2023/009274**

(87) International publication number:
**WO 2023/176718 (21.09.2023 Gazette 2023/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.03.2022 JP 2022041081**

(71) Applicant: **Sony Semiconductor Solutions
Corporation
Atsugi-shi, Kanagawa 243-0014 (JP)**

(72) Inventors:
• **KASAHARA, Naoya
  Atsugi-shi, Kanagawa 243-0014 (JP)**
• **SAWABE, Tomoaki
  Atsugi-shi, Kanagawa 243-0014 (JP)**
• **OGURA, Masaya
  Atsugi-shi, Kanagawa 243-0014 (JP)**
• **AOYAGI, Kenichi
  Atsugi-shi, Kanagawa 243-0014 (JP)**
• **SHIRAIWA, Toshiaki
  Atsugi-shi, Kanagawa 243-0014 (JP)**

• **NEGISHI, Eisuke
  Atsugi-shi, Kanagawa 243-0014 (JP)**
• **TATEJIMA, Kota
  Atsugi-shi, Kanagawa 243-0014 (JP)**
• **ITOU, Hiroyuki
  Atsugi-shi, Kanagawa 243-0014 (JP)**
• **YOSHIDA, Jun
  Atsugi-shi, Kanagawa 243-0014 (JP)**
• **KATO, Takayoshi
  Atsugi-shi, Kanagawa 243-0014 (JP)**
• **NISHIKAWA, Hiroshi
  Atsugi-shi, Kanagawa 243-0014 (JP)**
• **HAMASHITA, Daisuke
  Atsugi-shi, Kanagawa 243-0014 (JP)**
• **ICHIKAWA, Tomoyoshi
  Atsugi-shi, Kanagawa 243-0014 (JP)**
• **FUJIMAKI, Hiroshi
  Atsugi-shi, Kanagawa 243-0014 (JP)**
• **OHSHIMA, Keiji
  Atsugi-shi, Kanagawa 243-0014 (JP)**
• **SUGIYASU, Masataka
  Atsugi-shi, Kanagawa 243-0014 (JP)**

(74) Representative: **D Young & Co LLP
3 Noble Street
London EC2V 7BQ (GB)**

(54) **DISPLAY DEVICE**

(57)    A leakage current is suppressed in a display device provided with an organic EL film.

A display device includes a first electrode, a second electrode, and an organic EL film. In this display device, the first electrode and the second electrode have different polarities. Furthermore, in the display device, the organic EL film is formed between the first electrode and the second electrode when viewed from a direction that is parallel to a predetermined plane, and formed in a predetermined number of sub-pixels and a connection portion that is a portion mutually connecting adjacent sub-pixels in an inter-pixel region between the predetermined number of sub-pixels, when viewed from a vertical direction that is vertical to the predetermined plane.

EP 4 495 920 A1

# FIG. 2

## Description

TECHNICAL FIELD

The present technology relates to a display device. Specifically, the present technology relates to a display device using a light emitting element.

BACKGROUND ART

Conventionally, organic electro luminescence (EL) has been used in display devices and the like in order to reduce backlight and improve image quality. For example, there has been proposed a display device having a structure in which a first electrode is disposed for every sub-pixel, an organic EL film and a second electrode are stacked on the first electrode, and the organic EL film and the second electrode are connected in all sub-pixels in a display region and outside the display region (see, for example, Patent Document 1).

CITATION LIST

PATENT DOCUMENT

Patent Document 1: Japanese Patent Application Laid-Open No. 2014-232568

SUMMARY OF THE INVENTION

PROBLEMS TO BE SOLVED BY THE INVENTION

In the above-described related art, the organic EL film is connected inside and outside the display region to prevent cracking and peeling of the organic EL film in a patterning process. However, in the above-described related art, it is difficult to suppress a leakage current through the organic EL film.

The present technology has been made in view of such a situation, and an object thereof is to suppress a leakage current in a display device provided with an organic EL film.

SOLUTIONS TO PROBLEMS

The present technology has been made to solve the above-described problem, and a first aspect thereof is a display device including: a first electrode and a second electrode having different polarities; and an organic EL film formed between the first electrode and the second electrode when viewed from a direction that is parallel to a predetermined plane, the organic EL film being formed in a predetermined number of sub-pixels and a connection portion that is a portion mutually connecting adjacent sub-pixels in an inter-pixel region between the above-described predetermined number of sub-pixels, when viewed from a vertical direction that is vertical to the above-described predetermined plane.

This configuration brings about an effect of suppressing the occurrence of leakage current.

Furthermore, in the first aspect, the above-described connection portion may be a part of the above-described inter-pixel region. This configuration brings about an effect of suppressing the occurrence of leakage current.

Furthermore, in the first aspect, the above-described first electrode may be formed for every sub-pixel among the above-described sub-pixels in a predetermined region surrounding the sub-pixel when viewed from the above-described vertical direction, and the above-described second electrode may be formed in the above-described predetermined number of sub-pixels and in the connection portion when viewed from the above-described vertical direction. This configuration brings about an effect that the sub-pixels are individually driven.

Furthermore, in the first aspect, there may be further provided a protective film covering a pixel array unit in which the above-described predetermined number of sub-pixels are arranged, in which a film thickness of a predetermined portion of the above-described protective film covering the above-described predetermined number of sub-pixels may be larger than a film thickness of a portion that is not considered as the above-described predetermined portion. This configuration brings about an effect of improving light extraction efficiency.

Furthermore, in the first aspect, the above-described connection portion may be formed in a portion that is not considered as a rectangular region in the above-described inter-pixel region. This configuration brings about an effect of suppressing the occurrence of leakage current.

Furthermore, in the first aspect, the above-described predetermined number of sub-pixels may be arranged in the pixel array unit, and a width of the above-described second electrode may be a value according to a distance from a central portion of the above-described pixel array unit. This configuration brings about an effect of suppressing shading.

Furthermore, in the first aspect, one end of the above-described connection portion may be connected to one of a pair of adjacent sub-pixels among the above-described predetermined number of sub-pixels, another end of the above-described connection portion may be connected to another one of the above-described pair of sub-pixels, and a width of the above-described one end may be different from a width of the above-described another end. This configuration brings about an effect that principal ray control is performed.

Furthermore, in the first aspect, the above-described predetermined number of sub-pixels may be arranged in the pixel array unit, and the above-described width may be a value according to a distance from a center of the above-described pixel array unit. This configuration brings about an effect that principal ray control is performed.

Furthermore, in the first aspect, the above-described connection portion may include first and second connection portions having a rectangular shape, and a pair of adjacent sub-pixels among the above-described predetermined number of sub-pixels may be connected by the above-described first and second connection portions. This configuration brings about an effect of preventing a connection failure.

Furthermore, in the first aspect, an edge of the above-described connection portion may have an arc shape. This configuration brings about an effect of preventing a connection failure.

Furthermore, in the first aspect, a width of a center of the above-described connection portion may be wider than widths of both ends of the above-described connection portion. This configuration brings about an effect of improving light extraction efficiency.

Furthermore, in the first aspect, an opened region in which the above-described organic EL film is not formed may be provided in a central portion of the above-described connection portion. This configuration brings about an effect of improving light extraction efficiency.

Furthermore, in the first aspect, the above-described organic EL film may be formed in the above-described predetermined number of sub-pixels, in the above-described connection portion, and in a bridge region mutually connecting the above-described connection portions in the above-described inter-pixel region when viewed from the above-described vertical direction. This configuration brings about an effect of suppressing an increase in resistance of a cathode electrode.

Furthermore, in the first aspect, a shape of each of the above-described sub-pixels may be a figure in which a core portion and a plurality of protrusions are combined when viewed from the above-described vertical direction. This configuration brings about an effect of improving light extraction efficiency.

Furthermore, in the first aspect, a shape of the above-described organic EL film as viewed from the above-described vertical direction may be a shape having a predetermined number of bent portions. This configuration brings about an effect of improving light extraction efficiency.

Furthermore, in the first aspect, unevenness may be formed on a side wall of each of the above-described sub-pixels when viewed from a direction that is parallel to the above-described predetermined plane. This configuration brings about an effect of improving light extraction efficiency.

Furthermore, in the first aspect, the above-described predetermined number of sub-pixels may be arranged in a delta array. This configuration brings about an effect of suppressing a leakage current in a delta-array display device.

Furthermore, in the first aspect, the above-described predetermined number of sub-pixels may be arranged in a square array. This configuration brings about an effect of suppressing a leakage current in a square-array display device.

Furthermore, in the first aspect, the above-described predetermined number of sub-pixels may be arranged in a stripe array. This configuration brings about an effect of suppressing a leakage current in a stripe-array display device.

Furthermore, in the first aspect, the above-described organic EL film is formed in a frame surrounding a predetermined number of the above-described sub-pixels, in a predetermined number of the above-described sub-pixels, and in the above-described connection portion when viewed from the above-described vertical direction, a plurality of openings is formed in the above-described organic EL film when viewed from the above-described vertical direction, the above-described plurality of openings includes a first opening having at least one edge in contact with the above-described frame and a second opening that is not considered as the above-described first opening, and a smallest angle among angles formed by two edges of the above-described first opening may not exceed a smallest angle among angles formed by two edges of the above-described second opening. This configuration brings about an effect of suppressing deterioration of the frame and pixels around the frame.

BRIEF DESCRIPTION OF DRAWINGS

Fig. 1 is a block diagram illustrating a configuration example of a display device according to a first embodiment of the present technology.
Fig. 2 is an example of a plan view and a cross-sectional view of a pixel array unit according to the first embodiment of the present technology.
Fig. 3 is an example of a plan view of the pixel array unit and a cross-sectional view taken along a line segment including a connection portion according to the first embodiment of the present technology.
Fig. 4 is an example of a plan view and a cross-sectional view of a pixel array unit in a comparative example.
Fig. 5 is a diagram for explaining a manufacturing process up to photolithography according to the first embodiment of the present technology.
Fig. 6 is a view for explaining a manufacturing process up to film formation of a protective film according to the first embodiment of the present technology.
Fig. 7 is an example of a delta-array pixel array unit in which sub-pixels arranged in an oblique direction are mutually connected according to the first embodiment of the present technology.
Fig. 8 is an example of a delta-array pixel array unit in which sub-pixels arranged in a horizontal direction are mutually connected according to the first embodiment of the present technology.

Fig. 9 is an example of a delta-array pixel array unit in which sub-pixels arranged in a vertical direction are mutually connected according to the first embodiment of the present technology.

Fig. 10 is an example of a delta-array pixel array unit in which sub-pixels arranged in a horizontal direction, a vertical direction, and an oblique direction are mutually connected according to the first embodiment of the present technology.

Fig. 11 is an example of a delta-array pixel array unit in which sub-pixels arranged in a horizontal direction and a vertical direction are mutually connected according to the first embodiment of the present technology.

Fig. 12 is an example of a square-array pixel array unit in which sub-pixels arranged in an oblique direction are mutually connected according to the first embodiment of the present technology.

Fig. 13 is an example of a square-array pixel array unit in which sub-pixels arranged in a vertical direction are mutually connected according to the first embodiment of the present technology.

Fig. 14 is an example of a square-array pixel array unit in which sub-pixels arranged in a horizontal direction are mutually connected according to the first embodiment of the present technology.

Fig. 15 is an example of a square-array pixel array unit in which sub-pixels arranged in a horizontal direction and a vertical direction are mutually connected according to the first embodiment of the present technology.

Fig. 16 is an example of a square-array pixel array unit in which sub-pixels arranged in a horizontal direction, a vertical direction, and an oblique direction are mutually connected according to the first embodiment of the present technology.

Fig. 17 is an example of a stripe-array pixel array unit in which sub-pixels arranged in a vertical direction are mutually connected according to the first embodiment of the present technology.

Fig. 18 is an example of a stripe-array pixel array unit in which sub-pixels arranged in a horizontal direction are mutually connected according to the first embodiment of the present technology.

Fig. 19 is an example of a stripe-array pixel array unit in which sub-pixels arranged in a vertical direction are mutually connected and connection portions arranged in a horizontal direction are mutually connected, according to the first embodiment of the present technology.

Fig. 20 is an example of a stripe-array pixel array unit in which sub-pixels arranged in a horizontal direction and a vertical direction are mutually connected according to the first embodiment of the present technology.

Fig. 21 is an example of a stripe-array pixel array unit in which sub-pixels arranged in a horizontal direction and a vertical direction are mutually connected and connection portions arranged in a horizontal direction are mutually connected, according to the first embodiment of the present technology.

Fig. 22 is an example of a plan view of a pixel array unit in which a connection portion is formed in a portion other than a rectangular portion, according to the first embodiment of the present technology.

Fig. 23 is an example of a plan view of a pixel array unit according to a second embodiment of the present technology.

Fig. 24 is an example of a plan view of a delta-array pixel array unit according to a third embodiment of the present technology.

Fig. 25 is an example of a plan view of a pixel array unit in which a width is changed according to a distance from a central portion in a delta array according to the third embodiment of the present technology.

Fig. 26 is an example of a plan view of a square-array pixel array unit according to the third embodiment of the present technology.

Fig. 27 is an example of a plan view of a pixel array unit in which a width is changed according to a distance from a central portion in a square array according to the third embodiment of the present technology.

Fig. 28 is an example of a plan view of a pixel array unit in which a connection portion is formed in a T shape according to the third embodiment of the present technology.

Fig. 29 is an example of a plan view of a pixel array unit according to a fourth embodiment of the present technology.

Fig. 30 is an example of a plan view of a pixel array unit in a modification of the fourth embodiment of the present technology.

Fig. 31 is another example of a plan view of a pixel array unit in a modification of the fourth embodiment of the present technology.

Fig. 32 is an example of a plan view of a pixel array unit according to a fifth embodiment of the present technology.

Fig. 33 is an example of a plan view of a pixel array unit in a first modification of the fifth embodiment of the present technology.

Fig. 34 is an example of a cross-sectional view of a pixel array unit taken along a line segment including a connection portion in the first modification of the fifth embodiment of the present technology.

Fig. 35 is an example of a plan view of a pixel array unit in a second modification of the fifth embodiment of the present technology.

Fig. 36 is an example of a cross-sectional view of the pixel array unit in the second modification of the fifth embodiment of the present technology.

Fig. 37 is an example of a plan view of a pixel array unit according to a sixth embodiment of the present technology.

Fig. 38 is an example of a cross-sectional view of the pixel array unit according to the sixth embodiment of the present technology.

Fig. 39 is an example of a cross-sectional view taken along a line segment including a connection portion according to the sixth embodiment of the present technology.

Fig. 40 is a view for explaining a manufacturing process of a display device according to the sixth embodiment of the present technology.

Fig. 41 is a diagram illustrating an example of a shape of a sub-pixel having four protrusions according to the sixth embodiment of the present technology.

Fig. 42 is a diagram illustrating an example of a shape of a sub-pixel having five protrusions according to the sixth embodiment of the present technology.

Fig. 43 is a diagram illustrating an example of a shape of a sub-pixel having six protrusions according to the sixth embodiment of the present technology.

Fig. 44 is a diagram illustrating an example of a shape of a sub-pixel having eight protrusions according to the sixth embodiment of the present technology.

Fig. 45 is a diagram illustrating an example of a pixel array unit in which sub-pixels each having four or five protrusions are arranged in a stripe array according to the sixth embodiment of the present technology.

Fig. 46 is a diagram illustrating an example of a pixel array unit in which sub-pixels each having six or eight protrusions are arranged in a stripe array according to the sixth embodiment of the present technology.

Fig. 47 is a diagram illustrating an example of a pixel array unit in which sub-pixels each having four or five protrusions are arranged in a delta array according to the sixth embodiment of the present technology.

Fig. 48 is a diagram illustrating an example of a pixel array unit in which sub-pixels each having six or eight protrusions are arranged in a delta array according to the sixth embodiment of the present technology.

Fig. 49 is a diagram illustrating an example of a pixel array unit in which sub-pixels each having four or five protrusions are arranged in a square array according to the sixth embodiment of the present technology.

Fig. 50 is a diagram illustrating an example of a pixel array unit in which sub-pixels each having six or eight protrusions are arranged in a square array according to the sixth embodiment of the present technology.

Fig. 51 is a plan view of an organic EL film and a cross-sectional view of a pixel array unit according to a seventh embodiment of the present technology.

Fig. 52 is a diagram for explaining a manufacturing process up to photolithography according to the seventh embodiment of the present technology.

Fig. 53 is a diagram for explaining a manufacturing process up to film formation of a low refractive index film according to the seventh embodiment of the present technology.

Fig. 54 is a diagram illustrating an example of a plan view of the organic EL film according to the seventh embodiment of the present technology.

Fig. 55 is a diagram illustrating another example of a plan view of the organic EL film according to the seventh embodiment of the present technology.

Fig. 56 is a diagram illustrating an example of a cross-sectional view of the pixel array unit according to the seventh embodiment of the present technology.

Fig. 57 is a diagram illustrating an example of a plan view of a pixel array unit in which sub-pixels are arranged in a stripe array according to the seventh embodiment of the present technology.

Fig. 58 is a diagram illustrating an example of a plan view of a pixel array unit in which sub-pixels are arranged in a delta array according to the seventh embodiment of the present technology.

Fig. 59 is a diagram illustrating an example of a plan view of a pixel array unit in which sub-pixels are arranged in a square array according to the seventh embodiment of the present technology.

Fig. 60 is a diagram illustrating another example of a plan view of a pixel array unit in which sub-pixels are arranged in a square array according to the seventh embodiment of the present technology.

Fig. 61 is a diagram illustrating an example of a cross-sectional view of a pixel array unit according to an eighth embodiment of the present technology.

Fig. 62 is a diagram for explaining a manufacturing process according to the eighth embodiment of the present technology.

Fig. 63 is a diagram illustrating an example of an arrangement method for sub-pixels according to the eighth embodiment of the present technology.

Fig. 64 is a diagram illustrating an example of an arrangement method for sub-pixels when a cathode contact electrode is disposed, according to the eighth embodiment of the present technology.

Fig. 65 is a diagram illustrating an example of a cross-sectional view of a pixel array unit in a first modification of the eighth embodiment of the present technology.

Fig. 66 is a diagram for explaining a manufacturing process up to formation of a low refractive index film in the first modification of the eighth embodiment of the present technology.

Fig. 67 is a diagram for explaining a manufacturing process up to formation of a texture film in the first modification of the eighth embodiment of the present technology.

Fig. 68 is a diagram illustrating an example of a cross-sectional view of a pixel array unit in a second modification of the eighth embodiment of the present technology.

Fig. 69 is a diagram for explaining a manufacturing process in the second modification of the eighth embodiment of the present technology.

Fig. 70 is a diagram illustrating an example of a cross-sectional view of a pixel array unit in which a position of unevenness is changed in the second modification of the eighth embodiment of the present technology.

Fig. 71 is a diagram illustrating an example of a cross-sectional view of a pixel array unit in a third modification of the eighth embodiment of the present technology.

Fig. 72 is a diagram illustrating an example of a cross-sectional view of a pixel array unit in a fourth modification of the eighth embodiment of the present technology.

Fig. 73 is a plan view illustrating an example of a layout of an organic EL film according to the first embodiment of the present technology.

Fig. 74 is an example of a perspective view of an opening according to the first embodiment of the present technology.

Fig. 75 is a plan view illustrating an example of a layout of the organic EL film according to a ninth embodiment of the present technology.

Fig. 76 is a plan view illustrating an example of a layout of the organic EL film in a first modification of the ninth embodiment of the present technology.

Fig. 77 is a plan view illustrating an example of a layout of the organic EL film in a second modification of the ninth embodiment of the present technology.

Fig. 78 is a plan view illustrating an example of a layout of the organic EL film in a third modification of the ninth embodiment of the present technology.

Fig. 79 is a conceptual diagram for explaining a relationship among a normal line LN passing through a center of a light emitting unit, a normal line LN' passing through a center of a lens member, and a normal line LN" passing through a center of a wavelength selection unit.

Fig. 80 is a conceptual diagram for explaining a relationship among the normal line LN passing through a center of the light emitting unit, the normal line LN' passing through a center of the lens member, and the normal line LN" passing through a center of the wavelength selection unit.

Fig. 81 is a conceptual diagram for explaining a relationship among the normal line LN passing through a center of the light emitting unit, the normal line LN' passing through a center of the lens member, and the normal line LN" passing through a center of the wavelength selection unit.

Fig. 82 is a conceptual diagram for explaining a relationship among the normal line LN passing through a center of the light emitting unit, the normal line LN' passing through a center of the lens member, and the normal line LN" passing through a center of the wavelength selection unit.

Fig. 83 is a schematic cross-sectional view for explaining a first example and a second example of a resonator structure.

Fig. 84 is a schematic cross-sectional view for explaining a third example and a fourth example of the resonator structure.

Fig. 85 is a schematic cross-sectional view for explaining a fifth example and a sixth example of the resonator structure.

Fig. 86 is a schematic cross-sectional view for explaining a seventh example of the resonator structure.

Fig. 87 is a front view and a rear view illustrating an example of an external appearance of a digital still camera.

Fig. 88 is a perspective view of an example of an external appearance of a head-mounted display.

Fig. 89 is a perspective view illustrating an example of an external appearance of a television device.

Fig. 90 is an external view of a see-through head-mounted display.

Fig. 91 is an external view illustrating an example of an electronic device to which a display unit according to an embodiment of the present disclosure can be applied.

Fig. 92 is a view illustrating an internal state of a vehicle from a rear side to a front side of the vehicle, and a view illustrating an internal state of the vehicle from an oblique rear side to an oblique front side of the vehicle.

## MODE FOR CARRYING OUT THE INVENTION

Hereinafter, modes for carrying out the present technology (hereinafter referred to as embodiments) will be described. The description will be given in the following order.

1. First embodiment (example in which organic EL film is left at connection portion)

2. Second embodiment (example in which organic EL film is left at connection portion and width of cathode electrode is adjusted)

3. Third Embodiment (example in which organic EL film is left at connection portion and width of connection portion is adjusted)

4. Fourth embodiment (example in which organic EL film is left at connection portion and connection portion is increased)

5. Fifth embodiment (example in which organic EL film is left at connection portion and width of center of connection portion is increased)

6. Sixth embodiment (example in which organic EL film is left at connection portion and shape of sub-pixel is changed)

7. Seventh embodiment (example in which organic EL film is left at connection portion and organic EL film is bent in sub-pixel)

8. Eighth embodiment (example in which organic EL film is left at connection portion and unevenness is formed on side wall of sub-pixel)

9. Ninth embodiment (example in which organic EL film is left at connection portion and angle of opening of organic EL film is increased)

<1. First embodiment>

[Configuration example of display device]

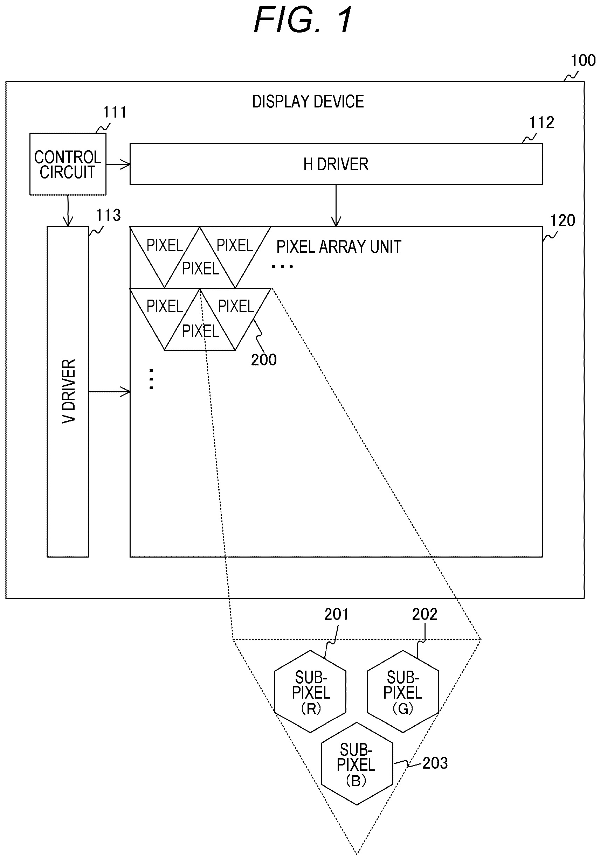

Fig. 1 is a block diagram illustrating a configuration example of a display device 100 according to a first embodiment of the present technology. The display device 100 includes a control circuit 111, an H driver 112, a V driver 113, and a pixel array unit 120. As the display device 100, a display integrated with an electronic device such as a smartphone or a personal computer, a monitor device separated from the electronic device, or the like is assumed.

In the pixel array unit 120, a plurality of pixels 200 is arranged. Each of the pixels 200 includes a plurality of sub-pixels that emits light beams of mutually different colors. For example, sub-pixels 201, 202, and 203 that emit R, G, and B light beams are disposed for every pixel 200. Each shape of the sub-pixels 201, 202, and 203 is a hexagonal shape, and these three are arranged in a triangular shape, for example. That is, the sub-pixels are arranged in a delta array. Note that a shape and an arrangement of the sub-pixels are not limited to the hexagonal shape and the delta array.

The control circuit 111 controls a drive timing of each of the H driver 112 and the V driver 113 on the basis of image data. The H driver 112 drives the sub-pixels on a column basis. The V driver 113 drives the sub-pixels on a row basis.

[Configuration example of pixel array unit]

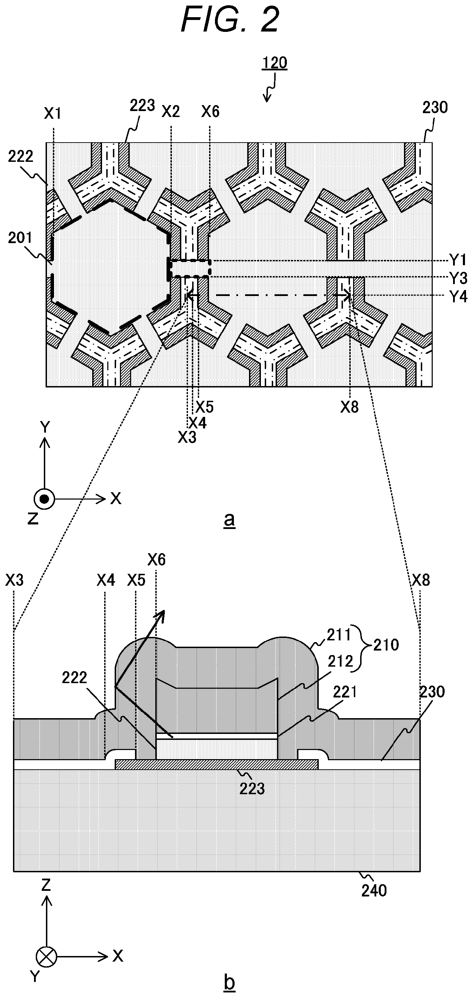

Fig. 2 is an example of a plan view and a cross-sectional view of the pixel array unit 120 according to the first embodiment of the present technology. In the figure, a is an example of a plan view of the pixel array unit 120, and b in the figure is an example of a cross-sectional view of the pixel array unit 120.

The plurality of sub-pixels such as the sub-pixel 201 is arranged on a predetermined plane. Hereinafter, an axis perpendicular to the plane is referred to as a "Z axis", and a predetermined axis parallel to the plane will be assumed as an "X axis". An axis perpendicular to the X axis and the Z axis will be assumed as a "Y axis". Furthermore, the X-axis direction can also be referred to as a "horizontal direction". The Y-axis direction can also be referred to as a "vertical direction".

As described above, each of the sub-pixels has, for example, a hexagonal shape. A region surrounded by a one-dotted chain line in a of the figure indicates the sub-pixel 201. Furthermore, the plurality of sub-pixels is arranged at regular intervals. A region between the sub-pixels is hereinafter referred to as an "inter-pixel region". In a of the figure, a region including a hatched portion and a white portion corresponds to the inter-pixel region.

In the figure, b illustrates a cross-sectional view of the pixel array unit 120 taken along a line segment between coordinates (X3, Y4) and (X8, Y4) in a of the figure. The pixel array unit 120 includes a substrate 240, protective films 211 and 212, a cathode electrode 221, an organic EL film 222, a plurality of anode electrodes 223, and an insulating film 230.

On a substrate plane of the substrate 240, the anode electrode 223 is formed for every sub-pixel. Hereinafter, a direction from the substrate 240 to the anode electrode 223 is referred to as an "upper" direction. The individual anode electrodes 223 are separated (in other words, insulated) from each other by the insulating film 230 formed between the anode electrodes 223. The hatched portion corresponds to the anode electrode 223, and the white portion corresponds to the insulating film 230.

The organic EL film 222 is formed above the anode electrode 223, and the cathode electrode 221 is formed above the organic EL film. Furthermore, the protective film 212 is formed above the cathode electrode 221, and the protective film 211 covering the protective film 212 and a portion between the pixels is formed above the protective film 212 and the portion between the pixels. Although the protective films 211 and 212 are separately formed in a manufacturing process described later, the protective films 211 and 212 are integrated and can be collectively treated as a protective film 210.

Since the protective film 212 is formed above the sub-pixel, a film thickness of a portion of the protective film 210 covering the sub-pixel is larger than a film thickness of other portion. In other words, the protective film 210 is raised at the portion of the sub-pixel. Furthermore, on the top and a side surface of the protective film 210, a low refractive index film (not illustrated) is filled. Therefore, light emitted from the sub-pixel is reflected upward by the side surface (in other words, a surface of the protective film) of the raised portion. A thick arrow in a of the figure indicates an optical path of light emitted by the sub-pixel.

Furthermore, in a of the figure, the protective films 211 and 212 and the cathode electrode 221 are omitted in order to clearly illustrate a planar shape of the organic EL film 222. A gray portion in a of the figure indicates the organic EL film 222. As exemplified in a of the figure, the organic EL film 222 is formed in each of the plurality of sub-pixels and in a portion mutually connecting adjacent sub-pixels in the inter-pixel region. In the inter-pixel region, a portion where the organic EL film 222 is formed is hereinafter referred to as a "connection portion". A rectangular portion of a dotted line surrounded by coordinates (X2, Y1), (X6, Y1), (X2, Y3), and (X6, Y3) in a of the figure corresponds to the connection portion.

Furthermore, the anode electrode 223 is formed in a predetermined region surrounding the sub-pixel when viewed from the Z-axis direction. An outer periphery (coordinate X5, and the like) of a hatched portion in a of the figure corresponds to an outer periphery of the anode electrode 223. Furthermore, a planar shape of the cathode electrode 221 is similar to that of the organic EL film 222. Furthermore, an end portion of the insulating film 230 reaches an end portion of the anode electrode 223, and is raised by a thickness of the electrode. A hexagonal shape of a one-dotted chain line passing through the coordinate X4 and the like indicates an outer periphery of the raised portion of the insulating film 230. In the following figures, the one-dotted chain line is omitted.

Note that the anode electrode 223 is an example of a first electrode described in the claims, and the cathode electrode 221 is an example of a second electrode described in the claims.

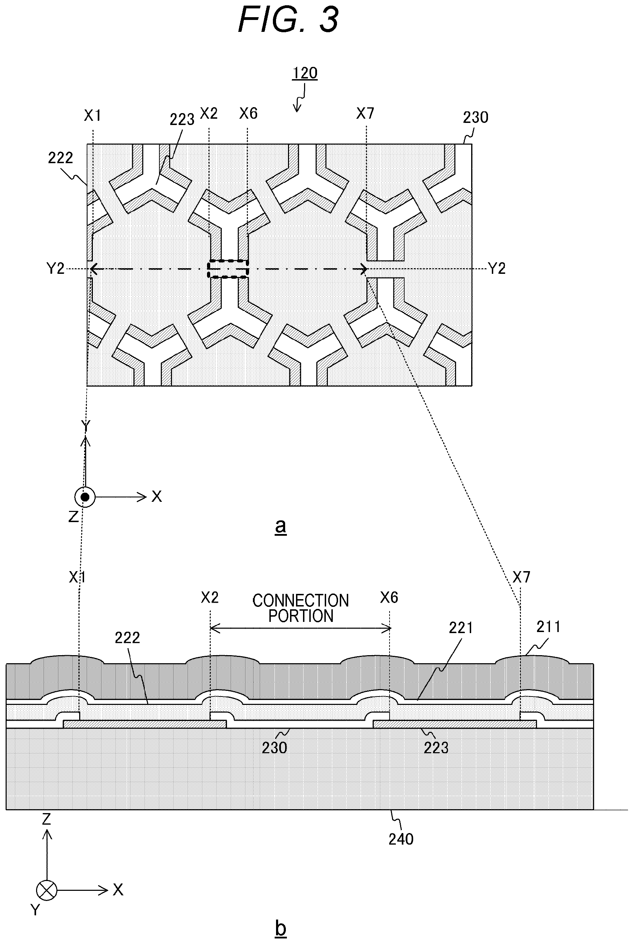

Fig. 3 is an example of a plan view of the pixel array unit 120 and a cross-sectional view taken along a line segment including the connection portion according to the first embodiment of the present technology. In the figure, a is an example of a plan view of the pixel array unit 120. In the figure, b illustrates a cross-sectional view taken along a line segment between coordinates (X1, Y2) and (X7, Y2) in a of the figure. It is assumed that the line segment includes the connection portion between sub-pixels. As exemplified in b of the figure, the organic EL film 222 and the cathode electrode 221 are also formed in the connection portion, and adjacent sub-pixels are mutually connected by the organic EL film 222 and the cathode electrode 221.

As exemplified in Figs. 2 and 3, the organic EL film 222 is formed in each of the plurality of sub-pixels and a portion (that is, the connection portion) that mutually connects adjacent sub-pixels in the inter-pixel region between the sub-pixels, when viewed from the Z-axis direction. Furthermore, the organic EL film 222 is formed between the cathode electrode 221 and the anode electrode 223 when viewed from the Y-axis direction or the X-axis direction. Note that the cathode electrode 221 and the anode electrode 223 are examples of a first electrode and a second electrode described in the claims.

Furthermore, the anode electrode 223 is formed for every sub-pixel in a predetermined region surrounding the sub-pixel when viewed from the Z-axis direction. Similarly to the organic EL film 222, the cathode electrode 221 is formed in each of the plurality of sub-pixels and in the connection portion when viewed from the Z-axis direction. Furthermore, a film thickness of a portion covering the sub-pixel in the protective film 210 (protective films 211 and 212) is larger than a film thickness of other portion.

Here, a display device 100 having a structure in which the organic EL film 222 is formed over the entire inter-pixel region and the protective film is not raised in the portion of the sub-pixel is assumed as a comparative example.

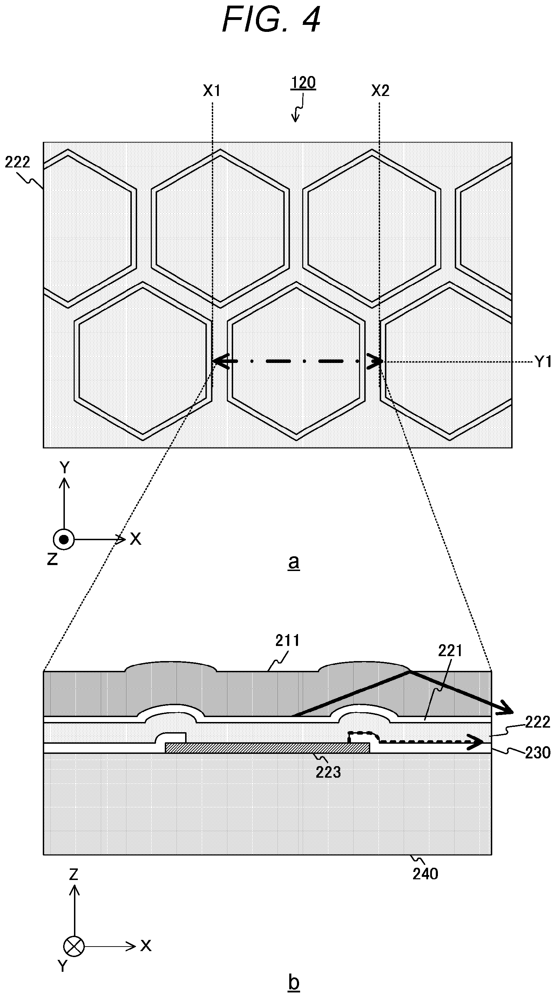

Fig. 4 is an example of a plan view and a cross-sectional view of a pixel array unit 120 in the comparative example. In the figure, a is an example of a plan view of the pixel array unit 120, and b of the figure is an example of a cross-sectional view taken along a line segment between coordinates (X1, Y1) and (X2, Y1) in a of the figure.

As exemplified in the figure, the organic EL film 222 is formed on each of the sub-pixels and the entire inter-pixel region between the sub-pixels. This similarly applies to the cathode electrode 221. Furthermore, a film thickness of the protective film 211 is assumed to be substantially the same between a portion above the sub-pixel and a portion above the inter-pixel region.

In the comparative example, since the sub-pixels are mutually connected by the organic EL film 222, a leakage current flowing through the organic EL film 222 tends to increase. A dotted arrow in the figure indicates the leakage current.

On the other hand, in the structure in which the organic EL film 222 is formed in a part (connection portion) of the inter-pixel region as exemplified in Figs. 2 and 3, the leakage current can be made smaller than that in the comparative example in which the organic EL film 222 is formed in the entire region. Note that, in a configuration in which no organic EL film 222 is formed over the entire inter-pixel region, the organic EL film 222 and the cathode electrode 221 on the sub-pixel are isolated, and power cannot be supplied to each of the sub-pixels. In order to prevent this state, in Fig. 2, the organic EL film 222 is left at the connection portion.

Furthermore, in the comparative example, since the protective film 211 is not raised above the sub-pixel, light emitted from the sub-pixel may be reflected downward on a surface of the protective film. A thick arrow in the figure indicates an optical path of light reflected by the surface of the protective film.

On the other hand, as exemplified in Fig. 2, in the structure in which the protective film is raised above the sub-pixel, light can be reflected upward by a side surface (a surface of the protective film) of the raised portion. As a result, light extraction efficiency can be improved as compared with the comparative example.

[Manufacturing method for display device]

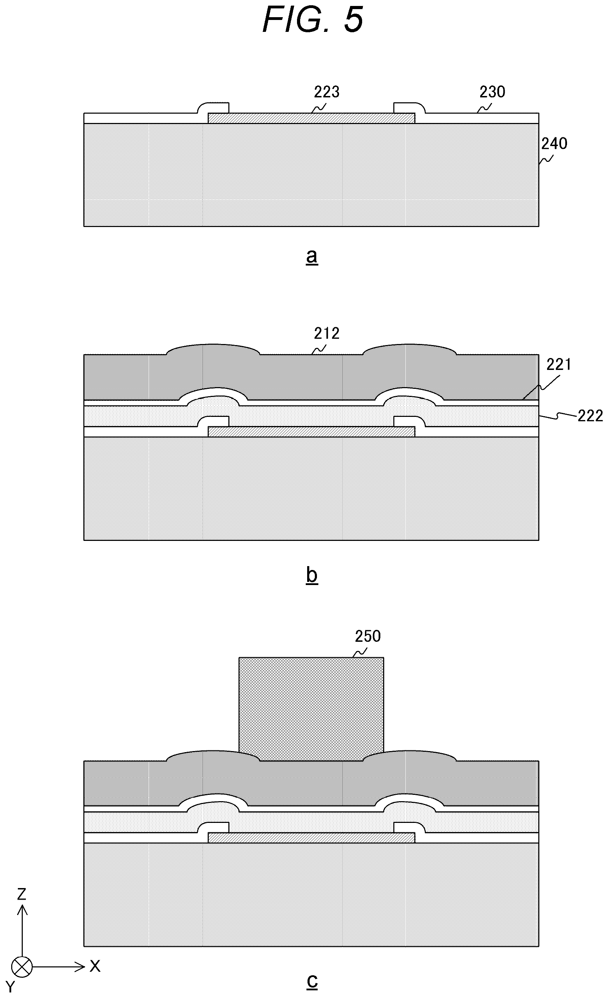

Fig. 5 is a diagram for explaining a manufacturing process up to photolithography according to the first embodiment of the present technology. In the figure, a illustrates a cross-sectional view of the pixel array unit 120 in which the anode electrode 223 and the insulating film 230 are formed. In the figure, b illustrates a cross-sectional view of the pixel array unit 120 in which the organic EL film 222, the cathode electrode 221, and the protective film 212 are formed. In the figure, c illustrates a cross-sectional view of the pixel array unit 120 when photolithography is performed.

As exemplified in a of the figure, a manufacturing system forms the anode electrode 223 for every sub-pixel on the substrate 240, and forms the insulating film 230 between the anode electrodes 223. Then, as exemplified in b of the figure, the manufacturing system forms the organic EL film 222 and the cathode electrode 221, and forms the protective film 212 on the cathode electrode 221. Subsequently, the manufacturing system disposes a photoresist 250 on each of the sub-pixels, and performs photolithography.

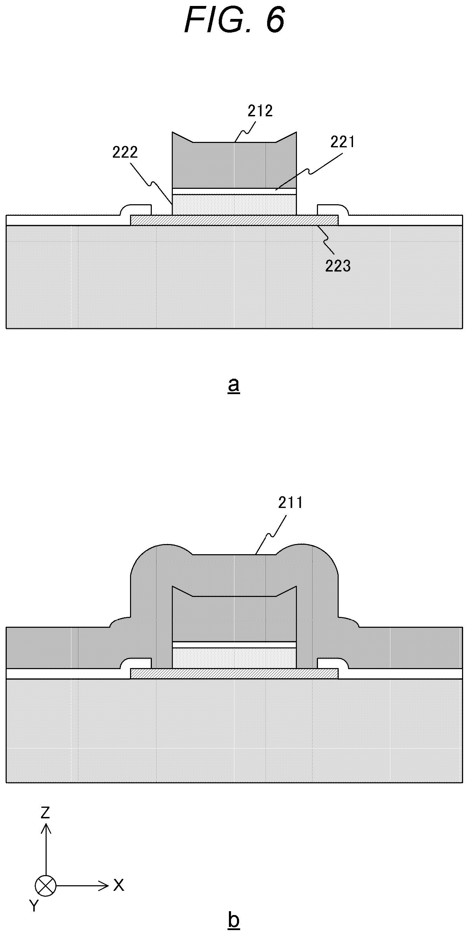

Fig. 6 is a diagram for explaining a manufacturing process up to film formation of the protective film 211 according to the first embodiment of the present technology. In the figure, a illustrates a cross-sectional view of the pixel array unit 120 after photolithography. In the figure, b illustrates a cross-sectional view of the pixel array unit 120 on which the protective film 211 is formed.

As exemplified in a of the figure, while the protective film 212 above the sub-pixel is left, the protective film 212 of other portion is removed by photolithography. Then, as exemplified in b of the figure, the manufacturing system forms the protective film 211. As a result, the pixel array unit 120 having the structure exemplified in Fig. 2 is obtained.

In Fig. 2, sub-pixels arranged in an oblique direction and the horizontal direction (X-axis direction) are mutually connected by the organic EL film 222, but the present technology is not limited to this configuration.

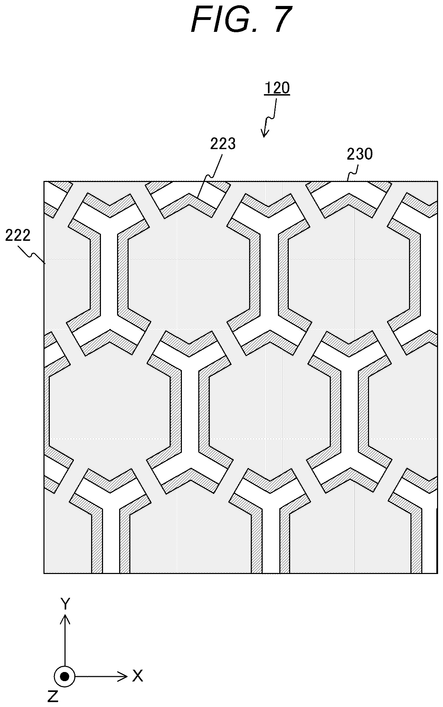

For example, as exemplified in Fig. 7, the number of connection portions in the horizontal direction can be reduced, to mutually connect only sub-pixels arranged in the oblique direction.

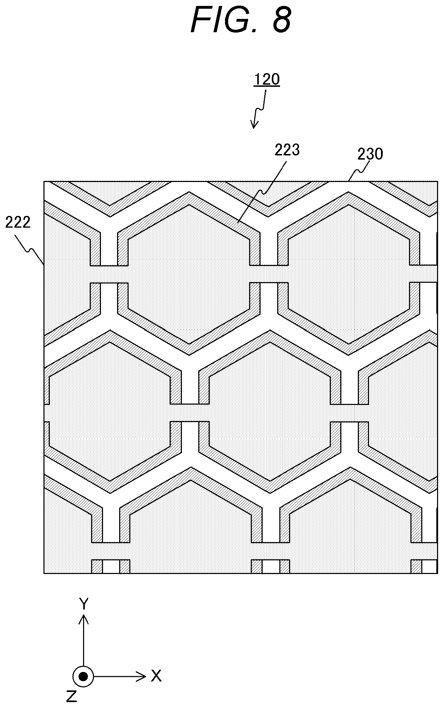

Alternatively, as exemplified in Fig. 8, it is also possible to reduce the number of connection portions in the oblique direction, to mutually connect only sub-pixels arranged in the horizontal direction.

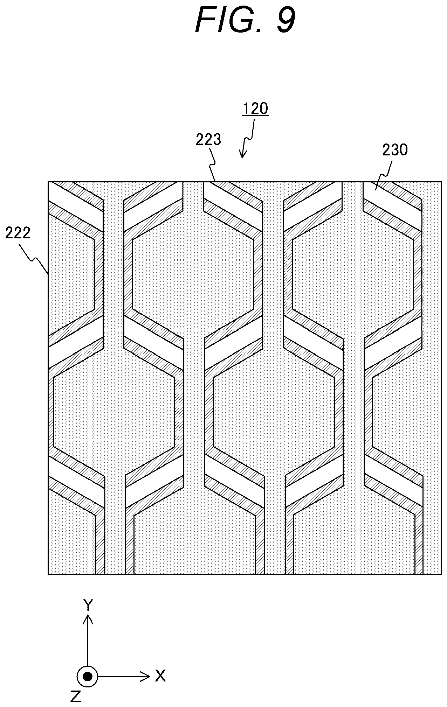

Alternatively, as exemplified in Fig. 9, it is also possible to reduce the number of connection portions in the horizontal direction and the oblique direction, provide connection portions in a vertical direction (Y-axis direction), to mutually connect sub-pixels arranged in the vertical direction.

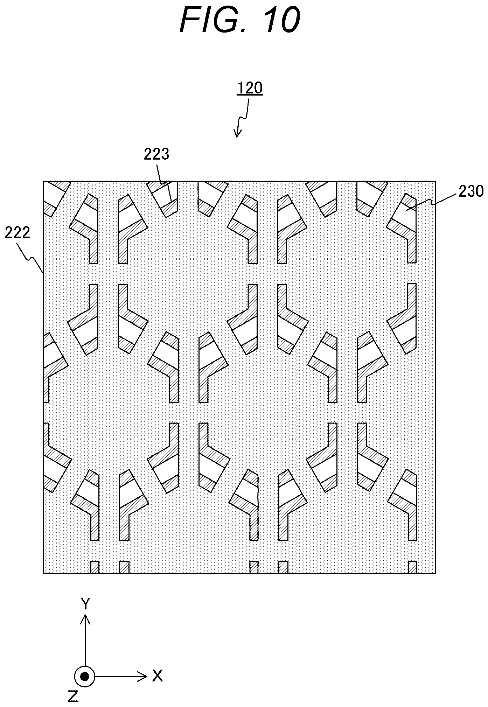

Alternatively, as exemplified in Fig. 10, connection portions in the vertical direction may be added, to mutually connect sub-pixels arranged in the horizontal direction, the vertical direction, and the oblique direction.

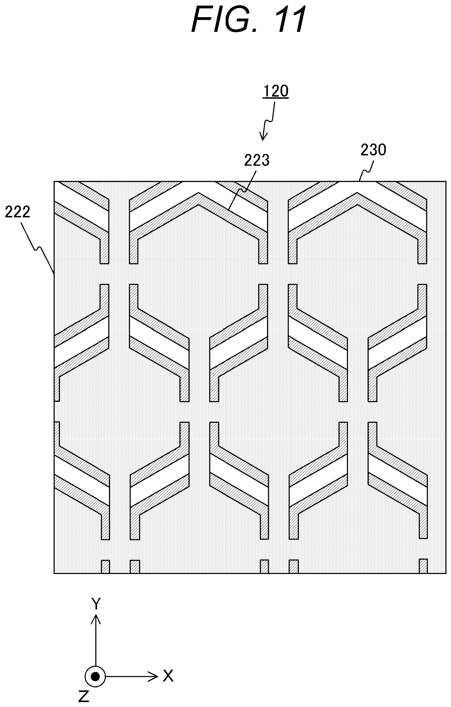

Alternatively, as exemplified in Fig. 11, it is also possible to reduce the number of connection portions in the oblique direction and add the connection portions in the horizontal direction, to mutually connect sub-pixels arranged in the horizontal direction and the vertical direction.

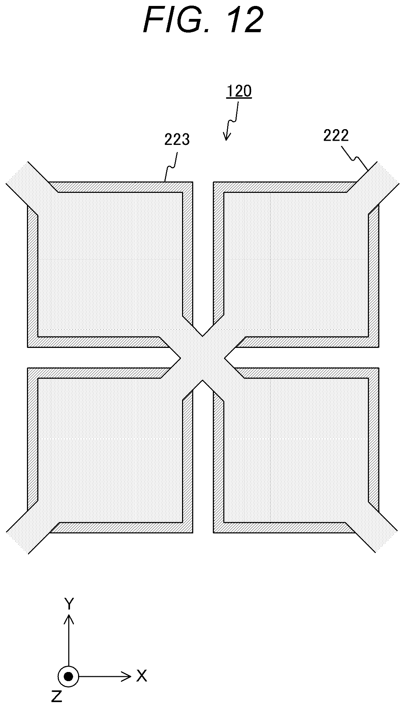

Furthermore, in Fig. 2 and Figs. 7 to 11, the sub-pixels are arranged in a delta array, but the present technology is not limited to this configuration. As exemplified in Figs. 12 to 16, the sub-pixels may have a square shape, and may be arranged in a square array.

At that time, as exemplified in Fig. 12, the connection portions may be provided in the oblique direction to mutually connect sub-pixels arranged in the oblique direction.

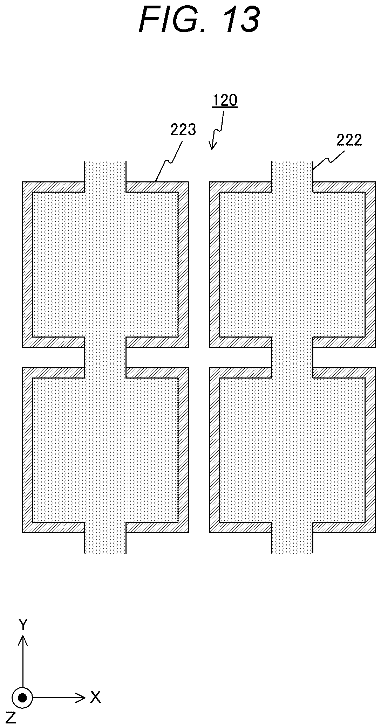

Alternatively, as exemplified in Fig. 13, the connection portions may be provided in the vertical direction to mutually connect sub-pixels arranged in the vertical direction.

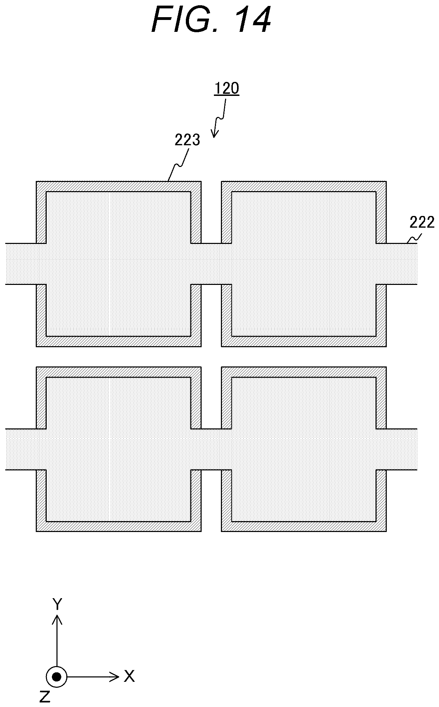

Alternatively, as exemplified in Fig. 14, the connection portions may be provided in the horizontal direction to mutually connect sub-pixels arranged in the horizontal direction.

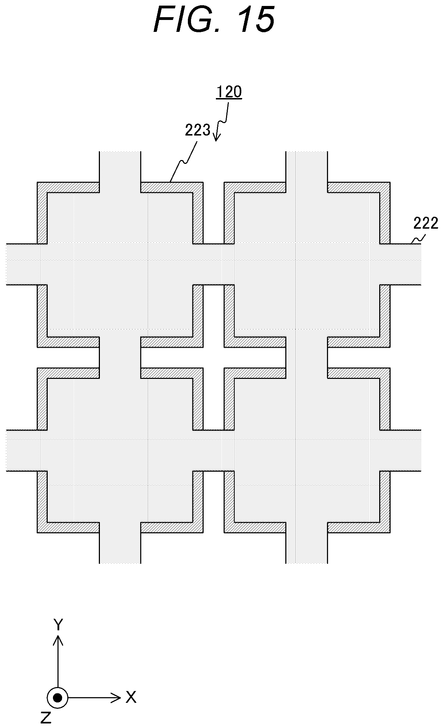

Alternatively, as exemplified in Fig. 15, the connection portions may be provided in the horizontal direction and the vertical direction, to mutually connect sub-pixels arranged in the horizontal direction and the vertical direction.

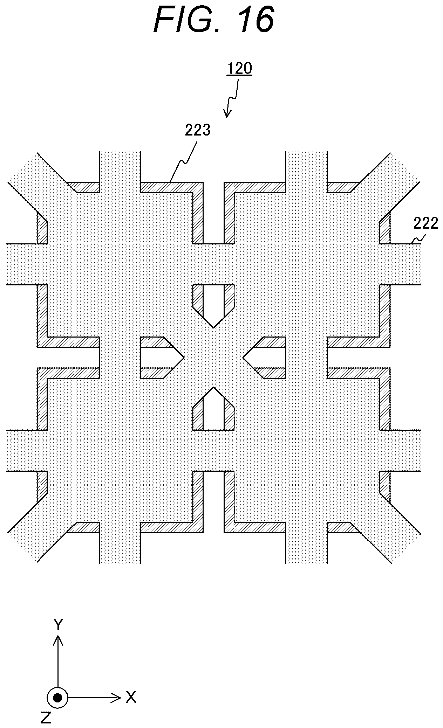

Alternatively, as exemplified in Fig. 16, the connection portions may be provided in the horizontal direction, the vertical direction, and the oblique direction, to mutually connect sub-pixels arranged in the horizontal direction, the vertical direction, and the oblique direction.

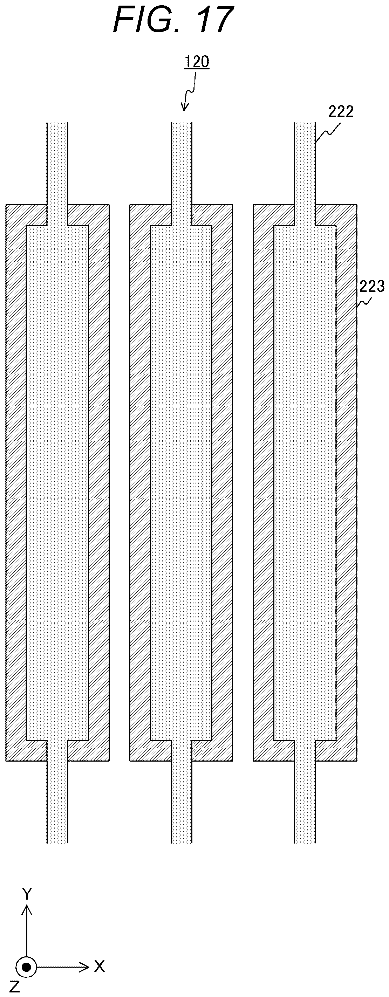

Furthermore, as exemplified in Figs. 17 to 21, the sub-pixel may have a rectangular shape, and may be arranged in a stripe array.

At that time, as exemplified in Fig. 17, the connection portions may be provided in the vertical direction to mutually connect sub-pixels arranged in the vertical direction.

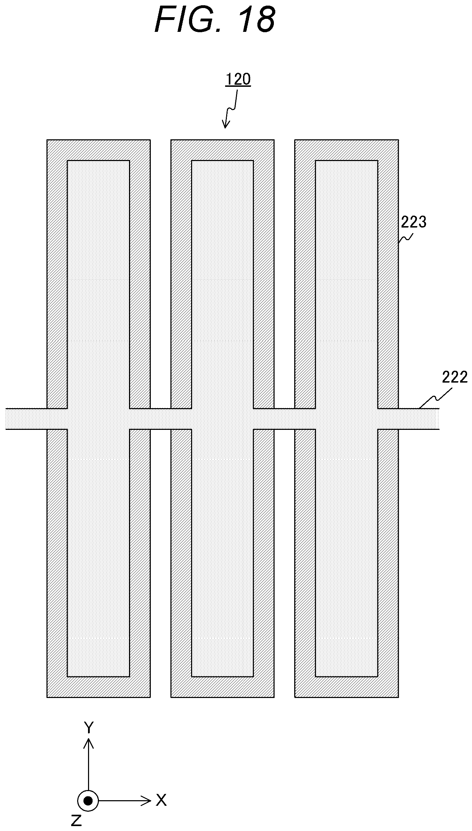

Alternatively, as exemplified in Fig. 18, the connection portions may be provided in the horizontal direction to mutually connect sub-pixels arranged in the horizontal direction.

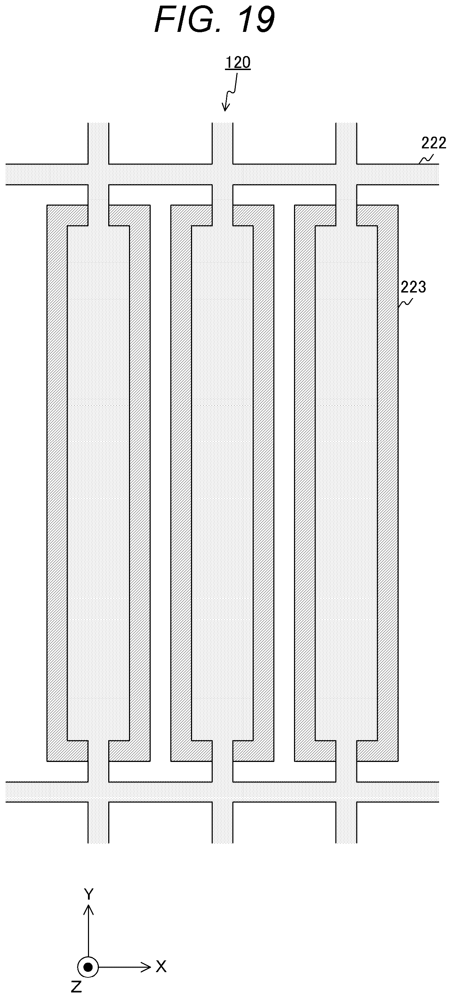

Alternatively, as exemplified in Fig. 19, sub-pixels arranged in the vertical direction may be mutually connected, and further, the connection portions arranged in the horizontal direction may be mutually connected.

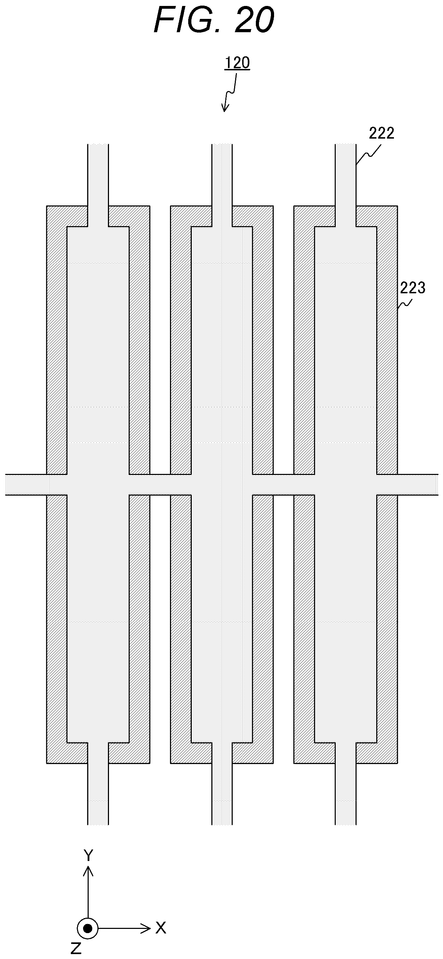

Alternatively, as exemplified in Fig. 20, the connection portions may be provided in the horizontal direction and the vertical direction, to mutually connect sub-pixels arranged in the horizontal direction and the vertical direction.

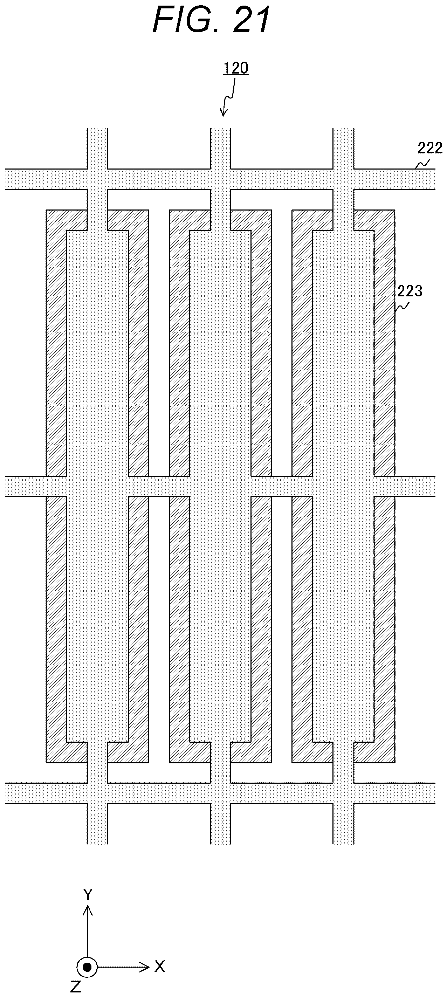

Alternatively, as exemplified in Fig. 21, sub-pixels arranged in the horizontal direction and the vertical direction may be mutually connected, and the connection portions arranged in the horizontal direction may be mutually connected.

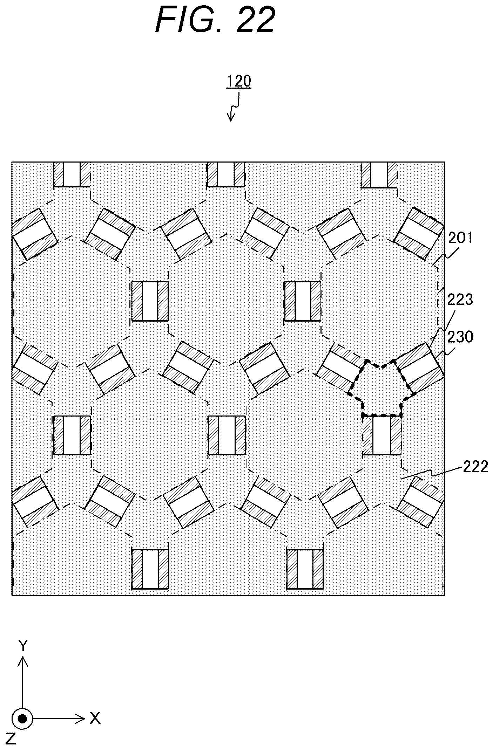

Note that, in the above-described example, the rectangular portion in the inter-pixel region is used as the connection portion, but the present technology is not limited to this configuration. As exemplified in Fig. 22, the organic EL film 222 can also be formed by using, as the connection portion, a portion other than the rectangular portion in the inter-pixel region between the adjacent sub-pixels. In the figure, a Y-shaped portion surrounded by a thick dotted line corresponds to the connection portion. In this case, a part of the anode electrode 223 and a part of the insulating film 230 are disposed in the rectangular portion.

As described above, according to the first embodiment of the present technology, since the organic EL film 222 is formed in each of the sub-pixels and the connection portion in the inter-pixel region, it is possible to reduce the leakage current as compared with the case where the organic EL film 222 is formed in the entire inter-pixel region.

Furthermore, since the film thickness of the portion covering the sub-pixel in the protective film 210 is made larger than the film thickness of the other portion, the light extraction efficiency can be improved.

<2. Second embodiment>

In the first embodiment described above, a width of each cathode electrode 221 of the connection portion in the pixel array unit 120 is constant, but it is difficult to suppress shading in this configuration. A display device 100 according to a second embodiment is different from that of the first embodiment in that a width of a cathode electrode 221 is changed according to a distance from a central portion.

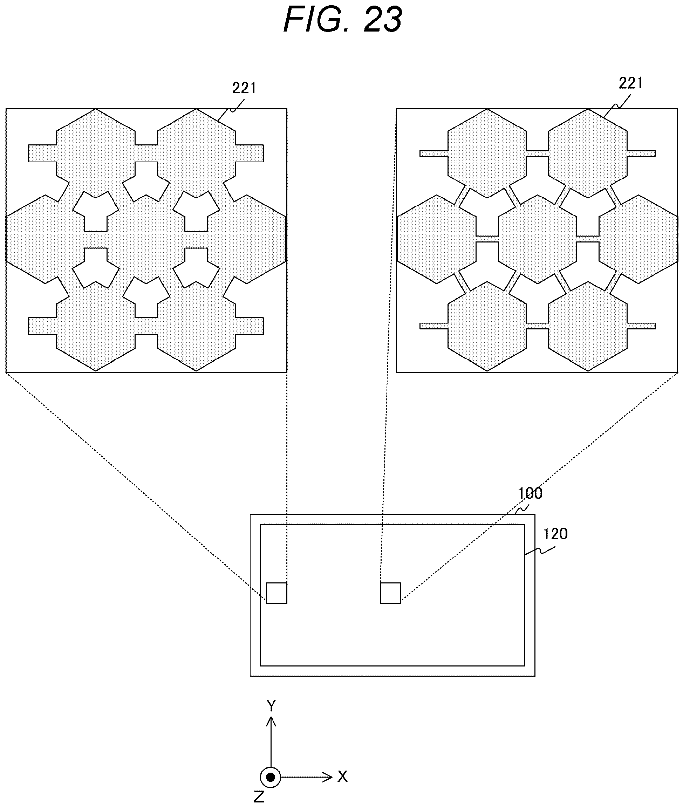

Fig. 23 is an example of a plan view of a pixel array unit 120 according to the second embodiment of the present technology. The pixel array unit 120 of the second embodiment is different from that of the first embodiment in that a width of the cathode electrode 221 of a connection portion between sub-pixels is smaller as being closer to a central portion.

Here, when a current flows through the cathode electrode 221, a potential drop (in other words, IR drop) occurs due to resistance of the cathode electrode 221, and a potential difference between an anode and a cathode in individual pixels decreases. A cathode contact electrode (not illustrated) that supplies a potential to the cathode electrode 221 is disposed in a periphery of the pixel array unit 120. Therefore, as being farther from the periphery, in other words, as being closer to a center of the pixel array unit 120, a potential difference becomes smaller, a current flowing through an organic EL film 222 decreases, and luminance decreases. As a result, luminance becomes non-uniform, and shading may occur.

By setting the width of the cathode electrode 221 to be narrower as being closer to the central portion, an area of side-wall reflection exemplified in Fig. 2 is increased as being closer to the center, and the light extraction efficiency is improved. Therefore, it is possible to suppress a decrease (that is, shading) in luminance in the central portion.

As described above, according to the second embodiment of the present technology, since the width of the cathode electrode 221 of the connection portion is set to a value according to a distance from the central portion, shading can be suppressed.

<3. Third embodiment>

In the first embodiment described above, the width of the connection portion of the organic EL film 222 is constant. However, in this configuration, it is necessary to shift a position of a lens to change a direction of a principal ray when principal ray control is performed. A display device 100 according to a third embodiment is different from that of the first embodiment in that the principal ray control is realized by setting a width of one end of a connection portion to a value different from that of another end.

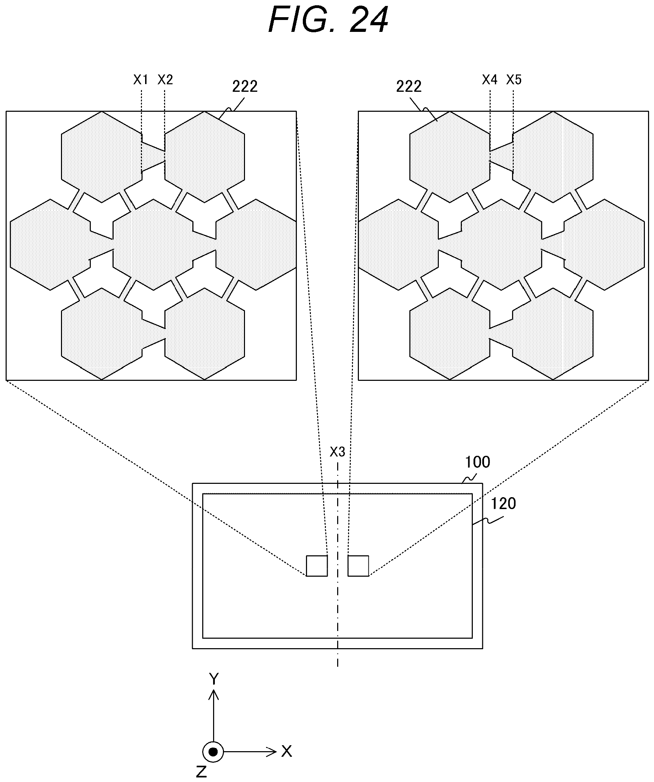

Fig. 24 is an example of a plan view of a delta-array pixel array unit 120 according to the third embodiment of the present technology. In the third embodiment, a width of one end of a connection portion of an organic EL film 222 is different from that of another end. For example, a width of one end farther from a central portion of the pixel array unit 120 out of both ends of the connection portion is assumed to be wider than a width of another end. Furthermore, the width gradually changes from one end to another end.

For example, an X coordinate of the central portion of the pixel array unit 120 is assumed to be X3. On a left side of the coordinate X3, a width of a left end at the coordinate X1 or the like is wider than a width of a right end at the coordinate X2 or the like. On a right side of the coordinate X3, a width of a left end at the coordinate X4 or the like is narrower than a right end at the coordinate X5 or the like. Similarly, on an upper side of the central portion, a width of an upper end of the connection portion is wider than a width of a lower end. On a lower side of the central portion, a width of an upper end of the connection portion is narrower than a width of a lower end. In this way, by setting the width of one end farther from the central portion to be wider than the width of another end for every connection portion, the principal ray can be directed toward the center without shifting a position of a lens. With this principal ray control, light can be collected at the central portion of the display device 100. Note that, in the figure, the connection portion on the upper side and the lower side of the central portion is omitted.

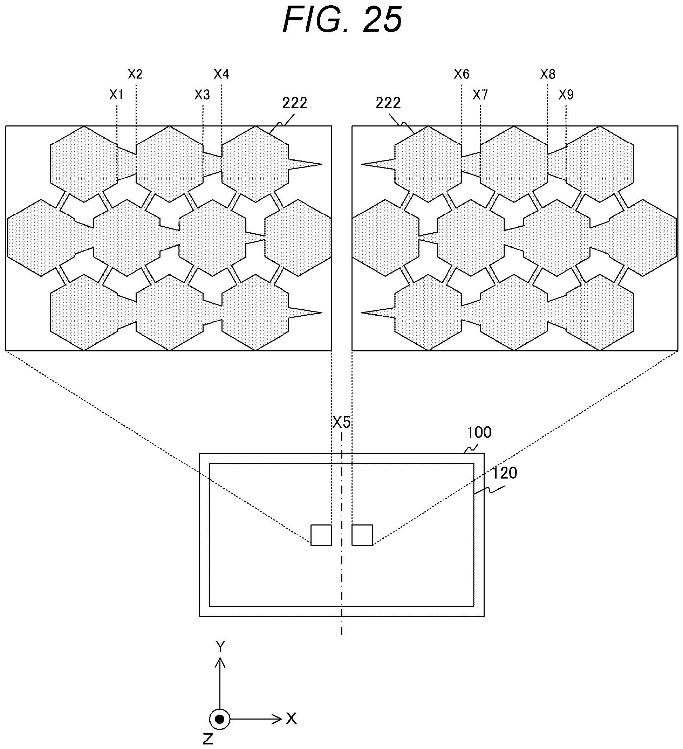

Note that, as exemplified in Fig. 25, it is preferable to change the width of the connection portion according to a distance from the central portion. For example, the width of the connection portion may simply be increased as the distance from the central portion increases. An X coordinate of the central portion is assumed to be X5. On a left side of the coordinate X5, a width of a left end at the coordinate X1 of a certain connection portion is wider than a width of a right end at the coordinate X2. A width of a left end at the coordinate X3 of a connection portion closer to the central portion than the certain connection portion is wider than a width of a right end at the coordinate X4, and widths of the coordinates X3 and X4 are narrower respectively than widths of the coordinates X1 and X2.

On a right side of the coordinate X5, a width of a left end at the coordinate X6 of a certain connection portion is narrower than a right end at the coordinate X7. A width of a left end at the coordinate X8 of a connection portion farther from the central portion than the certain connection portion is narrower than a right end at the coordinate X9, and widths at coordinates X8 and X9 are respectively wider than widths at coordinates X6 and X7.

Similarly, on an upper side of the central portion, the width of the connection portion becomes wider as being closer to an upper end of the pixel array unit 120. On a lower side of the central portion, the width of the connection portion becomes wider as being closer to a lower end of the pixel array unit 120.

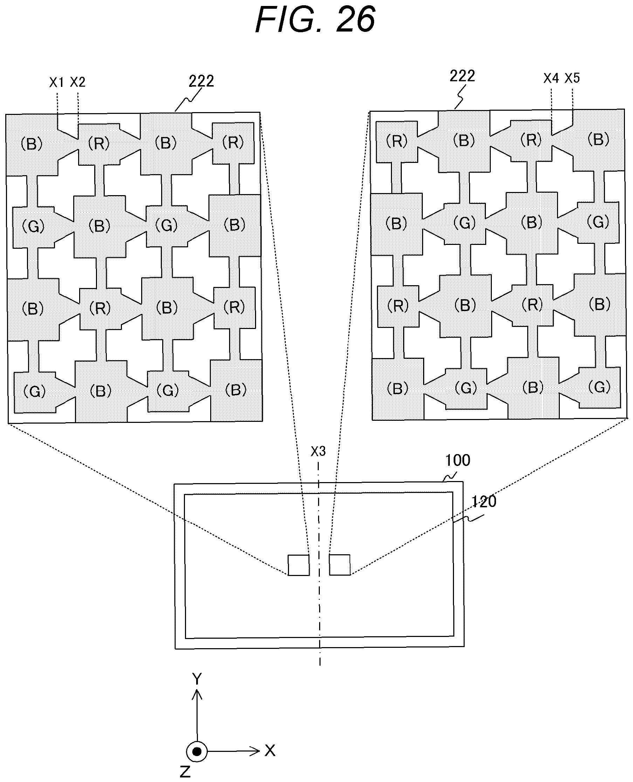

Furthermore, as exemplified in Fig. 26, in the square array, a width of one end of the connection portion can be set to a value different from that of another end.

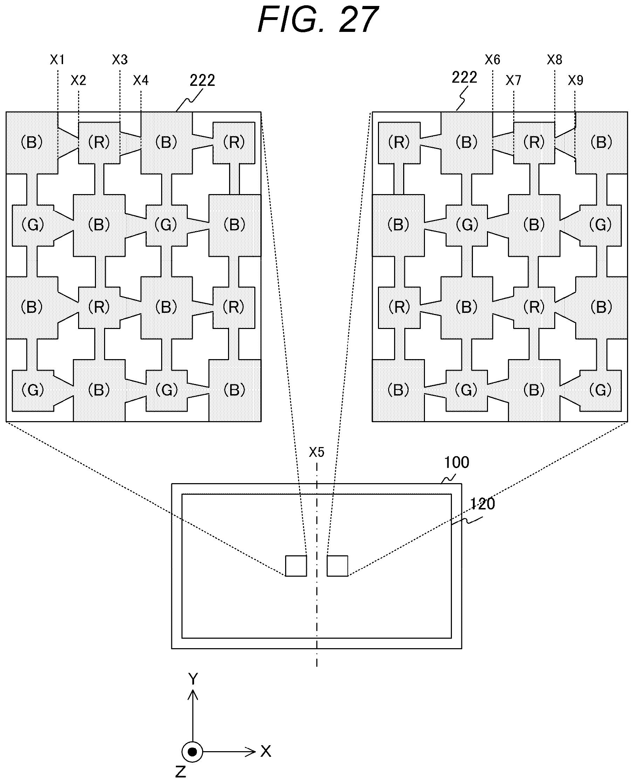

As exemplified in Fig. 27, the width of the connection portion can be changed according to a distance from the central portion in the square array.

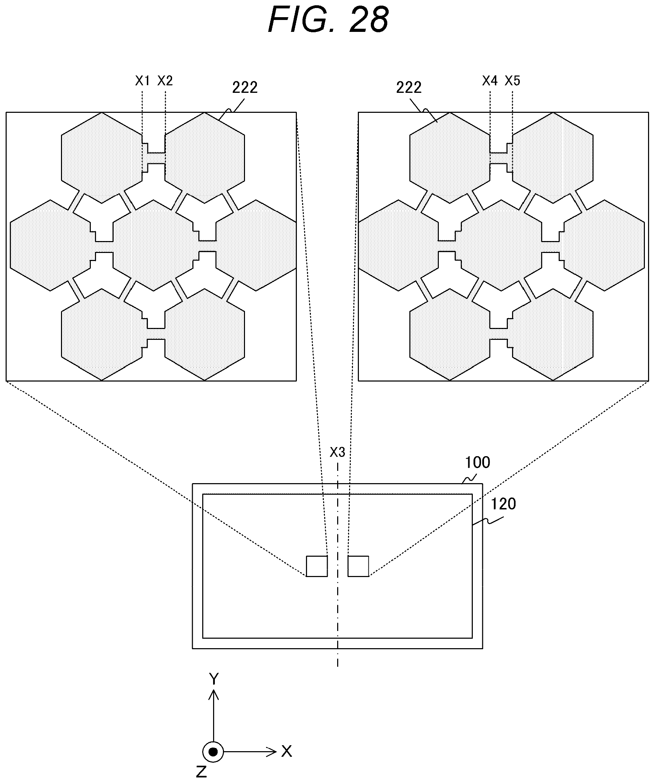

Furthermore, the width is gradually changed from one end to another end, but the present technology is not limited to this configuration. For example, as exemplified in Fig. 28, the connection portion can be formed in a T shape.

As described above, according to the third embodiment of the present technology, since the width of one end of the connection portion is set to a value different from that of another end, the principal ray control can be performed without shifting the position of the lens.

<4. Fourth embodiment>

In the first embodiment described above, adjacent sub-pixels are mutually connected by the connection portion. However, if the connection portion is too thin, the connection portion may be broken and the sub-pixel may be become a black spot due to a connection failure. A display device 100 according to a fourth embodiment is different from that of the first embodiment in that a connection failure is prevented.

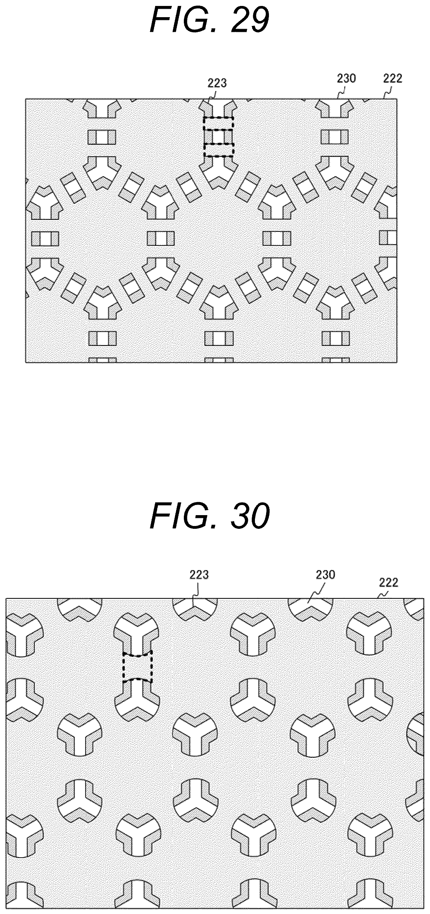

Fig. 29 is an example of a plan view of a pixel array unit 120 according to the fourth embodiment of the present technology. The pixel array unit 120 of the fourth embodiment is different from that of the first embodiment in that, in a case where attention is paid to a pair of adjacent sub-pixels, the sub-pixels are connected by two connection portions. In the figure, a portion surrounded by a thick dotted line corresponds to the connection portion.

Note that a pair of adjacent sub-pixels can be connected by three or more sub-pixels. By increasing the number of the connection portions to two or more, even if a connection failure occurs in one connection portion, the connection between the sub-pixels can be maintained by the remaining connection portions. As a result, a connection failure can be prevented.

Note that the two connection portions between the pair of sub-pixels are examples of first and second connection portions described in the claims.

As described above, according to the fourth embodiment of the present technology, since the pair of adjacent sub-pixels are connected by the two connection portions, connection failure can be prevented.

[Modifications]

In the fourth embodiment described above, the number of connection portions is increased to two or more. However, even with this configuration, connection failure may not be sufficiently prevented. A display device 100 in a modification of the fourth embodiment is different from that of the fourth embodiment in that an edge of a connection portion has an arc shape.

Fig. 30 is an example of a plan view of a pixel array unit 120 according to the modification of the fourth embodiment of the present technology. The pixel array unit 120 according to the modification of the fourth embodiment is different from that of the fourth embodiment in that there is one connection portion between a pair of adjacent sub-pixels and an edge of the connection portion has an arc shape. The edge of the connection portion has, for example, an arc shape of a fan. A region surrounded by a thick dotted line in the figure corresponds to the connection portion. By forming the edge of the connection portion in the arc shape, a disconnection failure between the sub-pixels can be reduced.

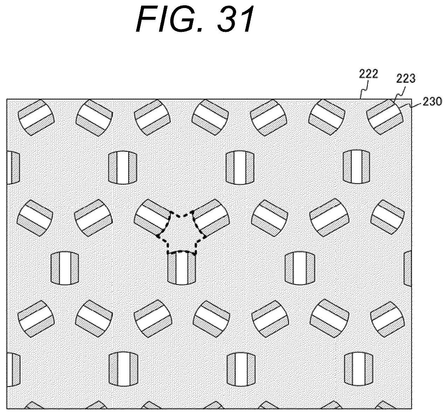

Note that, as exemplified in Fig. 31, a Y-shaped connection portion may be disposed in the vicinity of a vertex of a hexagonal sub-pixel, and an edge of the connection portion may have an arc shape. A region surrounded by a thick dotted line in the figure corresponds to the connection portion.

Furthermore, in the modification of the fourth embodiment, as exemplified in Fig. 29, two or more connection portions can be provided between a pair of sub-pixels.

As described above, according to the modification of the fourth embodiment of the present technology, since the edge of the connection portion is formed in the arc shape, connection failure can be prevented.

<5. Fifth embodiment>

In the first embodiment described above, the connection portion has a rectangular shape. However, with this configuration, it is difficult to further improve the light extraction efficiency. A display device 100 according to a fifth embodiment is different from that of the first embodiment in that a width of a center of a connection portion is increased to improve the light extraction efficiency.

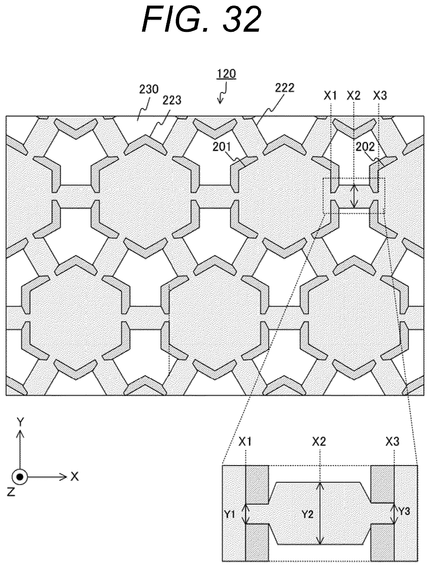

Fig. 32 is an example of a plan view of a pixel array unit 120 according to the fifth embodiment of the present technology. The pixel array unit 120 of the fifth embodiment is different from that of the first embodiment in that a width of a center of the connection portion is wider than widths of both ends of the connection portion. For example, hexagonal sub-pixels 201 and 202 are arranged in the X-axis direction, an X coordinate of a right end of the sub-pixel 201 is assumed to be X1, an X coordinate of a left end of the sub-pixel 202 on a right side thereof is assumed to be X3, and the X coordinate in a middle thereof is assumed to be X2. The X coordinates of the left end and the right end of the connection portion connecting the sub-pixels correspond to X1 and X3, and the X coordinate of the center corresponds to X2. When lengths (that is, widths) of the connection portion at the coordinates X1 and X3 in the Y-axis direction are assumed to be Y1 and Y3, and a width of the connection portion at the coordinate X2 is assumed to be Y2, Y2 is larger than each of Y1 and Y3.

By increasing the width of the center, it is possible to increase a region reflected at an interface between a protective film 211 and a low refractive index film, and the light extraction efficiency is improved. Furthermore, by increasing the width of the center of the connection portion, resistance of the connection portion can be reduced, and a voltage rise can be suppressed.

As described above, according to the fifth embodiment of the present technology, since the width of the center of the connection portion is widened, the light extraction efficiency can be improved.

[First modification]

In the fifth embodiment described above, the width of the center of the connection portion is increased. However, with this configuration, it is difficult to further improve the light extraction efficiency. A display device 100 in a first modification of the fifth embodiment is different from that of the fifth embodiment in that a central portion of a connection portion is opened.

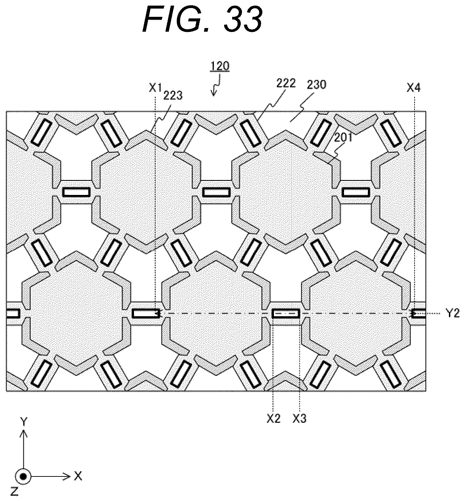

Fig. 33 is an example of a plan view of a pixel array unit 120 in the first modification of the fifth embodiment of the present technology. The first modification of the fifth embodiment is different from the fifth embodiment in that a part of the central portion of the connection portion of the pixel array unit 120 is opened, and an organic EL film 222 is not formed in the opened region. In the figure, a thick rectangle between the coordinates X2 and X3 indicates the opened region.

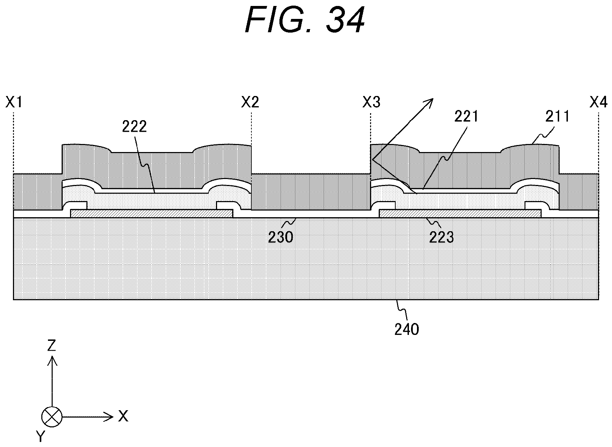

Fig. 34 is a cross-sectional view taken along a line segment between coordinates (X1, Y2) and (X4, Y2) in Fig. 33. By eliminating the organic EL film 222 near the center of the connection portion, light from a sub-pixel can be reflected at an interface between the protective film 211 and a sealing resin above the protective film 211. As a result, the light extraction efficiency is further improved. An arrow in Fig. 34 indicates a trajectory of light reflected by at interface.

As described above, according to the first modification of the fifth embodiment of the present technology, since the central portion of the connection portion is opened, the light extraction efficiency can be further improved.

[Second modification]

In the fifth embodiment described above, the width of the center of the connection portion is increased.

However, connection portions may be mutually connected. A display device 100 in a second modification of the fifth embodiment is different from that of the fifth embodiment in that adjacent connection portions are mutually connected.

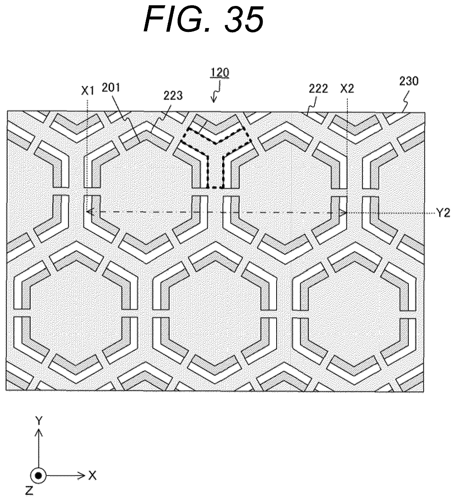

Fig. 35 is an example of a plan view of a pixel array unit 120 in the second modification of the fifth embodiment of the present technology. In the second modification of the fifth embodiment, the organic EL film 222 is also formed in a region extending from a central portion of a connection portion along an edge of a sub-pixel, and adjacent sub-pixels are mutually connected. A region where the sub-pixels are mutually connected is hereinafter referred to as a "bridge portion". A Y-shaped region surrounded by a thick dotted line at the same time indicates the bridge portion. The organic EL film 222 is formed in the hexagonal sub-pixel, the connection portion mutually connecting the sub-pixels, and the bridge portion mutually connecting the connection portions.

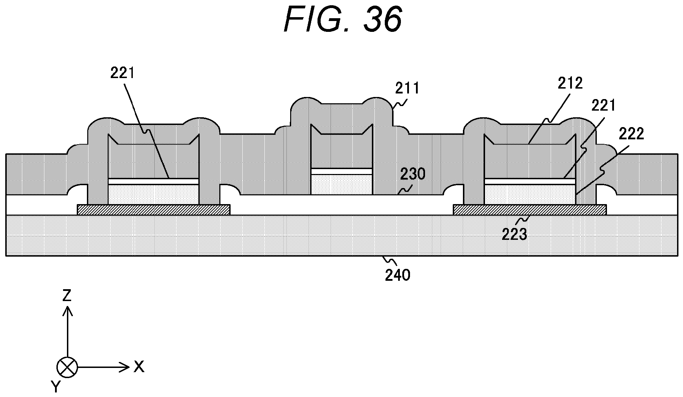

Fig. 36 is a cross-sectional view taken along a line segment between coordinates (X1, Y2) and (X2, Y2) in Fig. 35.

As the width of the connection portion is made narrower, resistance of a cathode electrode 221 above the connection portion becomes larger. However, as exemplified in Figs. 35 and 36, by mutually connecting the connection portions by using the bridge portion, the resistance of the cathode electrode 221 can be reduced by the increased amount. This configuration makes it possible to suppress an increase in resistance of the cathode electrode 221 when the width of the connection portion is narrowed.

As described above, according to the second modification of the fifth embodiment of the present technology, since the organic EL film 222 is also formed in the bridge portion mutually connecting the connection portions, an increase in the resistance of the cathode electrode 221 can be suppressed.

<6. Sixth embodiment>

In the first embodiment described above, the hexagonal sub-pixels are arranged when viewed from the Z-axis direction, but it is difficult to further improve the light extraction efficiency with the shape of the sub-pixels. A display device 100 according to a sixth embodiment is different from that of the first embodiment in that the light extraction efficiency is improved by providing unevenness on a side wall of a sub-pixel when viewed from the Z-axis direction.

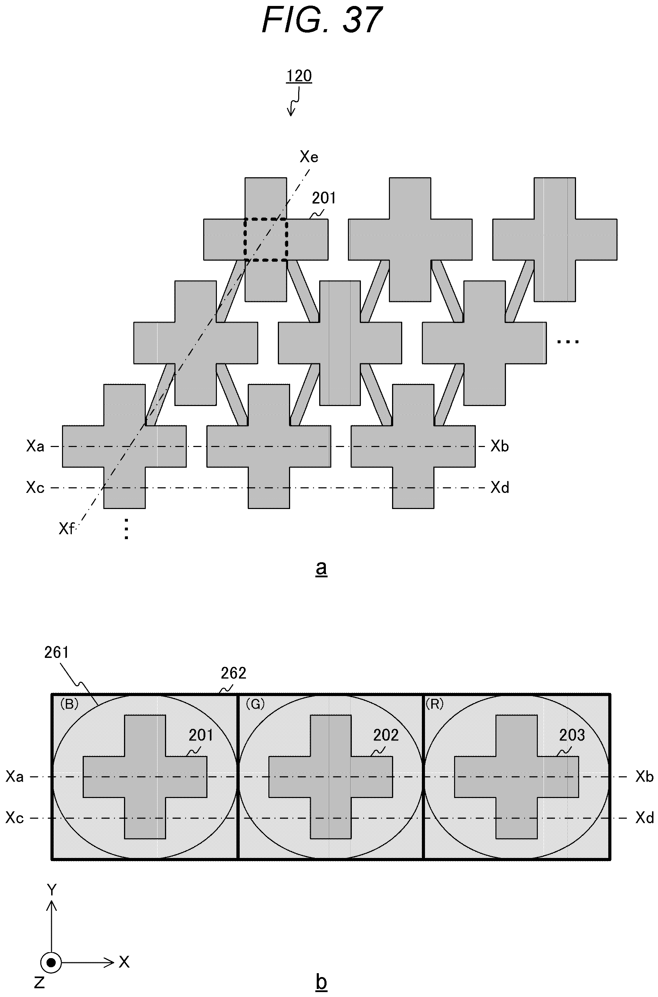

Fig. 37 is an example of a plan view of a pixel array unit 120 according to the sixth embodiment of the present technology. In the figure, a is an example of a plan view when viewed from the Z-axis direction without an on-chip lens 261 and a color filter 262, and b of the figure is an example of a plan view when three sub-pixels are viewed from the Z-axis direction.

As exemplified in a of the figure, when viewed from the Z-axis direction, unevenness is provided on a side wall for each of the sub-pixels such as a sub-pixel 201. Hereinafter, a portion of the sub-pixel protruding from the side surface is referred to as a "protrusion", and a portion other than the protrusion is referred to as a "core portion". The planar shape of the sub-pixel viewed from the Z-axis direction can be expressed as a figure in which the core portion and the plurality of protrusions are combined. Here, more specifically, the shape of the sub-pixel corresponds to a shape of each of an organic EL film 222 excluding a connection portion, a cathode electrode 221, and a protective film 211. Furthermore, adjacent sub-pixels are connected to each other by the connection portion in an oblique direction.

A portion surrounded by a thick dotted line in a of the figure corresponds to the core portion. For example, the sub-pixel has a shape (in other words, a cross shape) in which the core portion is rectangular and a rectangular protrusion is adjacent to each of four edges of the core portion.

Furthermore, as exemplified in b of the figure, the on-chip lens 261 and the color filter 262 are provided in each of the sub-pixels 201 to 203. A circular line indicates an outer periphery of the on-chip lens 261, and a rectangular thick frame indicates an outer periphery of the color filter 262. In b of the figure, the connection portion is omitted.

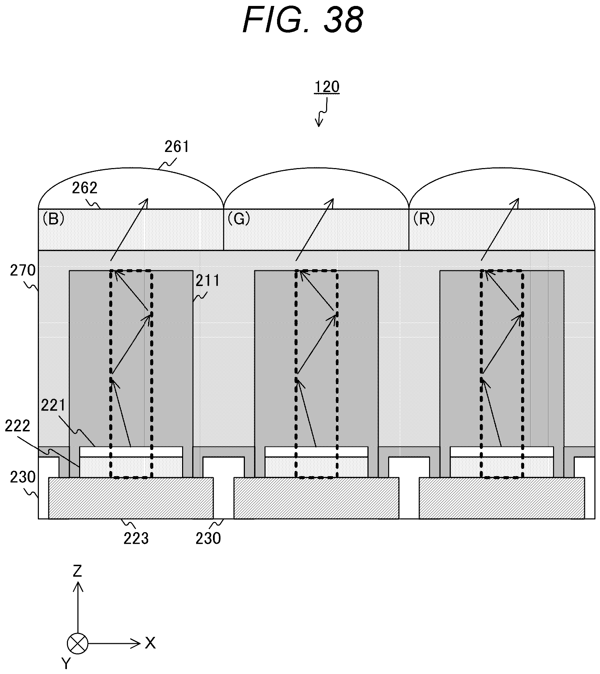

Fig. 38 is an example of a cross-sectional view of the pixel array unit 120 according to the sixth embodiment of the present technology. This figure is an example of a cross-sectional view taken along a line segment Xa-Xb in the horizontal direction including the core portion in b of Fig. 37. Furthermore, a thick dotted line in Fig. 38 indicates a cross-sectional shape of the protrusion taken along a line segment Xc-Xd including only the protrusion out of the core portion and the protrusion in b of Fig. 37. Furthermore, an arrow indicates an optical path of light emitted by the organic EL film 222. By providing unevenness on the side wall, the protrusion functions as a light guide, and the light extraction efficiency can be improved.

Furthermore, in a case where the sub-pixels are connected in the oblique direction, the cross section taken along the line segment Xa-Xb in the horizontal direction does not include the connection portion. Adjacent sub-pixels in this cross section are separated from each other by the insulating film 230. Furthermore, a low refractive index film 270 is formed below the color filter 262.

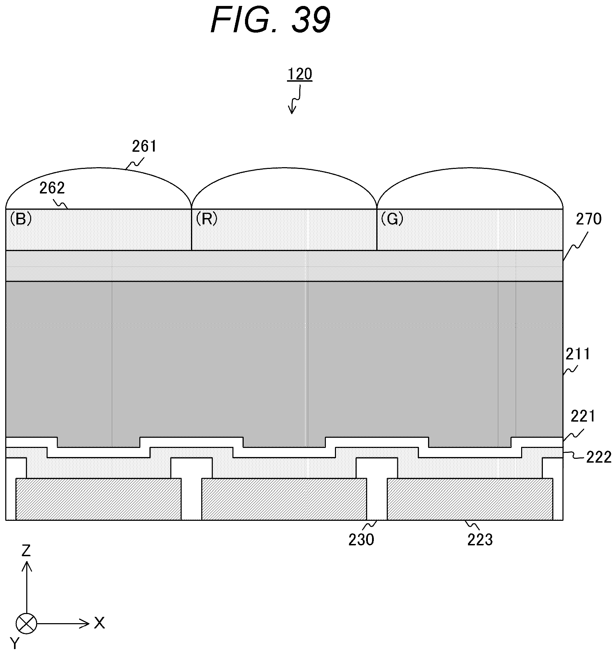

Fig. 39 is an example of a cross-sectional view taken along a line segment including the connection portion according to the sixth embodiment of the present technology. This figure is an example of a cross-sectional view taken along a line segment Xe-Xf in the oblique direction in a of Fig. 37. In a case where the sub-pixels are connected in the oblique direction, the cross section taken along the line segment Xe-Xf in the oblique direction includes the connection portion. The adjacent sub-pixels are connected to each other by the connection portion.

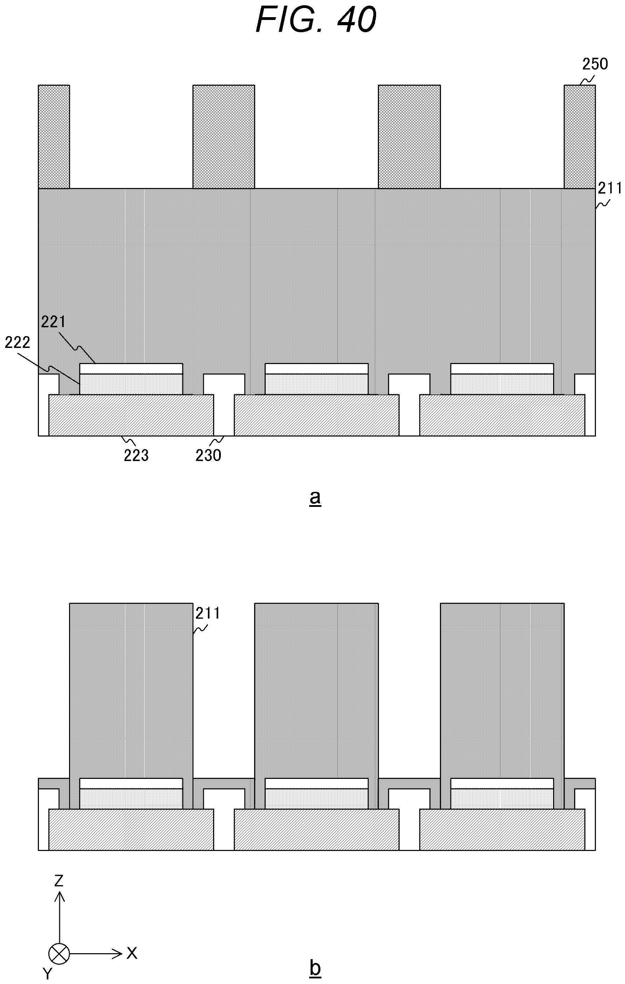

Fig. 40 is a diagram for explaining a manufacturing process of the display device 100 according to the sixth embodiment of the present technology. In the figure, a illustrates a cross-sectional view before photolithography, and b illustrates a cross-sectional view after photolithography.

As exemplified in a of the figure, a manufacturing system forms the organic EL film 222 and the cathode electrode 221, then forms the protective film 211 on the organic EL film and the cathode electrode, and disposes a photoresist 250 on the protective film. A shape of the photoresist 250 as viewed from the Z-axis direction is a shape obtained by hollowing out the connection portion and the sub-pixel having unevenness. Then, the manufacturing system performs photolithography. As a result, as exemplified in b of the figure, the protective film 211 is processed into a shape having unevenness. In the figure, b illustrates a cross section taken along the line segment Xa-Xb in Fig. 37.

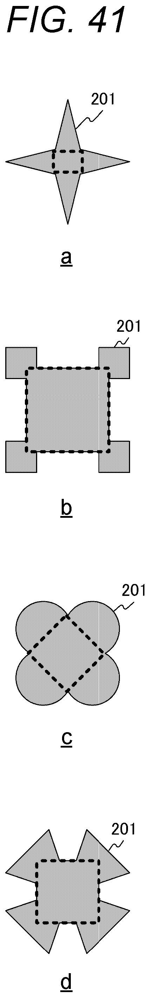

Fig. 41 is a diagram illustrating an example of a shape of a sub-pixel having four protrusions according to the sixth embodiment of the present technology. In a case where the core portion has a rectangular shape, up to four protrusions can be provided. In this case, as exemplified in a of the figure, the protrusion may also have a triangular shape. Furthermore, as exemplified in b of the figure, the protrusion may also be formed in a rectangular shape, and the protrusion may also be disposed adjacent to a vertex of the core portion. Note that, as exemplified in Fig. 37, the protrusion may also be formed in a rectangular shape and disposed adjacent to four edges of the core portion.

Furthermore, as exemplified in c of Fig. 41, the protrusion may be a semicircle. As exemplified in d of the figure, the protrusion may be a wedge.

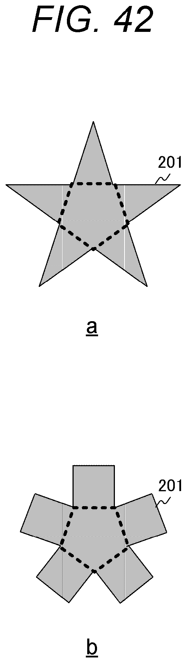

Fig. 42 is a diagram illustrating an example of a shape of a sub-pixel having five protrusions according to the sixth embodiment of the present technology. In a case where the core portion has a pentagonal shape, up to five protrusions can be provided. In this case, as exemplified in a of the figure, the protrusion may also have a triangular shape. Furthermore, as exemplified in b of the figure, the protrusion may have a rectangular shape.

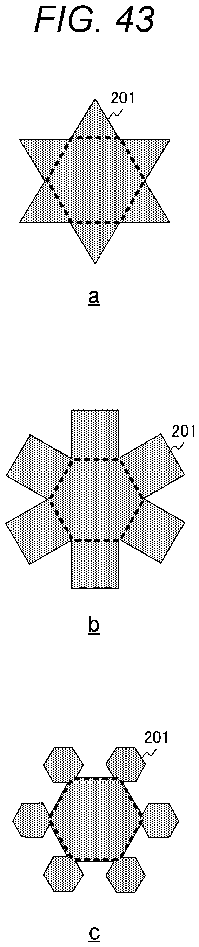

Fig. 43 is a diagram illustrating an example of a shape of a sub-pixel having six protrusions according to the sixth embodiment of the present technology. In a case where the core portion has a hexagonal shape, up to six protrusions can be provided. In this case, as exemplified in a of the figure, the protrusion may also have a triangular shape. Furthermore, as exemplified in b of the figure, the protrusion may have a rectangular shape. As exemplified in c of the figure, the protrusion may have a hexagonal shape.

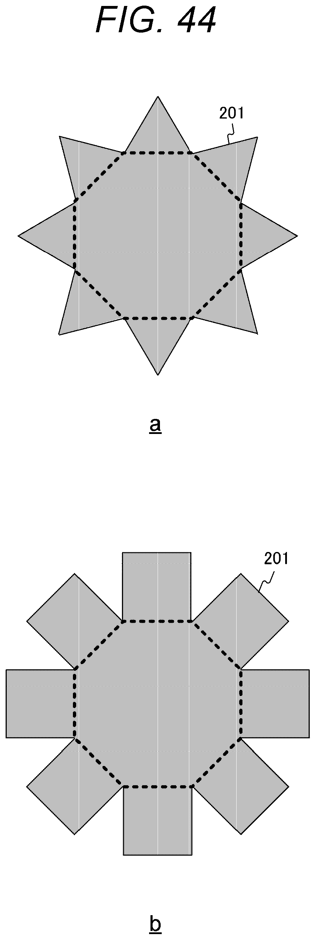

Fig. 44 is a diagram illustrating an example of a shape of a sub-pixel having eight protrusions according to the sixth embodiment of the present technology. In a case where the core portion has an octagonal shape, up to eight protrusions can be provided. In this case, as exemplified in a of the figure, the protrusion may also have a triangular shape. Furthermore, as exemplified in b of the figure, the protrusion may have a rectangular shape.

Theoretically, the number of protrusions can be set to nine or more. However, as the number of protrusions is increased, there is a higher possibility that a resolution limit of lithography is exceeded, and the function of the protrusions as light guides is deteriorated as the shape is closer to a circular shape. For this reason, the cases where the number of protrusions is four to eight, which are highly practical, have been exemplified.

Although the connection portions are disposed only in the oblique direction, the connection portions may also be disposed in the vertical direction and the horizontal direction as described above.

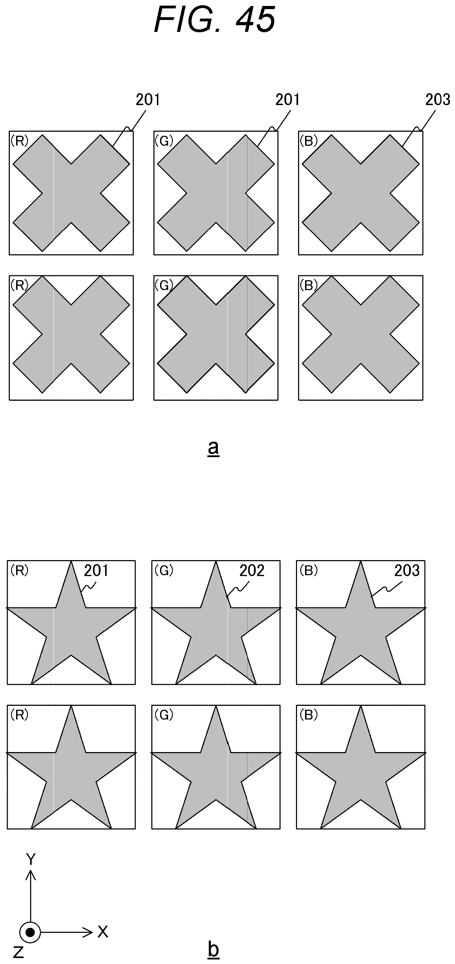

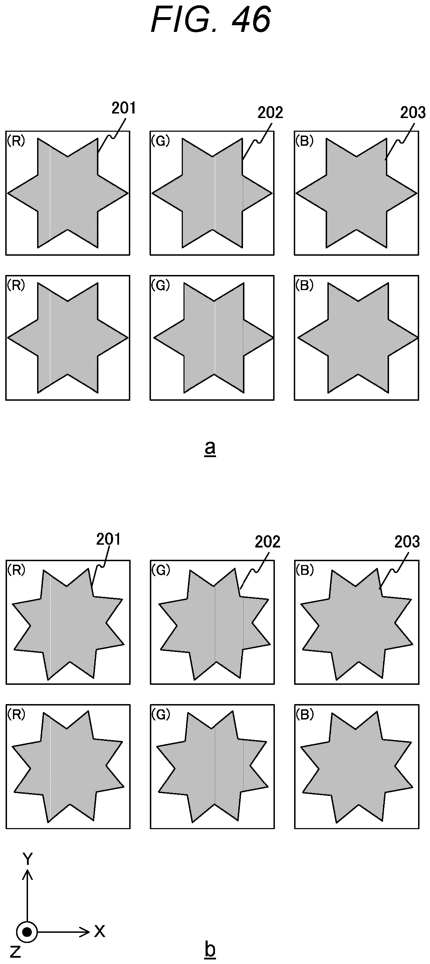

Furthermore, as exemplified in Figs. 45 and 46, sub-pixels can be arranged in a stripe array. In these figures, the connection portion is omitted.

In the stripe array, as exemplified in a of Fig. 45, the number of protrusions can be four. Alternatively, as exemplified in b of the figure, the number of protrusion can be five.

Alternatively, as exemplified in a of Fig. 46, the number of protrusion can be six. Alternatively, as exemplified in b of the figure, the number of protrusion can be eight.

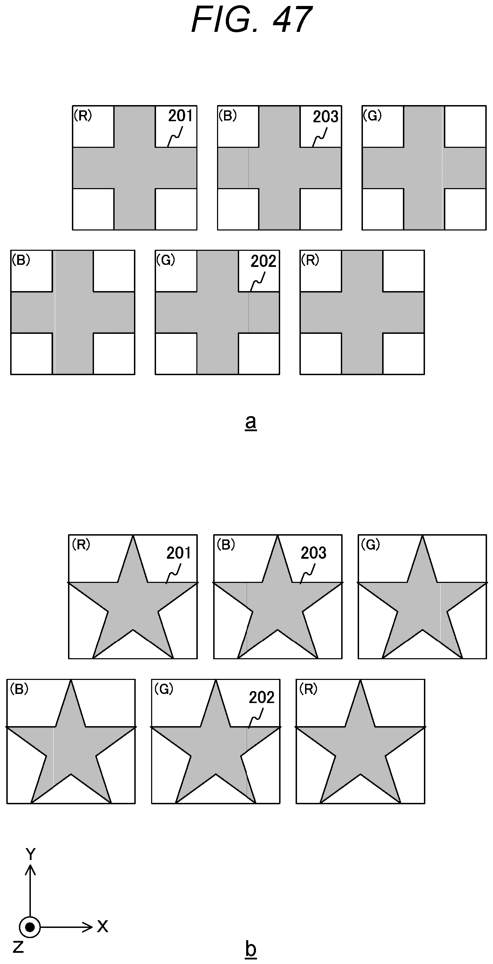

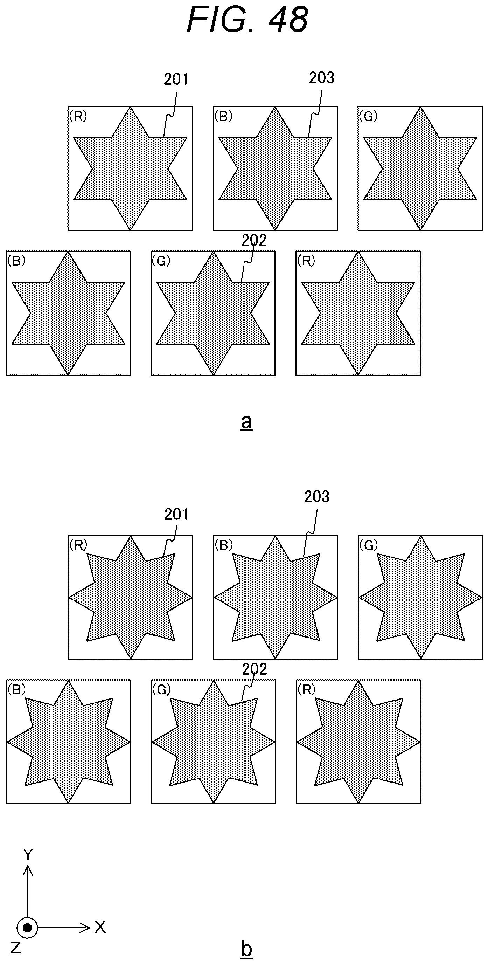

Furthermore, as exemplified in Figs. 47 and 48, sub-pixels can be arranged in a delta array. In these figures, the connection portion is omitted.

In the delta array, as exemplified in a of Fig. 47, the number of protrusions can be four. Alternatively, as exemplified in b of the figure, the number of protrusion can be five.

Alternatively, as exemplified in a of Fig. 48, the number of protrusion can be six. Alternatively, as exemplified in b of the figure, the number of protrusion can be eight.

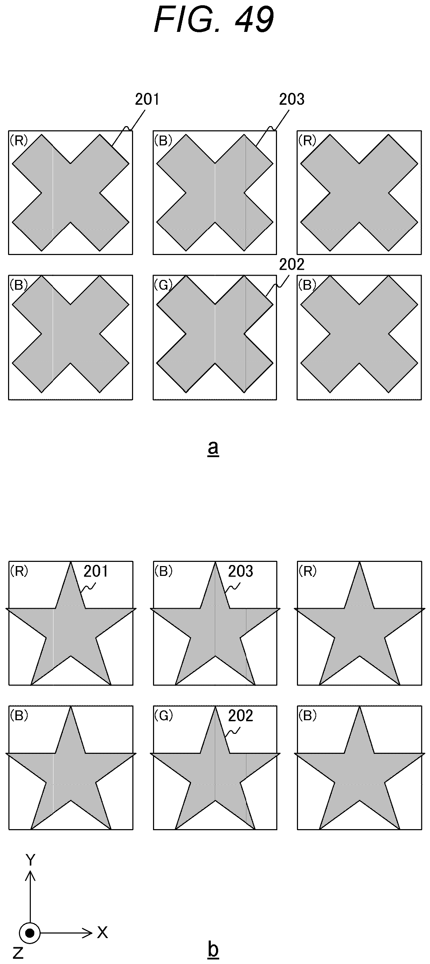

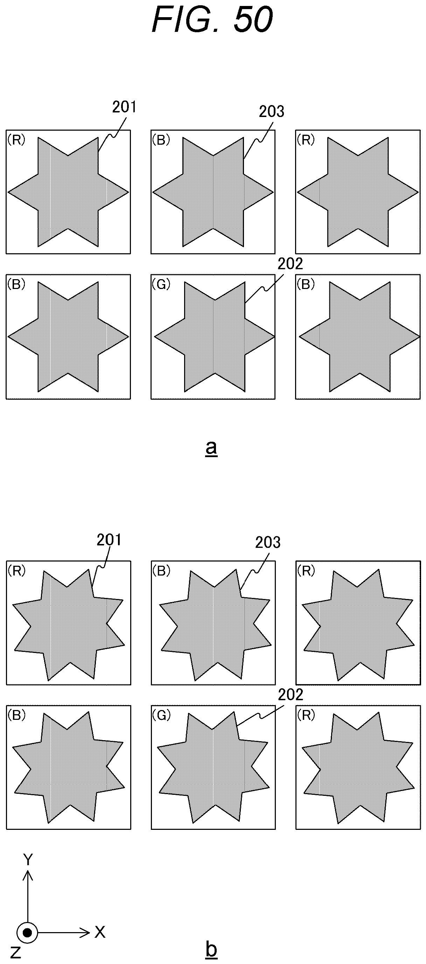

Furthermore, as exemplified in Figs. 49 and 50, the sub-pixels can be arranged in a square array. In these figures, the connection portion is omitted.

In the delta array, as exemplified in a of Fig. 49, the number of protrusions can be four. Alternatively, as exemplified in b of the figure, the number of protrusion can be five.

Alternatively, as exemplified in a of Fig. 50, the number of protrusion can be six. Alternatively, as exemplified in b of the figure, the number of protrusion can be eight.

Note that each of the second to fifth embodiments can be applied to the sixth embodiment.

As described above, according to the sixth embodiment of the present technology, since the shape of the sub-pixel as viewed from the Z-axis direction is a figure in which the core portion and the plurality of protrusions are combined, the light extraction efficiency can be improved.

<7. Seventh embodiment>

In the first embodiment described above, the shape of the organic EL film 222 in the sub-pixel is a hexagonal shape when viewed from the Z-axis direction, but it is difficult to further improve the light extraction efficiency with this shape. A display device 100 according to a seventh embodiment is different from that of the first embodiment in that a bent portion is provided in an organic EL film 222 to improve the light extraction efficiency.

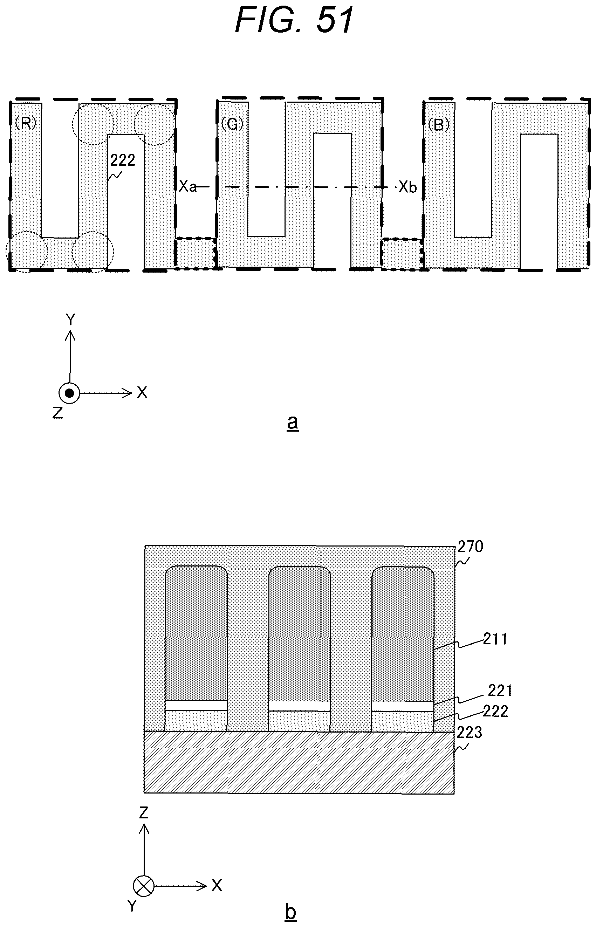

Fig. 51 is a view illustrating a plan view of the organic EL film 222 and a cross-sectional view of a pixel array unit 120 according to the seventh embodiment of the present technology. In the figure, a illustrates a plan view of the organic EL film 222 as viewed from the Z-axis direction. In the figure, b illustrates a cross-sectional view taken along a line segment Xa-Xb in a of the figure.

As exemplified in a of the figure, in the seventh embodiment, the organic EL film 222 has a shape having a predetermined number of bent portions when viewed from the Z-axis direction. In the figure, a rough dotted line indicates an outer periphery of a sub-pixel, and a fine rectangular dotted line indicates an outer periphery of a connection portion. A circular dotted line indicates a bent portion. For example, the organic EL film 222 in the sub-pixel is bent in an S shape at a right angle at each of four bent portions.

Furthermore, as exemplified in b of the figure, an upper surface of an anode electrode 223 below the organic EL film 222 is not processed into the shape having the bent portion. Whereas, shapes of a cathode electrode 221 and a protective film 211 stacked on the organic EL film 222 as viewed from the Z-axis direction are assumed to be the same as that of the organic EL film 222.

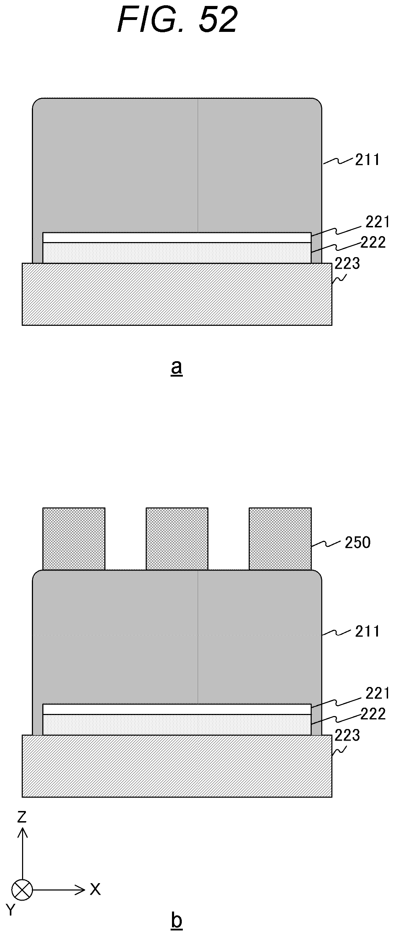

Fig. 52 is a diagram for explaining a manufacturing process up to photolithography according to the seventh embodiment of the present technology. In the figure, a illustrates a cross-sectional view of the pixel array unit 120 when the protective film 211 is formed. In the figure, b illustrates a cross-sectional view of the pixel array unit 120 when photolithography is performed.

As exemplified in a of the figure, the protective film 211 that covers the top of the cathode electrode 221 is formed for every sub-pixel. At this time point, the organic EL film 222 is not processed into the pattern such as the S shape having the bent portion.

Then, as exemplified in b of the figure, the manufacturing system disposes a photoresist 250 above each of the sub-pixels, and performs photolithography. The photoresist 250 has a shape obtained by hollowing out a pattern such as an S shape when viewed from the Z-axis direction.

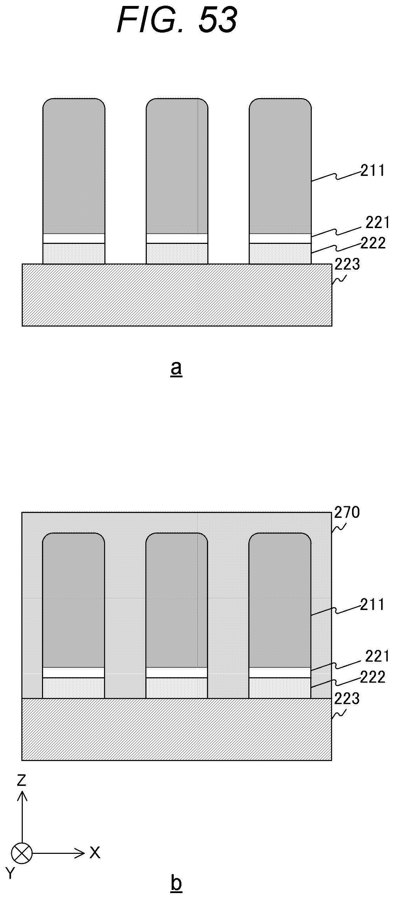

Fig. 53 is a diagram for explaining a manufacturing process up to film formation of a low refractive index film 270 according to the seventh embodiment of the present technology. In the figure, a illustrates a cross-sectional view of the pixel array unit 120 after photolithography. In the figure, b illustrates a cross-sectional view of the pixel array unit 120 on which the low refractive index film 270 is formed.

As exemplified in a of the figure, the protective film 211, the cathode electrode 221, and the organic EL film 222 are processed into a shape having a bent portion when viewed from the Z-axis direction by photolithography. Then, as exemplified in b of the figure, the manufacturing system performs embedding with the low refractive index film 270 to cover a processed end surface. The processed end surface of the organic EL film 222 is embedded and covered with the low refractive index film 270 to form a reflection interface. The light extraction efficiency can be improved by increasing a reflection area of a side wall.

Here, as a material of the low refractive index film 270, for example, a transparent material such as silicon nitride ($SiN_x$), silicon dioxide ($SiO_2$), lithium fluoride (LiF), magnesium fluoride (MgF), or silicon oxynitride (SiON) is used. The low refractive index film 270 may be a porous film (having a low film density), and a film having a lower refractive index of 1.4 or less can be obtained by, for example, using $SiO_x$ as the porous film.

Furthermore, the low refractive index film 270 may be formed as a low refractive index portion inside the protective film 211 on an end surface, and includes a gap and an air gap.

By forming a refractive index difference interface by using the low refractive index film 270, light emitted from the organic EL film 222 is reflected by the side wall, and the light extraction efficiency can be improved. By forming the pixel-shaped end surface bent in the sub-pixel, the side-wall reflection area increases not only in a peripheral portion of the sub-pixel but also inside the sub-pixel. As a result, the light extraction efficiency can be further enhanced.

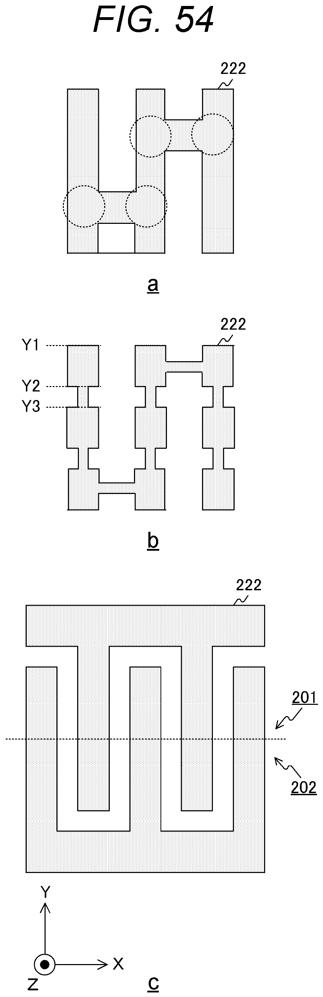

Fig. 54 is a view illustrating an example of a plan view of the organic EL film 222 according to the seventh embodiment of the present technology. A shape of the organic EL film 222 viewed from the Z-axis direction is not limited to the above-described S shape as long as a predetermined number of bent portions are provided.

For example, as exemplified in a of the figure, a shape (so-called Ghost Leg shape) may be adopted in which a horizontal line is drawn between a plurality of parallel lines in a direction vertical to the parallel lines. Furthermore, as exemplified in b of the figure, a width of a part of the organic EL film 222 may have a shape different from a width of other portion. For example, in the Y-axis direction, a width of a portion between the coordinates Y1 and Y2 is formed to be wider than a width of a portion between the coordinates Y2 to Y3. Furthermore, as exemplified in c of the figure, the organic EL film 222 may have a shape in which a plurality of notches is formed (so-called comb shape). In the figure, c illustrates a shape of adjacent sub-pixels 201 and 202.

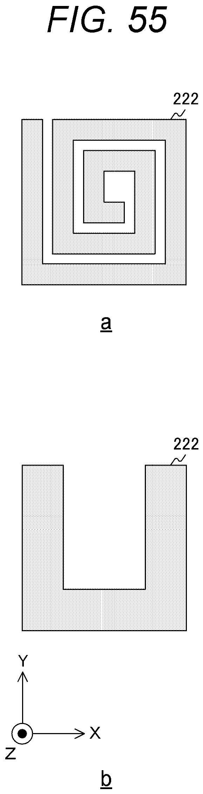

Furthermore, as exemplified in a of Fig. 55, the organic EL film 222 may have a spiral shape. Furthermore, as exemplified in b of the figure, the organic EL film 222 may have a U shape. Furthermore, it is also possible to perform rotation by 90 degrees or reverse arrangement. An orientation of the sub-pixel can be changed for every color. Furthermore, an arrangement angle can be changed toward an outer peripheral portion of the pixel array unit 120.

Note that the anode electrode 223 is not processed into the pattern having the bent portion, but is not limited to this configuration.

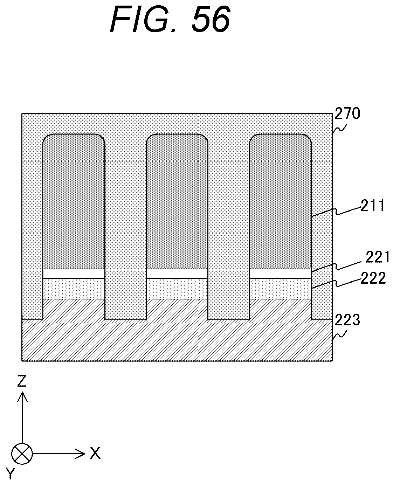

As exemplified in Fig. 56, together with the protective film 211, the cathode electrode 221, and the organic EL film 222, the anode electrode 223 can be processed into the same shape (S shape or the like) as those.

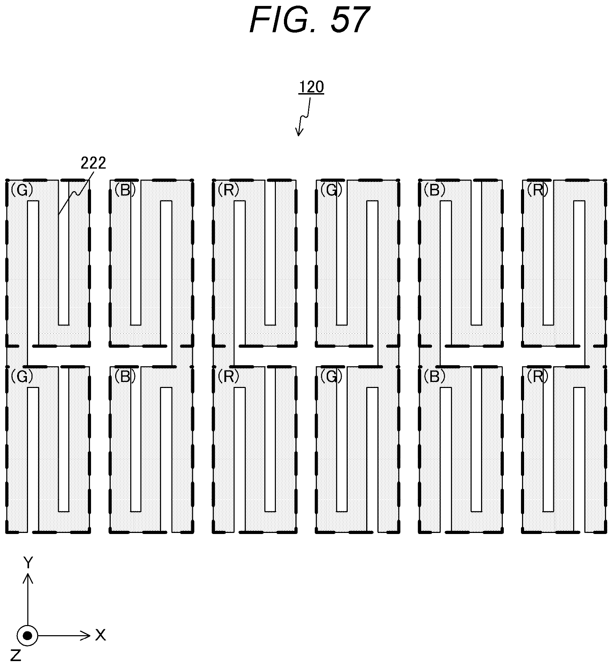

Furthermore, as exemplified in Fig. 57, sub-pixels having the shape having the bent portion can be arranged in a stripe array.

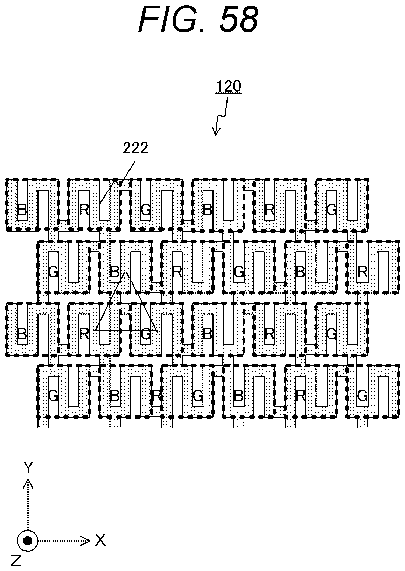

Alternatively, as exemplified in Fig. 58, sub-pixels may be arranged in a delta array.

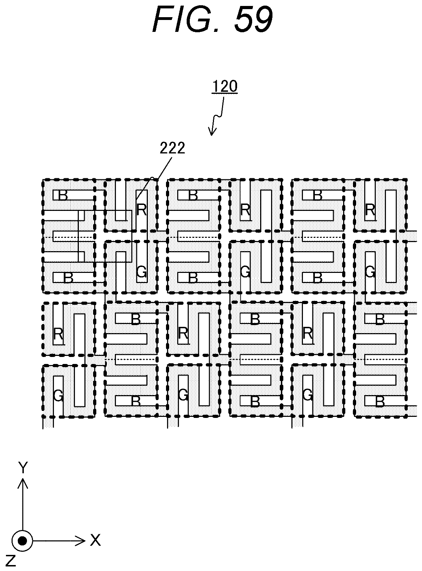

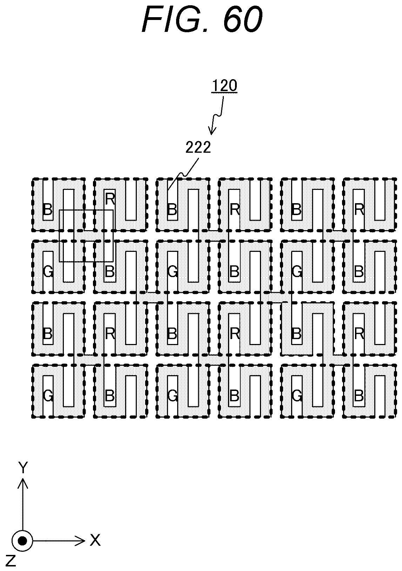

Alternatively, as exemplified in Figs. 59 and 60, sub-pixels can be arranged in a square array. In a case of the square array, as exemplified in Fig. 59, two B sub-pixels may also be disposed adjacent to each other in pixels in which two rows × two columns are disposed. As exemplified in Fig. 60, the two B sub-pixels may be arranged in an oblique direction.

Note that each of the second to fifth embodiments can be applied to the seventh embodiment.

As described above, according to the seventh embodiment of the present technology, since the organic EL film 222 in the sub-pixel has a shape having a predetermined number of bent portions, the light extraction efficiency can be improved.

<8. Eighth embodiment>

In the first embodiment described above, unevenness is not formed on the side wall of the sub-pixel when viewed from the X-axis direction or the Y-axis direction. However, with this configuration, it is difficult to further improve an effect of color mixing prevention and the light extraction efficiency. A display device 100 according to an eighth embodiment is different from that of the first embodiment in that unevenness is formed on a side wall of a sub-pixel when viewed from the X-axis direction or the Y-axis direction to prevent color mixing and improve the light extraction efficiency.

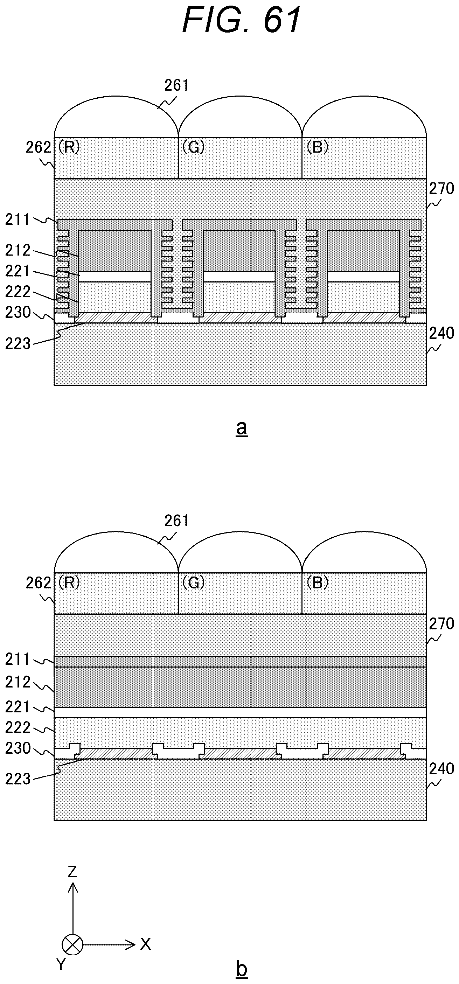

Fig. 61 is a diagram illustrating an example of a cross-sectional view of a pixel array unit 120 according to the eighth embodiment of the present technology. In the figure, a is an example of a cross-sectional view of the pixel array unit 120 taken along a cross section not including a connection portion. In the figure, b is an example of a cross-sectional view of the pixel array unit 120 taken along a cross section including a connection portion.

As exemplified in a of the figure, an organic EL film 222, a cathode electrode 221, and a protective film 212 are stacked on an anode electrode 223 in each of red (R), green (G), and blue (B) sub-pixels. Furthermore, a protective film 211 is formed so as to cover a side surface of each of the organic EL film 222 and the cathode electrode 221 and a side surface and the top of the protective film 212. Furthermore, embedding is performed with a low refractive index film 270 between individual sub-pixels, and a color filter 262 and an on-chip lens 261 are formed thereon.

Furthermore, as exemplified in a of the figure, unevenness is formed on a side wall of the protective film 211, in other words, a side wall of the sub-pixel when viewed from the X-axis direction or the Y-axis direction. Due to the formation of the unevenness, side-wall reflection of each of the sub-pixels is enhanced as compared with a case where there is no unevenness, and an amount of light incident on the color filter 262 immediately above is increased while maintaining a sealing property. As a result, color mixing can be prevented, and the light extraction efficiency can be improved. A cross-sectional shape of a protrusion in the unevenness has, for example, a rectangular shape.

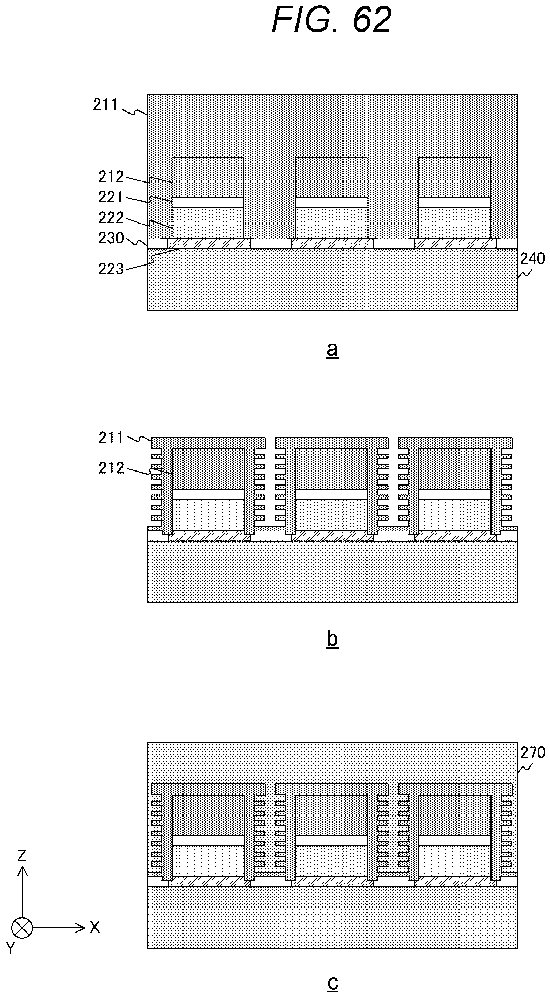

Fig. 62 is a diagram for explaining a manufacturing process according to the eighth embodiment of the present technology. As exemplified in a of the figure, the manufacturing system forms the anode electrode 223, the organic EL film 222, the cathode electrode 221, and the protective film 212 for every sub-pixel on a substrate 240, and performs embedding with the protective film 211. A refractive index of the protective film 211 is a value lower than or equal to a refractive index of the protective film 212 on the sub-pixel.

Then, as exemplified in b of the figure, the manufacturing system forms unevenness on the side wall of the protective film 211 by dry etching again, and performs embedding with the low refractive index film 270 as exemplified in c of the figure.

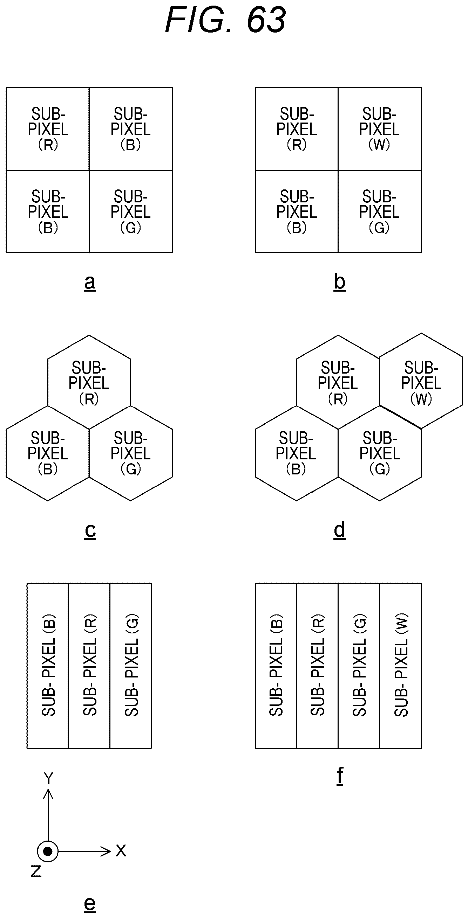

Fig. 63 is a diagram illustrating an example of an arrangement method for sub-pixels according to the eighth embodiment of the present technology. For example, as exemplified in a and b of the figure, the sub-pixels are arranged in a square array. In a case of the square array, sub-pixels of R, G, and B may be arranged as exemplified in a of the figure, or sub-pixels of R, G, B, and W (white) may be arranged as exemplified in b of the figure.

Furthermore, as exemplified in c and d of the figure, the sub-pixels may be arranged in a delta array. In a case of the delta array, sub-pixels of R, G, and B may be arranged as exemplified in c of the figure, or sub-pixels of R, G, B, and W may be arranged as exemplified in d of the figure.

Alternatively, as exemplified in e and f of the figure, the sub-pixels may be arranged in a stripe array. In a case of the stripe array, sub-pixels of R, G, and B may be arranged as exemplified in e of the figure, or sub-pixels of R, G, B, and W may be arranged as exemplified in f of the figure.

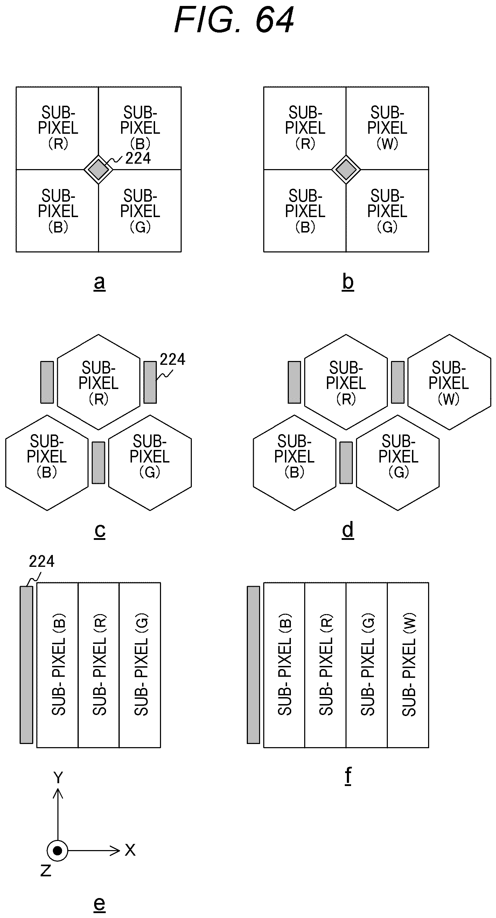

Furthermore, as exemplified in Fig. 64, a cathode contact electrode 224 may also be disposed between adjacent pixels.

Note that each of the second to seventh embodiments can be applied to the eighth embodiment.

As described above, according to the eighth embodiment of the present technology, since the unevenness is formed on the side wall of the sub-pixel when viewed from the X-axis direction or the Y-axis direction, color mixing can be prevented, and the light extraction efficiency can be improved.

[First modification]

In the eighth embodiment described above, the unevenness is formed on the side wall of the protective film 211 of each sub-pixel, but the unevenness may be formed other than the protective film 211. A display device 100 according to a first modification of the eighth embodiment is different from that of the eighth embodiment in that a texture film is added and unevenness is formed on the texture film.

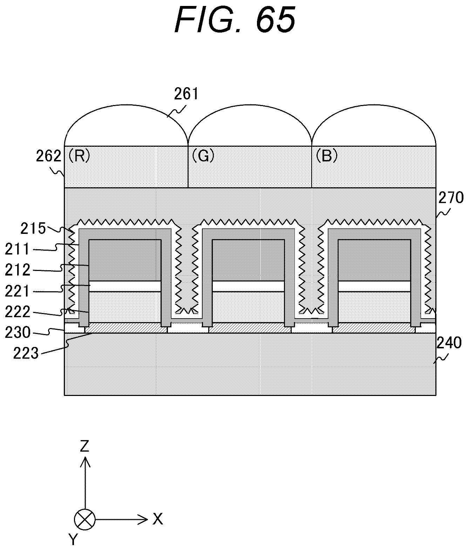

Fig. 65 is a diagram illustrating an example of a cross-sectional view of a pixel array unit 120 according to the first modification of the eighth embodiment of the present technology. An upper surface and a side surface of the protective film 211 of each of sub-pixels of the first modification of the eighth embodiment are covered with a texture film 215. Unevenness is formed on the texture film 215 instead of the protective film 211. For example, zinc oxide (ZnO) is used as the texture film 215.

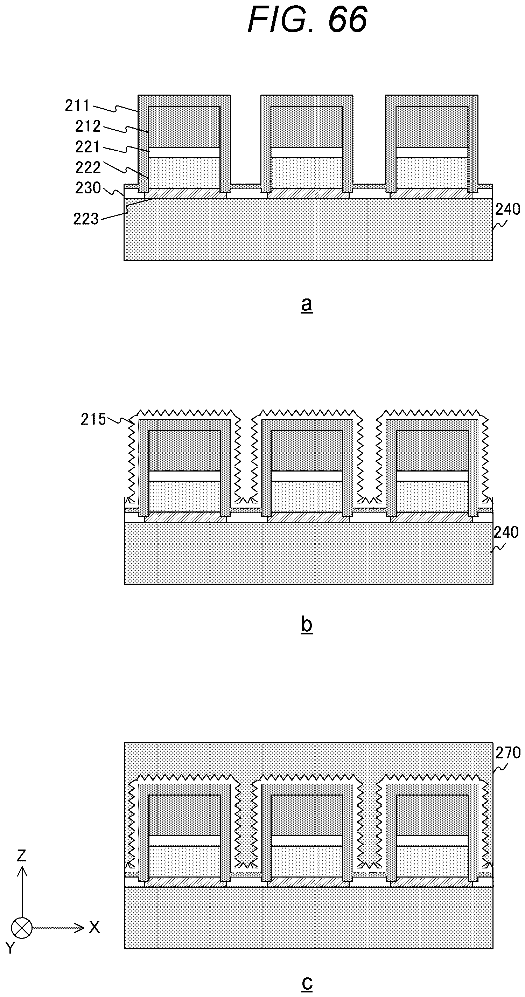

Fig. 66 is a diagram for explaining a manufacturing process in the first modification of the eighth embodiment of the present technology. As exemplified in a of the figure, in the first modification of the eighth embodiment, embedding with the protective film 211 is not performed. As exemplified in b of the figure, the manufacturing system forms the texture film 215 having unevenness, on the upper surface and the side surface of the protective film 211. Then, as exemplified in c of the figure, the manufacturing system embeds the sub-pixels with the low refractive index film 270.

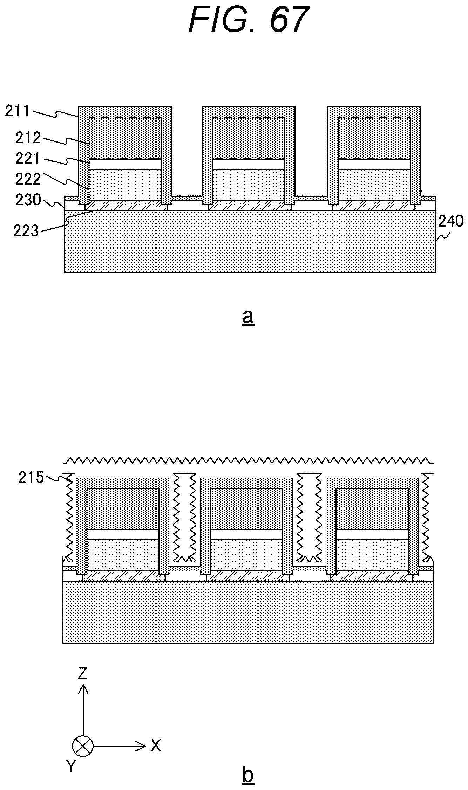

Note that, as exemplified in Fig. 67, an air gap surrounded by the texture film 215 can also be formed between the sub-pixels.

As described above, according to the first modification of the eighth embodiment of the present technology, since the unevenness is formed in the texture film 215, light is reflected by the side wall to prevent color mixing, and the light extraction efficiency can be improved.

[Second modification]

In the eighth embodiment described above, the unevenness is formed on the entire side wall of the sub-pixel, but the unevenness may be formed only on a part of the side wall. A display device 100 according to a second modification of the eighth embodiment is different from that of the eighth embodiment in that unevenness is formed on an upper portion and a lower portion of the side wall.

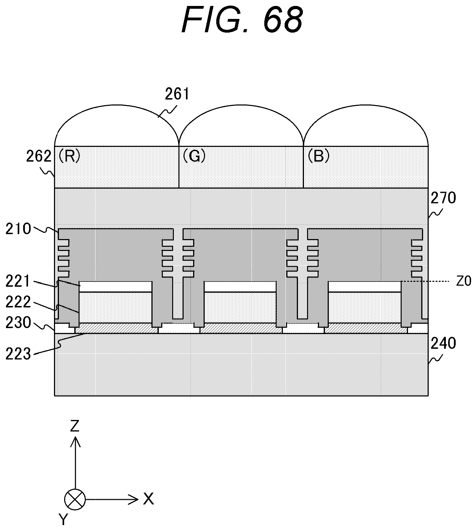

Fig. 68 is a diagram illustrating an example of a cross-sectional view of a pixel array unit 120 according to the second modification of the eighth embodiment of the present technology. The pixel array unit 120 according to the second modification of the eighth embodiment is different from that of the eighth embodiment in that unevenness is formed only on the upper portion of the side wall of the protective film 210.

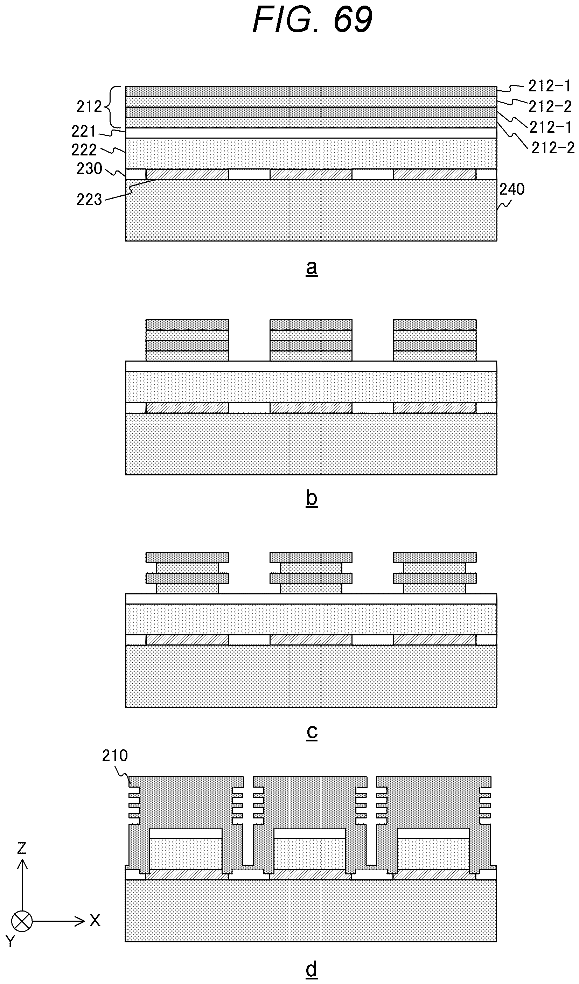

Fig. 69 is a diagram for explaining a manufacturing process in the second modification of the eighth embodiment of the present technology. As exemplified in a of the figure, the manufacturing system forms the organic EL film 222, and forms a layer of the cathode electrode 221 on the organic EL film 222. At this stage, it is assumed that the organic EL film 222 and the cathode electrode 221 are not separated for every sub-pixel.

The protective film 212 is formed by stacking a plurality of layers having different etching rates at the time of etching on the cathode electrode 221. For example, a layer 212-1 having a higher etching rate and a layer 212-2 having a lower etching rate are alternately stacked.

As exemplified in b of the figure, the manufacturing system separates the protective film 212 for every sub-pixel by dry etching, and forms unevenness on the side wall of the protective film 211 by wet etching using an etching rate difference, as exemplified in c of the figure.

Then, as exemplified in d of the figure, the manufacturing system separates the protective film 211, the organic EL film 222, and the cathode electrode 221 for every sub-pixel by dry etching, and further forms the protective film 212 on the top and a side surface of each of the separated portions. As a result, unevenness is formed only on the upper portion of the side wall of the protective film 210 including the protective films 211 and 212.

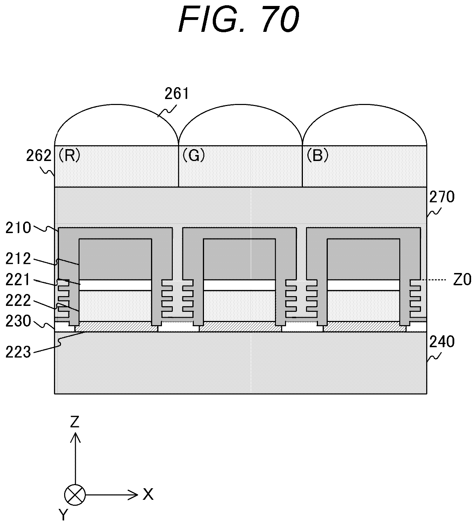

Note that, as exemplified in Fig. 70, unevenness may be formed only in a lower portion of the side wall.

As described above, according to the second modification of the eighth embodiment of the present technology, since the unevenness is formed only on the upper portion and the lower portion of the side wall, a reflection area of the side-wall reflection can be adjusted.

[Third modification]

In the eighth embodiment described above, the cross-sectional shape of the protrusion of the unevenness of the side wall is rectangular, but the cross-sectional shape of the protrusion is not limited to rectangular. A display device 100 in a third modification of the eighth embodiment is different from that of the eighth embodiment in that the cross-sectional shape of unevenness is changed.

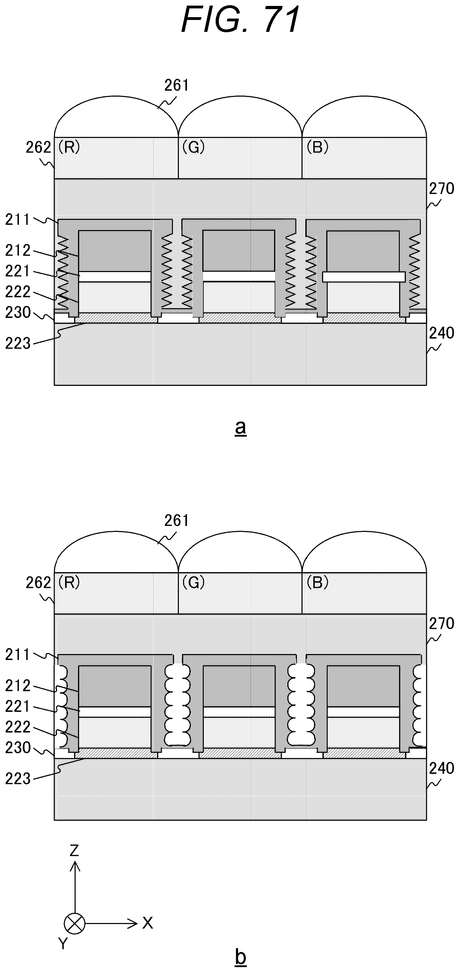

Fig. 71 is a diagram illustrating an example of a cross-sectional view of a pixel array unit 120 according to the third modification of the eighth embodiment of the present technology. In the figure, a illustrates an example of a cross-sectional view of the pixel array unit in which the cross-sectional shape of the protrusion is triangular. In the figure, b illustrates an example of a cross-sectional view of the pixel array unit 120 in which the cross-sectional shape of the recess is semicircular.

As exemplified in a of the figure, the cross-sectional shape of the protrusion can be made triangular. Alternatively, as exemplified in b of the figure, the cross-sectional shape of the recess can be made semicircular. By changing the cross-sectional shape of the unevenness, it is possible to change reflectance of side reflection and adjust the light extraction efficiency.

Any shape can be selected as the cross-sectional shape of the unevenness of the side wall, including the above-described triangular and the like. For example, the unevenness is constituted by a polygon including a plurality of vertices of the protrusions, and the cross-sectional shape of the protrusion includes at least one of a triangle, a quadrangle, a polygon, or a circle, and may partially include a curve. According to a simulation, emission intensity is improved at any viewing angle by introducing the uneven shape. The emission intensity increases depending on a depth and a width of the recess, for example. In a case where the depth is 200 nanometers (nm) and the width is 120 nanometers (nm), the emission intensity is 1.21 times as large as that in a case where there is no unevenness.

As described above, according to the third modification of the eighth embodiment of the present technology, since the cross-sectional shape of the unevenness is changed, the light extraction efficiency can be adjusted.

[Fourth modification]

In the eighth embodiment described above, embedding is performed with the low refractive index film 270 between sub-pixels, but a gap may be provided without embedding. A fourth modification of the eighth embodiment is different from the eighth embodiment in that a gap is provided between sub-pixels.

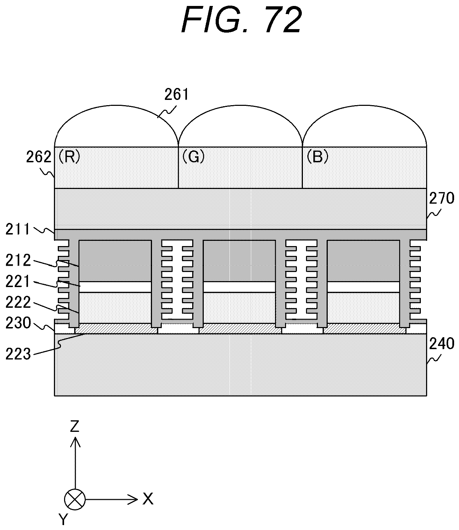

Fig. 72 is a diagram illustrating an example of a cross-sectional view of a pixel array unit 120 according to the fourth modification of the eighth embodiment of the present technology. In the fourth modification of the eighth embodiment, a gap surrounded by the protective film 211 is provided between sub-pixels. The low refractive index film 270 is laminated on the protective film 211. The light extraction efficiency can be adjusted by changing reflectance of side reflection by the gap.

As described above, according to the third modification of the eighth embodiment of the present technology, since the gap is provided between sub-pixels, the light extraction efficiency can be adjusted.

<9. Ninth embodiment>

In the first embodiment described above, the organic EL film 222 is formed in the sub-pixel and in the connection portion between the sub-pixels when viewed from the Z-axis direction. However, in this layout, when a portion where the organic EL film 222 is not formed is set as an opening, and an angle formed by edges of the opening is small, there is a possibility that coverage of the protective film 211 of the side wall is deteriorated and a moisture entry path occurs. A display device 100 according to a ninth embodiment is different from that of the first embodiment in that an organic EL film 222 is formed in a layout in which an angle formed by edges of an opening is large.

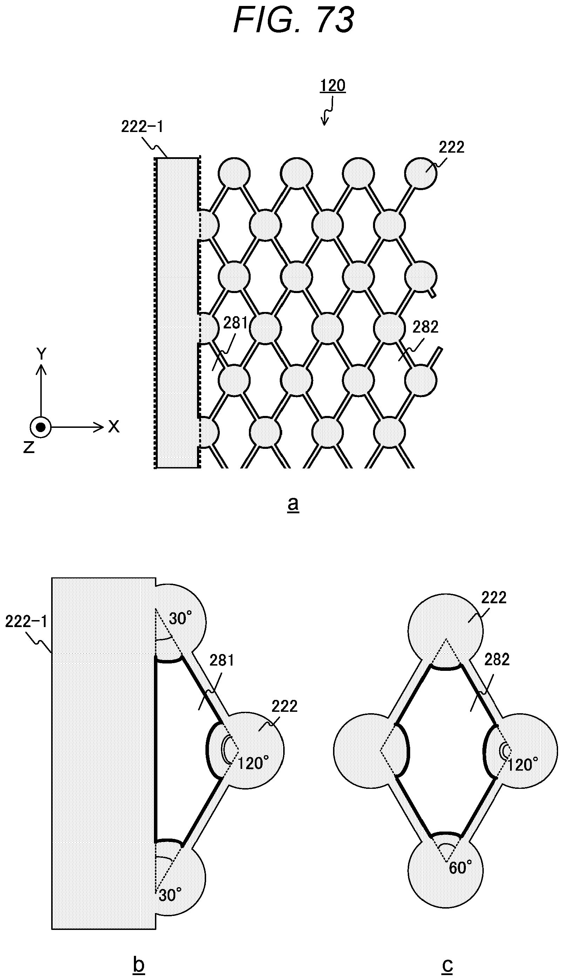

Fig. 73 is a plan view illustrating an example of a layout of the organic EL film 222 according to the first embodiment of the present technology. For comparison with the ninth embodiment, a of the figure illustrates a layout of the organic EL film 222 according to the first embodiment when viewed from the Z-axis direction.

As exemplified in a of the figure, the organic EL film 222 is formed in a predetermined number of sub-pixels, a connection portion between the sub-pixels, and a frame-shaped frame 222-1 surrounding the sub-pixels. A circular region indicates the sub-pixel, and a rectangular portion mutually connecting circles indicates the connection portion. A dotted line indicates a boundary of the frame 222-1. The boundary of the frame 222-1 is a straight line, and some sub-pixels are cut by the boundary.

Since the organic EL film 222 is left only in the connection portion in the inter-pixel region between the sub-pixels, a plurality of openings is formed in the organic EL film 222. These openings are divided into an opening 281 having at least one edge in contact with the frame 222-1 and an opening 282 having no edge in contact with the frame 222-1.

In the figure, b illustrates an enlarged view of the opening 281. A thick line in b of the figure indicates a boundary of the opening 281. The boundary includes a linear edge and an arc. An angle between two edges is, for example, 120° or 30°.

In the figure, c illustrates an enlarged view of the opening 282. A thick line in c of the figure indicates a boundary of the opening 282. This boundary also includes a linear edge and an arc. An angle between two edges is, for example, 60° or 120°.

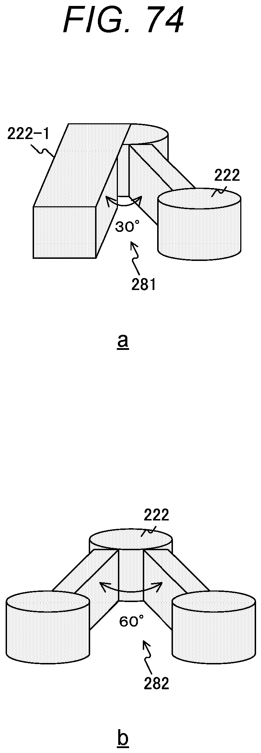

Fig. 74 is an example of a perspective view of an opening according to the first embodiment of the present technology. In the figure, a indicates a smallest angle among angles formed by two edges of the opening 281 having at least one edge in contact with the frame 222-1, and the angle is 30°.

In the figure, b indicates a smallest angle among angles formed by two edges of the opening 282 having no edge in contact with the frame 222-1, and the angle is 60°.

As described above, a minimum value of angles formed by two edges of the opening 281 is smaller than that of the opening 282. When the angle is small as described above, the coverage of a protective film 211 (silicon nitride or the like) on the side wall of the organic EL film 222 is deteriorated, and a thin portion of a protective film 221 is generated. This portion is likely to be an entry path of moisture. When moisture enters, damage may be formed on the organic EL film 222, causing deterioration of the organic EL film.

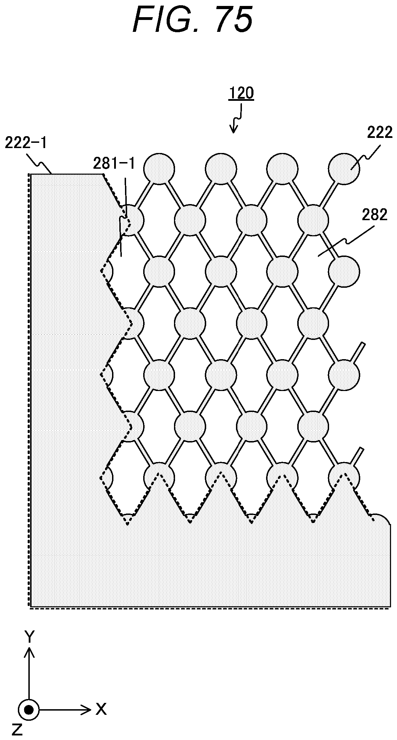

Fig. 75 is a plan view illustrating an example of a layout of the organic EL film 222 according to the ninth embodiment of the present technology. As exemplified in the figure, in the ninth embodiment, the organic EL film 222 is also formed at a portion that has been the opening 281 in the first embodiment. As a result, a boundary of the frame 222-1 indicated by a dotted line has a sawtooth shape. A shape of an opening 281-1 in contact with at least one edge of the frame 222-1 having this shape is the same as the shape of the opening 282 having no edge in contact with the frame 222-1. Note that, the opening 281-1 is an example of a first opening described in the claims, and the opening 282 is an example of a second opening described in the claims.

Since the shapes of an opening 282-1 and the opening 282 are the same, a minimum value of angles formed by two edges of the opening 282-1 is equal to a minimum value of angles formed by two edges of the opening 282. As a result, as compared with the first embodiment, a film thickness of the protective film 211 in the vicinity of the frame 222-1 can be made equal to that of a side surface of a sub-pixel away from the frame 222-1, and deterioration of the frame 222-1 can be avoided. In particular, when densification of pixels is progressed, an aspect ratio of the opening is further increased, and the coverage of the protective film 211 is deteriorated. Therefore, it is important to avoid deterioration by the layout exemplified in the figure.

Note that, as will be described later, a minimum value of angles formed by two edges of an opening having at least one edge in contact with the frame 222-1 can also be made larger than a minimum value of angles formed by two edges of an opening having no edge in contact with the frame 222-1. Furthermore, each of the second to eighth embodiments can be applied to the ninth embodiment.

As described above, according to the ninth embodiment of the present technology, since a minimum value of angles formed by two edges of the opening 281-1 is made equal to a minimum value of angles formed by two edges of the opening 282, it is possible to suppress deterioration of the frame 222-1.

[First modification]

In the ninth embodiment described above, the shape of the opening 281-1 having at least one edge in contact with the frame 222-1 is the same as that of the opening 282 having no such an edge, but the present technology is not limited to this layout. A display device 100 in a first modification of the ninth embodiment is different from that of the ninth embodiment in that a layout is changed.

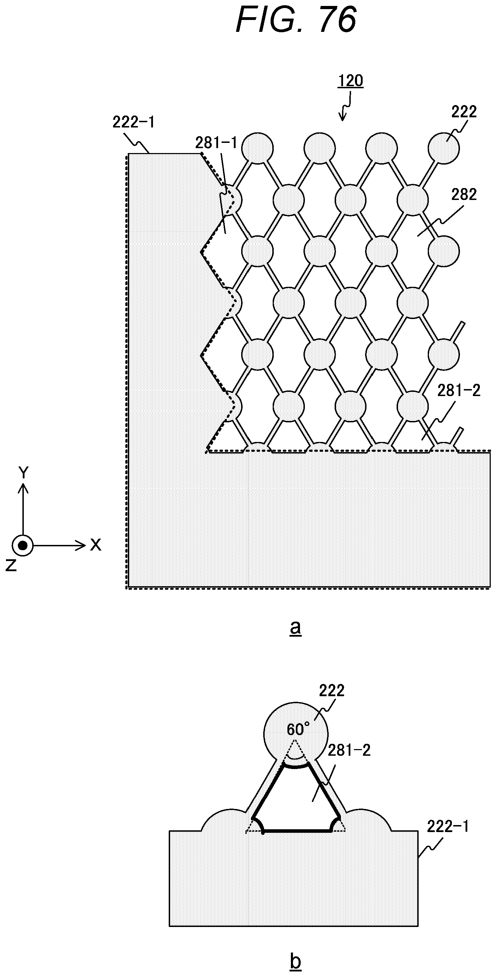

Fig. 76 is a plan view illustrating an example of a layout of the organic EL film 222 in the first modification of the ninth embodiment of the present technology. As exemplified in a of the figure, in the first modification of the ninth embodiment, a boundary of the frame 222-1 includes an edge having a sawtooth shape and an edge having a linear shape. The opening 281-1 in contact with the former has the same shape as the opening 282. Whereas, an opening 281-2 in contact with the latter is different in shape from the opening 282, and has a shape close to a triangular shape.

In the figure, b illustrates an enlarged view of the opening 281-2. A minimum value of angles formed by two edges of the opening 281-2 is 60°.

As exemplified in a and b of the figure, also for the opening 281-2 having a different shape from the opening 282, a minimum value of angles formed by two edges is equal to a minimum value of angles formed by two edges of the opening 282. Therefore, deterioration of the frame 222-1 can be suppressed.

As described above, according to the first modification of the ninth embodiment of the present technology, since a minimum value of angles formed by two edges is also made equal to a minimum value of angles formed by two edges of the opening 282 even for the opening 281-2 having a different shape, it is possible to suppress deterioration of the frame 222-1.

[Second modification]

In the ninth embodiment described above, the shape of the opening 281-1 having at least one edge in contact with the frame 222-1 is the same as that of the opening 282 having no such an edge, but the present technology is not limited to this layout. A display device 100 in a second modification of the ninth embodiment is different from that of the ninth embodiment in that a layout is changed.

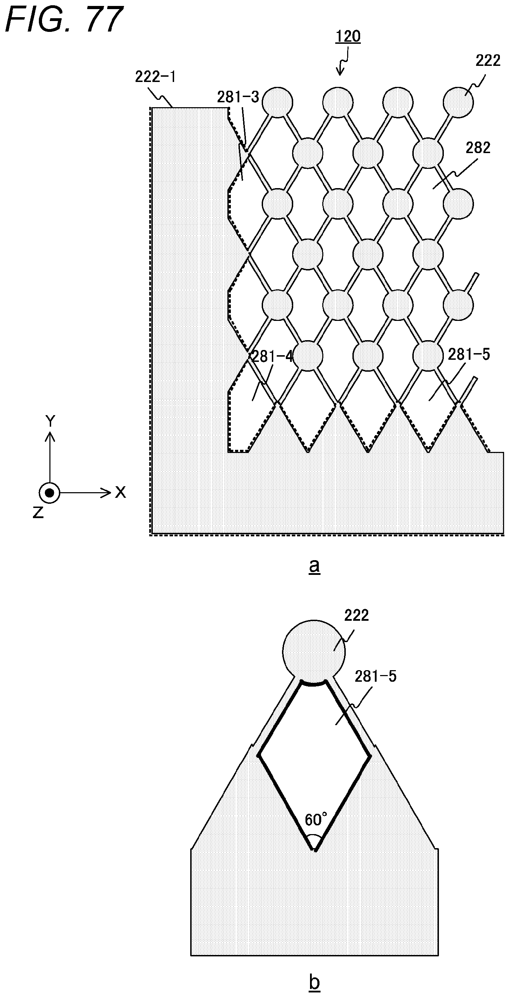

Fig. 77 is a plan view illustrating an example of a layout of the organic EL film 222 in the second modification of the ninth embodiment of the present technology. As exemplified in a of the figure, in the second modification of the ninth embodiment, a circular portion corresponding to a sub-pixel is not disposed in a region near the frame 222-1, but is disposed at a position sufficiently away from the frame 222-1. With this layout, areas of openings 281-3, 281-4, and 281-5 having at least one edge in contact with the frame 222-1 are larger than an area of the opening 282.

In the figure, b illustrates an enlarged view of the opening 281-5. As exemplified in b of the figure, a minimum value of angles formed by two edges of the opening 281-5 is 60°, which is equivalent to a minimum value of angles formed by two edges of the opening 282. This similarly applies to other openings 281-3 and 281-4. As a result, deterioration of the frame 222-1 can be suppressed.

As described above, according to the second modification of the ninth embodiment of the present technology, since a minimum value of angles formed by two edges of the opening 281-3 and the like having a relatively large area is made equal to a minimum value of angles formed by two edges of the opening 282, deterioration of the frame 222-1 can be suppressed.

[Third modification]

In the ninth embodiment described above, the shape of the opening 281-1 having at least one edge in contact with the frame 222-1 is the same as that of the opening 282 having no such an edge, but the present technology is not limited to this layout. A display device 100 in a third modification of the ninth embodiment is different from that of the ninth embodiment in that a layout is changed.

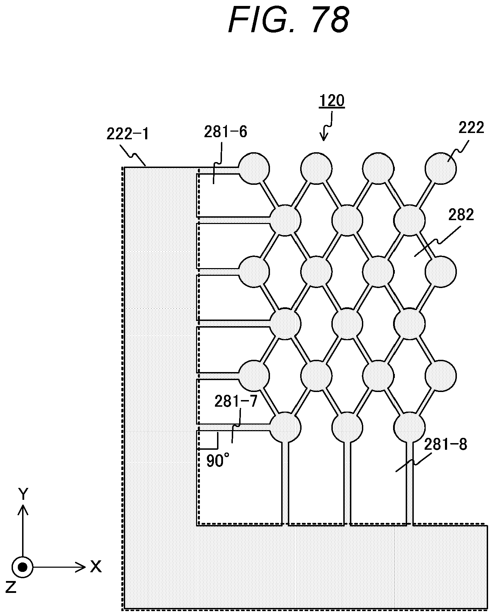

Fig. 78 is a plan view illustrating an example of a layout of the organic EL film 222 in the third modification of the ninth embodiment of the present technology. In the third modification of the ninth embodiment, a boundary of the frame 222-1 has a linear shape, and a circular portion corresponding to a sub-pixel is disposed at a position sufficiently away from the frame 222-1. In this layout, there are three patterns of openings 281-6, 281-7, and 281-8 having at least one edge in contact with the frame 222-1.

In each of the openings 281-6 and 281-8, a minimum value of angles formed by two edges is 60°, which is the same as a minimum value of angles formed by two edges of the opening 282. Whereas, a minimum value of angles formed by two edges of the opening 281-7 adjacent to a corner of the frame 222-1 is 90°, which is larger than the angle formed by two edges of the opening 282. As a result, deterioration is suppressed particularly in the vicinity of the corner of the frame 222-1.

As described above, according to the second modification of the ninth embodiment of the present technology, since a minimum value of angles formed by two edges of the opening 281-7 adjacent to the corner is made larger than the angle formed by two edges of the opening 282, deterioration in the vicinity of the corner can be suppressed.

[Relationship among normal lines extending through centers of light emitting units, lens members, and wavelength selection units]

In the description below, a relationship among a normal line LN extending through a center of a light emitting unit, a normal line LN' extending through a center of a lens member, and a normal line LN" extending through a center of a wavelength selection unit is described. Here, the organic EL film 222 and the like in a sub-pixel correspond to the light emitting unit.

Note that a size of a wavelength selection unit (for example, a color filter layer) may be appropriately changed corresponding to light emitted from the light emitting element, or a size of a light absorbing layer (black matrix layer) may be appropriately changed corresponding to light emitted from the light emitting element in a case where the light absorbing layer (black matrix layer) is provided between wavelength selection units (for example, color filter layers) of adjacent light emitting elements. Furthermore, the size of the wavelength selection unit (for example, the color filter layer) may be appropriately changed according to a distance (offset amount) $d_0$ between a normal line passing through a center of the light emitting unit and a normal line passing through a center of a color filter layer CF. A planar shape of the wavelength selection unit (for example, the color filter layer) may be the same as, similar to, or different from a planar shape of the lens member.

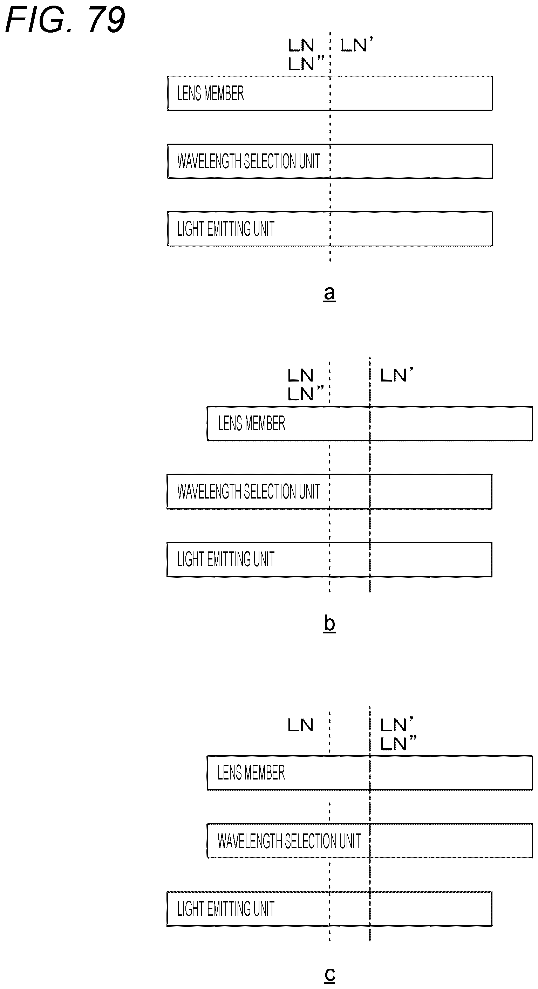

In the example illustrated in each of the embodiments described above, as illustrated in a conceptual diagram in a of Fig. 79, the normal line LN passing through the center of the light emitting unit, the normal line LN" passing through the center of the wavelength selection unit, and the normal line LN' passing through the center of the lens member coincide with each other. That is, $D_0 = d_0 = 0$ is satisfied.

Furthermore, in each of the embodiments described above, as illustrated in a conceptual diagram in b of Fig. 79, a configuration may be adopted in which the normal line LN passing through the center of the light emitting unit and the normal line LN" passing through the center of the wavelength selection unit coincide with each other, but the normal line LN passing through the center of the light emitting unit and the normal line LN" passing through the center of the wavelength selection unit do not coincide with the normal line LN' passing through the center of the lens member. That is, $D_0 \neq d_0 = 0$ is satisfied.

Furthermore, in each of the embodiments described above, as illustrated in a conceptual diagram in c of Fig. 79, a configuration may be adopted in which the normal line LN passing through the center of the light emitting unit does not coincide with the normal line LN" passing through the center of the wavelength selection unit and the normal line LN' passing through the center of the lens member, and the normal line LN" passing through the center of the wavelength selection unit and the normal line LN' passing through the center of the lens member coincide with each other. That is, $D_0 = d_0 > 0$ is satisfied.

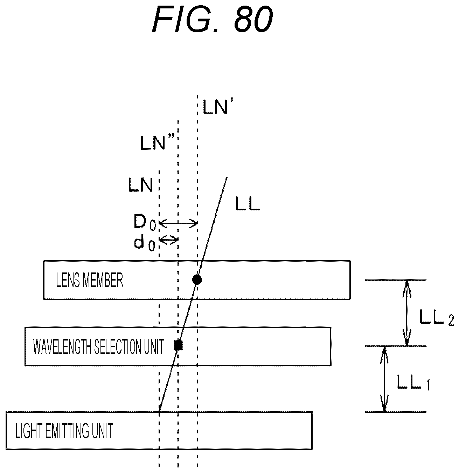

As illustrated in a conceptual diagram in Fig. 80, a mode may be adopted in which the normal line LN passing through the center of the light emitting unit does not coincide with the normal line LN" passing through the center of the wavelength selection unit and the normal line LN' passing through the center of the lens member, and the normal line LN' passing through the center of the lens member does not coincide with the normal line LN passing through the center of the light emitting unit and the normal line LN" passing through the center of the wavelength selection unit. Here, the center of the wavelength selection unit (indicated by a black square in Fig. 80) is preferably located on a straight line LL connecting the center of the light emitting unit and the center of the lens member (indicated by a black circle in Fig. 31). Specifically, when a distance from a center of the light emitting unit to a center of the wavelength selection unit in a thickness direction is $LL_1$, and a distance from the center of the wavelength selection unit to the center of the lens member in the thickness direction is $LL_2$,

$$D_0 > d_0 > 0$$

is satisfied, and

$$d_0 : D_0 = LL_1 : (LL_1 + LL_2)$$

is preferably satisfied, considering manufacturing variations.

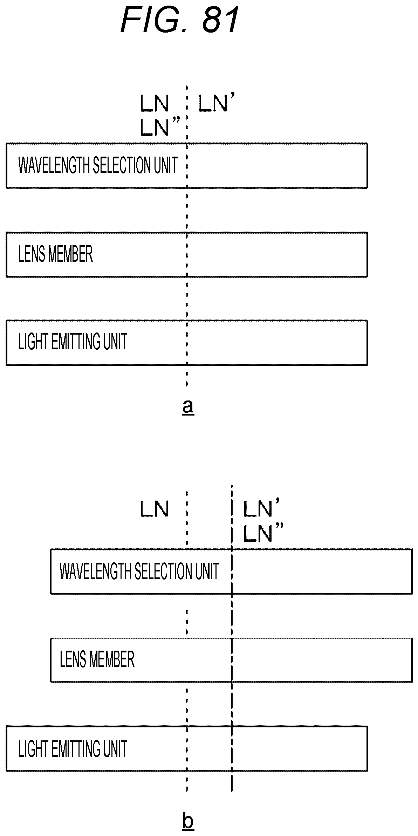

In each of the embodiments described above, as illustrated in a conceptual diagram in a of Fig. 81, a configuration may be adopted in which the normal line LN passing through the center of the light emitting unit, the normal line LN" passing through the center of the wavelength selection unit, and the normal line LN' passing through the center of the lens member coincide with each other. In this case, $D_0 = d_0 = 0$ is satisfied. In each of the embodiments described above, as illustrated in a conceptual diagram in b of Fig. 81, a configuration may be adopted in which the normal line LN passing through the center of the light emitting unit does not coincide with the normal line LN" passing through the center of the wavelength selection unit and the normal line LN' passing through the center of the lens member, and the normal line LN" passing through the center of the wavelength selection unit and the normal line LN' passing through the center of the lens member coincide with each other. In this case, $D_0 = d_0 > 0$ is satisfied.

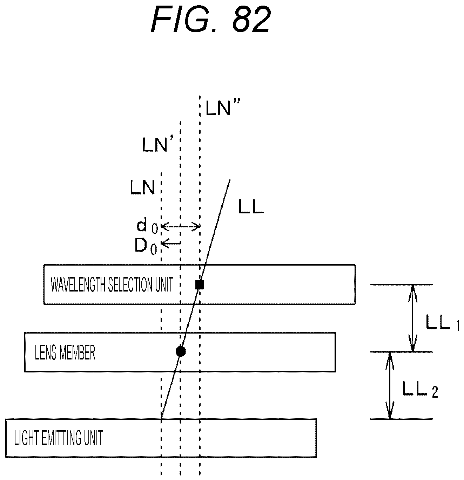

As illustrated in a conceptual diagram in Fig. 82, a mode may be adopted in which the normal line LN passing through the center of the light emitting unit does not coincide with the normal line LN" passing through the center of the wavelength selection unit and the normal line LN' passing through the center of the lens member, and the normal line LN' passing through the center of the lens member does not coincide with the normal line LN passing through the center of the light emitting unit and the normal line LN" passing through the center of the wavelength selection unit. Here, the center of the wavelength selection unit is preferably located on the straight line LL connecting the center of the light emitting unit and the center of the lens member. Specifically, when a distance from the center of the light emitting unit to the center of the wavelength selection unit (indicated by a black square in Fig. 82) in the thickness direction is $LL_1$, and a distance from the center of the wavelength selection unit to the center of the lens member (indicated by a black circle in Fig. 82) in the thickness direction is $LL_2$,

$$d_0 > D_0 > 0$$

is satisfied, and

$$D_0:d_0 = LL_2:(LL_1 + LL_2)$$

is preferably satisfied, considering manufacturing variations.

[Example of resonator structure applied to each embodiment]

The pixel used in the display device according to the present disclosure described above may have a resonator structure that causes resonance of light generated in the light emitting unit. Hereinafter, the resonator structure will be described with reference to the drawings.

(Resonator structure: First example)

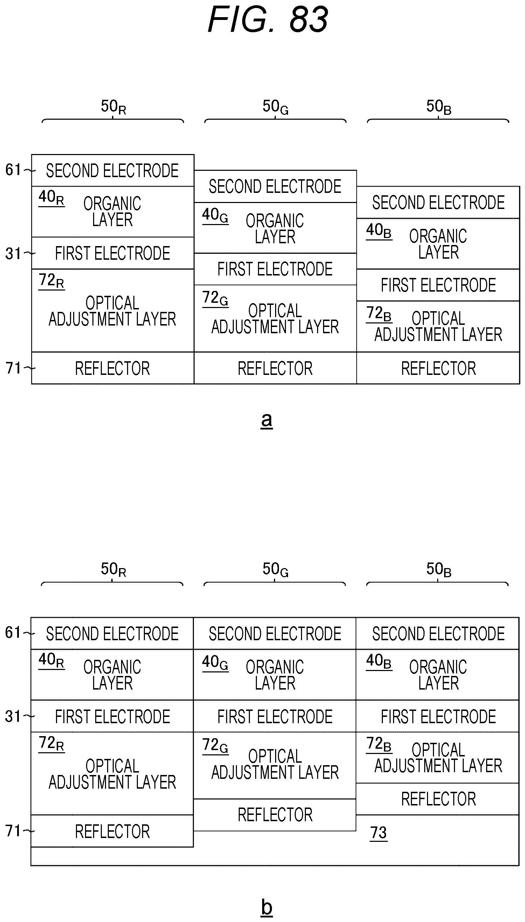

Fig. 83 is a schematic cross-sectional view for explaining a first example of the resonator structure.

In the first example, a first electrode 31 is formed to have a common film thickness in each light emitting unit 50. This similarly applies to a second electrode 61.

A reflector 71 is disposed below the first electrode 31 of the light emitting unit 50 with an optical adjustment layer 72 interposed therebetween. The resonator structure that causes resonance of light generated by an organic layer 40 is formed between the reflector 71 and the second electrode 61.

The reflector 71 is formed to have a common film thickness in each light emitting unit 50. The film thickness of the optical adjustment layer 72 is different according to a color to be displayed by the pixel. Since optical adjustment layers 72R, 72G, and 72B have different film thicknesses, it is possible to set an optical distance that causes optimum resonance for a wavelength of light according to the color to be displayed.

In the example illustrated in the figure, upper surfaces of the reflectors 71 in light emitting units 50R, 50G, and 50B are disposed so as to be aligned. As described above, since the film thickness of the optical adjustment layer 72 is different according to the color to be displayed by the pixel, positions of upper surfaces of the second electrode 61 are different according to the type of the light emitting units 50R, 50G, and 50B.

The reflectors 71 can be formed with a metal such as aluminum (Al), silver (Ag), or copper (Cu), or an alloy containing these metals as principal components, for example.

The optical adjustment layers 72 can be formed with an inorganic insulating material such as silicon nitride (SiNx), silicon oxide (SiOx), or silicon oxynitride (SiOxNy), or an organic resin material such as an acrylic resin or a polyimide resin. Each optical adjustment layer 72 may be a single layer, or may be a film stack formed with a plurality of materials. Furthermore, the number of stacked layers may be different according to the type of the light emitting unit 50.

The first electrode 31 can be formed using a transparent conductive material such as indium tin oxide (ITO), indium zinc oxide (IZO), or zinc oxide (ZnO).

The second electrode 61 needs to function as a semi-transmission reflection film. The second electrodes 61 can be formed with magnesium (Mg), silver (Ag), a magnesium-silver alloy (MgAg) containing these materials as the principal components, an alloy containing an alkali metal or an alkaline earth metal, or the like.

(Resonator structure: Second example)

In Fig. 83, b is a schematic cross-sectional view for explaining a second example of the resonator structure.

Also in the second example, the first electrode 31 and the second electrode 61 are formed to have a common film thickness in each light emitting unit 50.

Then, also in the second example, the reflector 71 is disposed below the first electrode 31 of the light emitting unit 50 with the optical adjustment layer 72 interposed therebetween. The resonator structure that causes resonance of light generated by an organic layer 40 is formed between the reflector 71 and the second electrode 61. Similarly to the first example, the reflector 71 is formed to have a common film thickness in each light emitting unit 50, and the film thickness of the optical adjustment layer 72 is different according to the color to be displayed by the pixel.

In the first example illustrated in a of Fig. 83, upper surfaces of the reflectors 71 in the light emitting units 50R, 50G, and 50B have been disposed so as to be aligned, and positions of the upper surfaces of the second electrodes 61 have been different according to the types of the light emitting units 50R, 50G, and 50B.

On the other hand, in the second example illustrated in b of Fig. 83, the upper surfaces of the second electrodes 61 are disposed so as to be aligned with the light emitting units 50R, 50G, and 50B. In order to align the upper surfaces of the second electrodes 61, the upper surfaces of the reflectors 71 in the light emitting units 50R, 50G, and 50B are disposed to be different according to the types of the light emitting units 50R, 50G, and 50B. Therefore, a lower surface (in other words, a surface of a base 73 indicated by reference numeral 73 in the figure) of the reflector 71 has a stair shape according to the type of the light emitting unit 50.

Materials and the like constituting the reflector 71, the optical adjustment layer 72, the first electrode 31, and the second electrode 61 are similar to those in contents described in the first example, and thus the description thereof is omitted.

(Resonator structure: Third example)

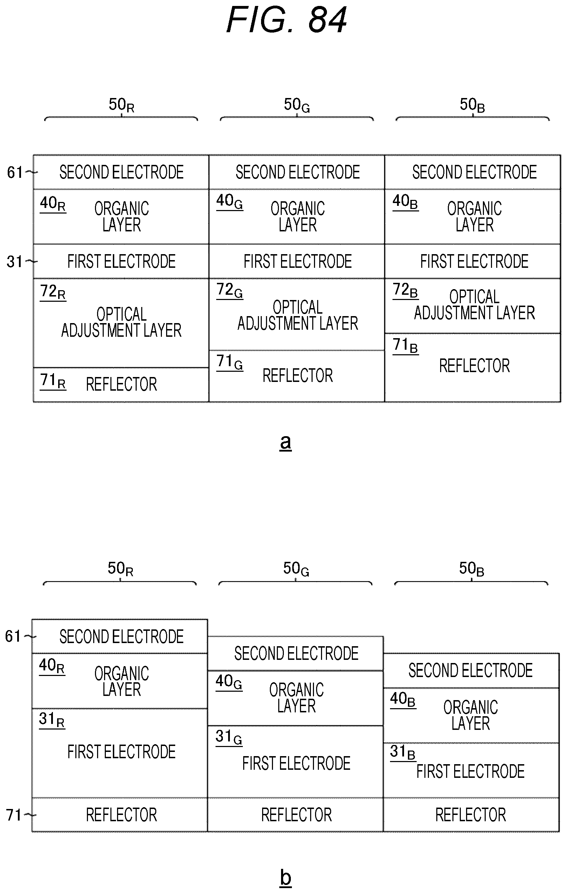

In Fig. 84, a is a schematic cross-sectional view for explaining a third example of the resonator structure.

Also in the third example, the first electrode 31 and the second electrode 61 are formed to have a common film thickness in each light emitting unit 50.

Then, also in the third example, the reflector 71 is disposed below the first electrode 31 of the light emitting unit 50 with the optical adjustment layer 72 interposed therebetween. The resonator structure that causes resonance of light generated by the organic layer 40 is formed between the reflector 71 and the second electrode 61. Similarly to the first and the second examples, the film thickness of the optical adjustment layer 72 is different according to the color to be displayed by the pixel. Then, similarly to the second example, the light emitting units 50R, 50G, and 50B are disposed such that positions of upper surfaces of the second electrodes 61 are aligned.

In the second example illustrated in b of Fig. 83, in order to align the upper surfaces of the second electrodes 61, the lower surface of the reflector 71 has had a stair shape according to the type of the light emitting unit 50.

On the other hand, in the third example illustrated in a of Fig. 83, the film thickness of the reflector 71 is set to be different according to the types of the light emitting units 50R, 50G, and 50B. More specifically, the film thickness is set such that lower surfaces of the reflectors 71R, 71G, and 71B are aligned.

Materials and the like constituting the reflector 71, the optical adjustment layer 72, the first electrode 31, and the second electrode 61 are similar to those in contents described in the first example, and thus the description thereof is omitted.

(Resonator structure: Fourth example)

In Fig. 84, b is a schematic cross-sectional view for explaining a fourth example of the resonator structure.

In the first example illustrated in a of Fig. 83, each of the first electrode 31 and the second electrode 61 of each light emitting unit 50 is formed to have a common film thickness. Then, the reflector 71 is disposed below the first electrode 31 of the light emitting unit 50 with the optical adjustment layer 72 interposed therebetween.

On the other hand, in the fourth example illustrated in b of Fig. 84, the optical adjustment layer 72 is omitted, and the film thickness of the first electrode 31 is set to be different according to the types of the light emitting units 50R, 50G, and 50B.

The reflector 71 is formed to have a common film thickness in each light emitting unit 50. The film thickness of the first electrode 31 is different according to the color to be displayed by the pixel. Since first electrodes 31R, 31G, and 31B have different film thicknesses, it is possible to set an optical distance that causes optimum resonance for a wavelength of light according to the color to be displayed.

Materials and the like constituting the reflector 71, the optical adjustment layer 72, the first electrode 31, and the second electrode 61 are similar to those in contents described in the first example, and thus the description thereof is omitted.

(Resonator structure: Fifth example)

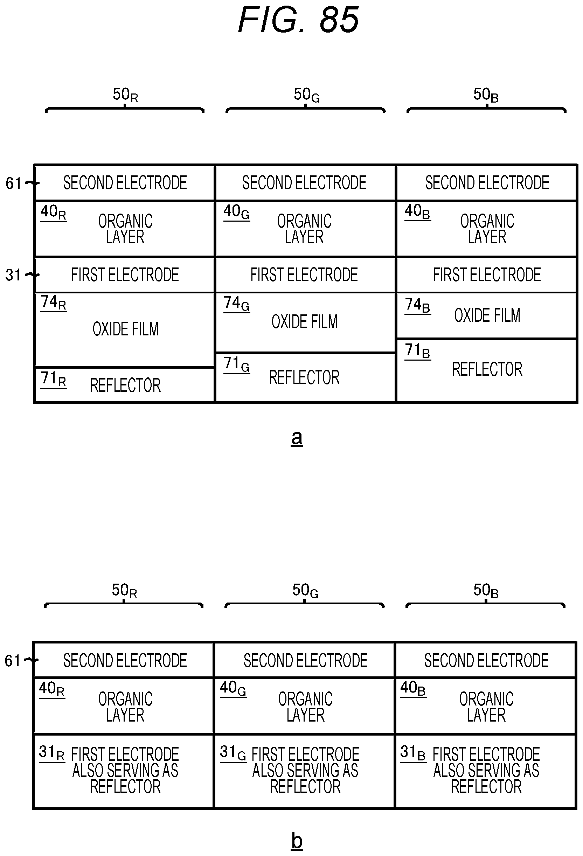

In Fig. 85, a is a schematic cross-sectional view for explaining a fifth example of the resonator structure.

In the first example illustrated in a of Fig. 83, each of the first electrode 31 and the second electrode 61 is formed to have a common film thickness in each light emitting unit 50. Then, the reflector 71 is disposed below the first electrode 31 of the light emitting unit 50 with the optical adjustment layer 72 interposed therebetween.

On the other hand, in the fifth example illustrated in a of Fig. 85, the optical adjustment layer 72 has been omitted, and instead, an oxide film 74 has been formed on a surface of the reflector 71. A film thickness of the oxide film 74 has been set to be different according to the types of the light emitting units 50R, 50G, and 50B.

The film thickness of the oxide film 74 is different according to the color to be displayed by the pixel. Since oxide films 74R, 74G, and 74B have different film thicknesses, it is possible to set an optical distance that causes optimum resonance for a wavelength of light according to the color to be displayed.

The oxide films 74 are films obtained by oxidizing the surfaces of the reflectors 71, and are formed with aluminum oxide, tantalum oxide, titanium oxide, magnesium oxide, zirconium oxide, or the like, for example. The oxide films 74 function as insulating films for adjusting the optical path lengths (optical distances) between the reflectors 71 and the second electrodes 61.

The oxide film 74 having different film thicknesses according to the types of the light emitting units 50R, 50G, and 50B can be formed, for example, as follows.

First, an electrolytic solution is filled in the container, and a substrate on which the reflector 71 is formed is immersed in the electrolytic solution. Furthermore, an electrode is disposed so as to face the reflector 71.

Then, a positive voltage is applied to the reflector 71 with reference to the electrode, and the reflector 71 is anodized. A film thickness of the oxide film due to the anodization is proportional to a voltage value for the electrode. Therefore, anodization is performed in a state where a voltage according to the type of the light emitting unit 50 is applied to each of the reflectors 71R, 71G, and 71B. As a result, the oxide films 74 having different film thicknesses can be collectively formed.

Materials and the like constituting the reflector 71, the first electrode 31, and the second electrode 61 are similar to those in contents described in the first example, and thus description thereof is omitted.

(Resonator structure: Sixth example)

In Fig. 85, b is a schematic cross-sectional view for explaining a sixth example of the resonator structure.
In the sixth example, the light emitting unit 50 is configured by stacking the first electrode 31, the organic layer 40, and the second electrode 61. However, in the sixth example, the first electrode 31 is formed to function as both an electrode and a reflector. The first electrode (also serving as a reflector) 31 is formed containing a material having an optical constant selected according to the type of the light emitting units 50R, 50G, and 50B. Since a phase shift by the first electrodes (also serving as reflectors) 31 vary, it is possible to set an optical distance that causes optimum resonance for a wavelength of light according to the color to be displayed.
The first electrodes (also serving as reflectors) 31 can be formed with a single-component metal such as aluminum (Al), silver (Ag), gold (Au), or copper (Cu), or an alloy containing these metals as the principal components. For example, the first electrode (also serving as a reflector) 50R of the light emitting unit 31R may be formed containing copper (Cu), and the first electrode (also serving as a reflector) 50G of the light emitting unit 31G and the first electrode (also serving as a reflector) 31B of the light emitting unit 50B may be formed containing aluminum.
Materials and the like constituting the second electrode 61 are similar to those in contents described in the first example, and thus the description thereof will be omitted.

(Resonator structure: Seventh example)

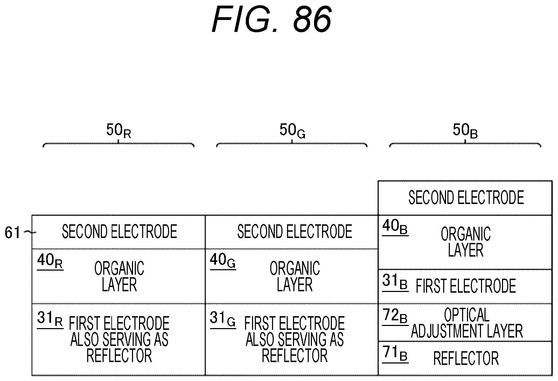

Fig. 86 is a schematic cross-sectional view for explaining a seventh example of the resonator structure.
In the seventh example, basically, the sixth example is applied to the light emitting units 50R and 50G, and the first example is applied to the light emitting unit 50B. Also in this configuration, it is possible to set an optical distance that causes optimum resonance for a wavelength of light according to the color to be displayed.
The first electrodes (also serving as reflectors) 31R and 31G used for the light emitting units 50R and 50G can be formed containing a single metal such as aluminum (Al), silver (Ag), gold (Au), or copper (Cu), or an alloy containing these as a main component.
Materials and the like constituting the reflector 71B, the optical adjustment layer 72B, and the first electrode 31B used for the light emitting unit 50B are similar to those in contents described in the first example, and thus description thereof is omitted.

[Electronic device]

The display device according to the present disclosure described above can be used as a display unit (display device) of an electronic device in all fields for displaying a video signal input to the electronic device or a video signal generated in the electronic device as an image or a video. As an example, for example, the display device can be used as a display unit of a television set, a digital still camera, a notebook personal computer, a mobile terminal device such as a mobile phone, a video camera, or a head-mounted display (display to be worn on a head).
Examples of a display device according to the present disclosure include a modular display device having a sealed configuration. As an example thereof includes a display module formed by adhering an opposing portion such as transparent glass to the pixel array unit. Note that, the display module may be provided with a circuit unit for inputting and outputting signals and the like from the outside to the pixel array unit, a flexible printed circuit (FPC) and the like. Hereinafter, a digital still camera and a head-mounted display will be exemplified as specific examples of an electronic device using a display device according to the present disclosure. However, the specific example exemplified here is merely an example, and the present technology is not limited thereto.

(Specific Example 1)

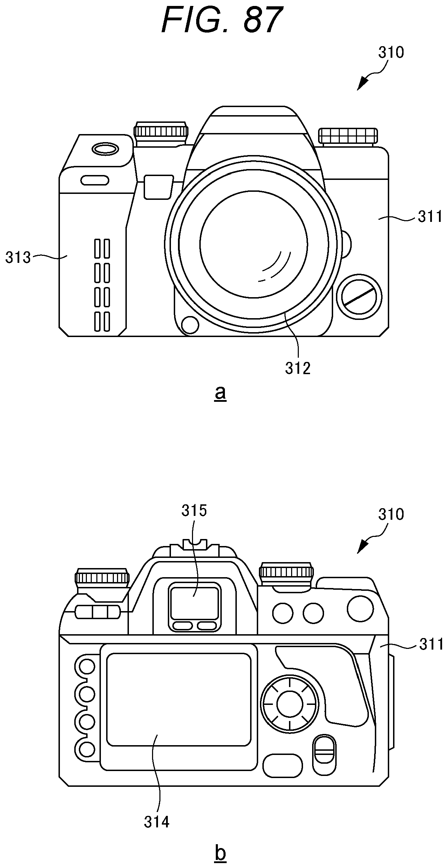

In Fig. 87, a and b illustrate an example of an external appearance of a digital still camera 310. The digital still camera 310 is of a lens interchangeable single-lens reflex type, and includes an interchangeable imaging lens unit (interchangeable lens) 312 substantially at the center on the front surface of a camera main body (camera body) 311, and a grip 313 to be held by the photographer on the front left side.
A monitor 314 is provided at a position shifted to the left side from the center of the rear surface of the camera main body 311. An electronic viewfinder (eyepiece window) 315 is provided above the monitor 314. By looking through the electronic viewfinder 315, the photographer can visually recognize an optical image of the subject guided from the imaging lens unit 312, and determine a picture composition. As the electronic viewfinder 315, the display device 100 according to one of the above-described embodiment and modifications thereof can be used.

(Specific Example 2)

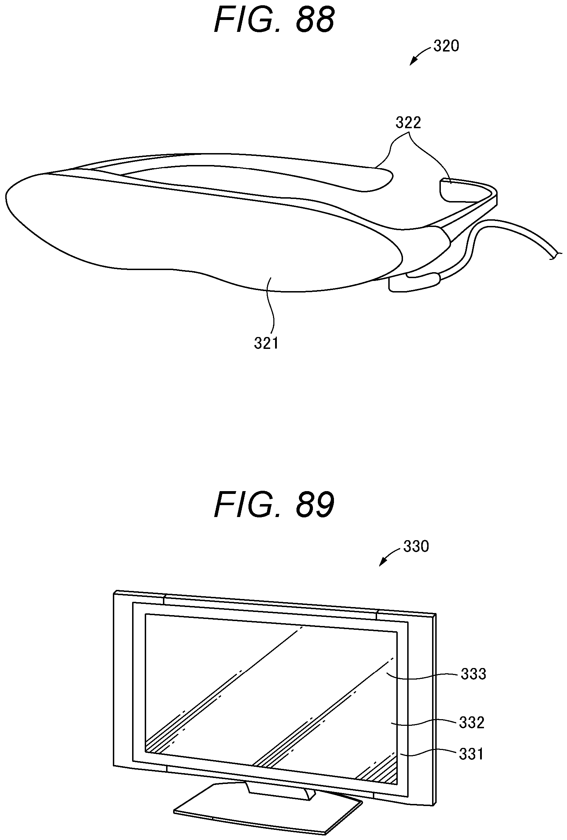

Fig. 88 illustrates an example of an external appearance of a head-mounted display 320. The head-mounted display 320 includes ear hooking portions 322 to be worn on the head of the user on both sides of a display unit 321 in the shape of eyeglasses, for example. As the display unit 321, any display device 100 according to one of the above-described embodiment and modifications thereof can be used.

(Specific Example 3)

Fig. 89 illustrates an example of an external appearance of a television device 330. The television device 330 includes, for example, a video display screen unit 331 including a front panel 332 and a filter glass 333, and the video display screen unit 331 includes the display device 100 according to one of the above-described embodiment and modifications thereof.

(Specific Example 4)

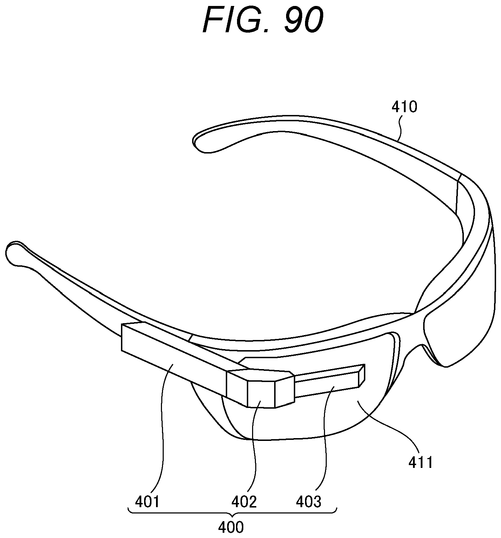

Fig. 90 is an external view of a see-through head-mounted display. A see-through head-mounted display 400 includes a main body 401, an arm 402, and a lens barrel 403.

The main body 401 is connected to the arm 402 and eyeglasses 410. Specifically, an end portion of the main body 401 in the long side direction is coupled to the arm 402, and one side of a side surface of the main body 401 is coupled to the eyeglasses 410 via a connecting member. Note that the main body 401 may be directly mounted on the head of the human body.

The main body 401 incorporates a control board for controlling operation of the see-through head-mounted display 400, and a display unit. The arm 402 connects the main body 401 and the lens barrel 403, and supports the lens barrel 403. Specifically, the arm 402 is coupled to an end portion of the main body 401 and an end portion of the lens barrel 403, and secures the lens barrel 403. Furthermore, the arm 402 incorporates a signal line for communicating data related to an image to be provided from the main body 401 to the lens barrel 403.

The lens barrel 403 projects image light provided from the main body 401 via the arm 402 toward the eyes of the user wearing the see-through head-mounted display 400 through an eyeglass. In the see-through head-mounted display 400, a display device according to the present disclosure can be used for the display unit of the main body 401.

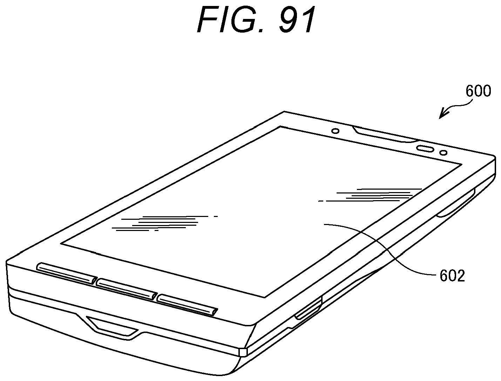

For example, the display device 100 according to the present embodiment can be applied to a display unit included in an electronic device such as a smartphone. Specifically, as illustrated in Fig. 91, a smartphone 600 includes a display unit 602 that displays various kinds of information, an operating unit that includes buttons and the like for receiving an operating input by the user, and the like. The display unit 602 described above can be the display device 100 according to the present embodiment.

(Application Examples of Display Device 100 and Electronic Device According to Present Disclosure)

(First application example)

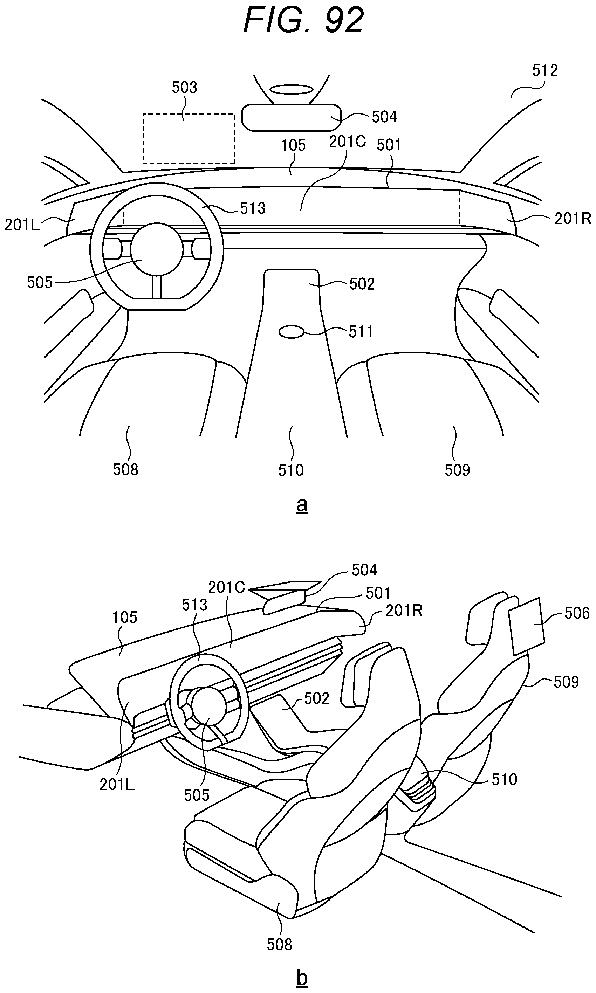

The display device 100 and the electronic device according to the present disclosure can be used for various applications. In Fig. 92, a and b are views illustrating an internal configuration of a vehicle which is a first application example of an electronic device including the display device 100 according to the present disclosure. In Fig. 92, a is a view illustrating an internal state of the vehicle from a rear side to a front side of the vehicle, and b of Fig. 92 is a view illustrating an internal state of the vehicle from an oblique rear side to an oblique front side of the vehicle.

The vehicle in a and b of Fig. 92 includes a center display 501, a console display 502, a head-up display 503, a digital rearview mirror 504, a steering wheel display 505, and a rear entertainment display 506.

The center display 501 is disposed on a dashboard at a location facing a driver's seat 508 and a passenger seat 509. Fig. 92 illustrates an example of the center display 501 having a horizontally long shape extending from the driver's seat 508 side to the passenger seat 509 side, but any screen size and arrangement location of the center display 501 may be adopted. The center display 501 can display information sensed by various sensors. As a specific example, the center display 501 can display a captured image captured by an image sensor, an image of a distance to an obstacle in front of or on a side of the vehicle, the distance being measured by a ToF sensor, a passenger's body temperature detected by an infrared sensor, and the like. The center display 501 can be used to display, for example, at least one of safety-related information, operation-related information, a life log, health-related information, authentication/identification-related information, or entertainment-related information.

The safety-related information is information about doze sensing, looking-away sensing, sensing of mischief of a child riding together, presence or absence of wearing of a seat belt, sensing of leaving of an occupant, and the like, and is information sensed by a sensor disposed to overlap with the back surface side of the center display 501, for example. The operation-related information senses a gesture related to an operation performed by an occupant, using a sensor. Gestures to be sensed may include an operation of various kinds of equipment in a vehicle 500. For example, operations of air conditioning equipment, a navigation device, an audiovisual (AV) device, an illuminating device, and the like are detected. The lifelogs include lifelogs of all the occupants. For example, the life log includes an action record of each occupant in the vehicle. By acquiring and storing the life log, it is possible to check a state of the occupant at a time of an accident. The health-related information senses the body temperature of an occupant, using a sensor such as a temperature sensor, and estimates the health condition of the occupant on the basis of the sensed body temperature. Alternatively, the face of the occupant may be imaged with an image sensor, and the health condition of the occupant may be estimated from the imaged facial expression. Moreover, a conversation may be made with an occupant in automatic voice, and the health condition of the occupant may be estimated on the basis of the contents of a response from the occupant. The authentication/identification-related information includes a keyless entry function of performing face authentication using a sensor, and a function of automatically adjusting a seat height and position through face identification. The entertainment-related information includes a function of detecting, with a sensor, operation information about an AV device being used by an occupant, and a function of recognizing the face of the occupant with sensor and providing content suitable for the occupant through the AV device.

The console display 502 can be used, for example, to display the life log information. The console display 502 is disposed near a shift lever 511 of a center console 510 between the driver's seat 508 and the passenger seat 509. The console display 502 can also display information detected by various sensors. Furthermore, the console display 502 may display an image of the surroundings of the vehicle captured with an image sensor, or may display an image of the distance to an obstacle present in the surroundings of the vehicle.

The head-up display 503 is virtually displayed behind a windshield 512 in front of the driver's seat 508. The head-up display 503 can be used to display, for example, at least one of the safety-related information, the operation-related information, the life log, the health-related information, the authentication/identification-related information, or the entertainment-related information. Being virtually disposed in front of the driver's seat 508 in many cases, the head-up display 503 is suitable for displaying information directly related to operations of the vehicle 500, such as the speed, the remaining amount of fuel (battery), and the like of the vehicle 500.

The digital rearview mirror 504 can not only display the rear of the vehicle but also display the state of an occupant in the rear seat, and thus, can be used to display the lifelog information by disposing a sensor on the back surface side of the digital rearview mirror 504 in an overlapping manner, for example.

The steering wheel display 505 is disposed near the center of a steering wheel 513 of the vehicle. The steering wheel display 505 can be used to display, for example, at least one of the safety-related information, the operation-related information, the life log, the health-related information, the authentication/identification-related information, or the entertainment-related information. In particular, being located close to the driver's hands, the steering wheel display 505 is suitable for displaying the lifelog information such as the body temperature of the driver, or for displaying information regarding operations of the AV device, the air conditioning equipment, or the like.

The rear entertainment display 506 is attached to the back side of the driver's seat 508 or the passenger seat 509, and is for an occupant in the rear seat to enjoy viewing/listening. The rear entertainment display 506 can be used to display, for example, at least one of the safety-related information, the operation-related information, the life log, the health-related information, the authentication/identification-related information, or the entertainment-related information. In particular, as the rear entertainment display 506 is located in front of an occupant in the rear seat, information related to the occupant in the rear seat is displayed. For example, information regarding an operation of the AV device or the air conditioning equipment may be displayed, or a result of measurement of the body temperature or the like of an occupant in the rear seat with a temperature sensor may be displayed.

As described above, disposing a sensor on the back surface side of the display device 100 makes it possible to measure the distance to an object existing in the surroundings. Optical distance measurement methods are roughly classified into a passive type and an active type. By a method of the passive type, distance measurement is performed by receiving light from an object, without projecting light from a sensor to the object. Methods of the passive type include a lens focus method, a stereo method, and a monocular vision method. Methods of the active type include distance measurement that is performed by projecting light onto an object, and receiving reflected light from the object with a sensor to measure the distance. Methods of the active type include an optical radar method, an active stereo method, an illuminance difference stereo method, a moire topography method, and an interference method. The display device 100 according to the present disclosure can be used in distance measurement by any of these methods. With a sensor disposed on the back surface side of the display device 100 according to the present disclosure in an overlapping manner, distance measurement of the passive type or the active type described above can be performed.

Note that the embodiments described above show examples for embodying the present technology, and the matters in the embodiments and the matters specifying the invention in the claims have corresponding relationships, respectively. Similarly, the matters specifying the invention in the claims and matters with the same names in the embodiments of the present technology have correspondence relationships. However, the present technology is not limited to the embodiments, and can be embodied by applying various modifications to the embodiments without departing from the gist of the present technology.

Note that effects described in the present specification are merely examples and are not limited, and other effects may be provided.

Note that the present technology may also have the following configurations.

(1) A display device including:

a first electrode and a second electrode having different polarities; and
an organic EL film formed between the first electrode and the second electrode when viewed from a direction that is parallel to a predetermined plane, the organic EL film being formed in a predetermined number of sub-pixels and a connection portion that is a portion mutually connecting adjacent sub-pixels in an interpixel region between the predetermined number of sub-pixels, when viewed from a vertical direction that is vertical to the predetermined plane.

(2) The display device according to (1) above, in which
the connection portion is a part of the inter-pixel region.
(3) The display device according to (1) or (2) above, in which

the first electrode is formed for every sub-pixel among the sub-pixels in a predetermined region surrounding the sub-pixel when viewed from the vertical direction, and
the second electrode is formed in the predetermined number of sub-pixels and in the connection portion when viewed from the vertical direction.

(4) The display device according to any one of (1) to (3) above, further including:

a protective film covering a pixel array unit in which the predetermined number of sub-pixels are arranged, in which
a film thickness of a predetermined portion of the protective film covering the predetermined number of sub-pixels is larger than a film thickness of a portion that is not considered as the predetermined portion.

(5) The display device according to any one of (1) to (4) above, in which
the connection portion is formed in a portion that is not considered as a rectangular region in the inter-pixel region.
(6) The display device according to any one of (1) to (5) above, in which

the predetermined number of sub-pixels are arranged in the pixel array unit, and
a width of the second electrode is a value according to a distance from a central portion of the pixel array unit.

(7) The display device according to any one of (1) to (5) above, in which

one end of the connection portion is connected to one of a pair of adjacent sub-pixels among the predetermined number of sub-pixels,
another end of the connection portion is connected to another one of the pair of sub-pixels, and
a width of the one end is different from a width of the another end.

(8) The display device according to (7) above, in which

the predetermined number of sub-pixels are arranged in the pixel array unit, and
the width is a value according to a distance from a center of the pixel array unit.

(9) The display device according to (1) above, in which

the connection portion includes first and second connection portions having a rectangular shape, and
a pair of adjacent sub-pixels among the predetermined number of sub-pixels are connected by the first and second connection portions.

(10) The display device according to (1) above, in which
an edge of the connection portion has an arc shape.
(11) The display device according to (1) above, in which
a width of a center of the connection portion is wider than widths of both ends of the connection portion.
(12) The display device according to (11) above, in which
an opened region in which the organic EL film is not formed is provided in a central portion of the connection portion.
(13) The display device according to (1) above, in which
the organic EL film is formed in the predetermined number of sub-pixels, in the connection portion, and in a bridge region mutually connecting the connection portions in the inter-pixel region, when viewed from the vertical direction.
(14) The display device according to any one of (1) to (13) above, in which
a shape of the sub-pixel is a figure in which a core portion and a plurality of protrusions are combined when viewed from the vertical direction.
(15) The display device according to any one of (1) to (13) above, in which

a shape of the organic EL film as viewed from the vertical direction is a shape having a predetermined number of bent portions.

(16) The display device according to any one of (1) to (15) above, in which

unevenness is formed on a side wall of the sub-pixel when viewed from a direction that is parallel to the predetermined plane.

(17) The display device according to any one of (1) to (16) above, in which

the predetermined number of sub-pixels are arranged in a delta array.

(18) The display device according to any one of (1) to (17) above, in which

the predetermined number of sub-pixels are arranged in a square array.

(19) The display device according to any one of (1) to (18) above, in which

the predetermined number of sub-pixels are arranged in a stripe array.

(20) The display device according to any one of (1) to (19) above, in which

the organic EL film is formed in a frame surrounding a predetermined number of the sub-pixels, in a predetermined number of the sub-pixels, and in the connection portion when viewed from the vertical direction,

a plurality of openings is formed in the organic EL film when viewed from the vertical direction,

the plurality of openings includes a first opening having at least one edge in contact with the frame and a second opening that is not considered as the first opening, and

a smallest angle among angles formed by two edges of the first opening does not exceed a smallest angle among angles formed by two edges of the second opening.

REFERENCE SIGNS LIST

31 First electrode

40 Organic layer

50 Light emitting unit

61 Second electrode

71 Reflector

72 Optical adjustment layer

73 Base

74 Oxide film

100 DISPLAY DEVICE

111 Control circuit

112 H driver

113 V driver

120 Pixel array unit

200 Pixel

201 to 203 Sub-pixel

210, 211, 212 Protective film

215 Texture film

221 Cathode electrode

222 Organic EL film

222-1 Frame

223 Anode electrode

224 Cathode contact electrode

230 Insulating film

240 Substrate

250 Photoresist

261 On-chip lens

262 Color filter

270 Low refractive index film

281, 281-1, 281-2, 281-3, 281-4, 281-5, 281-6, 281-7, 281-8, 282 Opening

310 Digital still camera

311 Camera main body

312 Imaging lens unit

313 Grip

314 Monitor

315 Electronic viewfinder

320 Head-mounted display

321 Display unit

322 Ear hooking portion

330 Television device

331 Video display screen unit

332 Front panel

333 Filter glass

400 See-through head-mounted display

401 Main body

402 Arm

403 Lens barrel

410 Eyeglasses

501 Center display

502 Console display

503 Head-up display

504 Digital rearview mirror

505 Steering wheel display

506 Rear entertainment display

508 Driver's seat

509 Passenger seat

510 Center console

511 Shift lever

512 Windshield

513 Steering wheel

600 Smartphone

602 Display unit

## Claims

1. A display device comprising:

   a first electrode and a second electrode having different polarities; and
   an organic EL film formed between the first electrode and the second electrode when viewed from a direction that is parallel to a predetermined plane, the organic EL film being formed in a predetermined number of sub-pixels and a connection portion that is a portion mutually connecting adjacent sub-pixels in an inter-pixel region between the predetermined number of sub-pixels, when viewed from a vertical direction that is vertical to the predetermined plane.

2. The display device according to claim 1, wherein the connection portion is a part of the inter-pixel region.

3. The display device according to claim 1, wherein

   the first electrode is formed for every sub-pixel among the sub-pixels in a predetermined region surrounding the sub-pixel when viewed from the vertical direction, and
   the second electrode is formed in the predetermined number of sub-pixels and the connection portion when viewed from the vertical direction.

4. The display device according to claim 1, further comprising:

   a protective film covering a pixel array unit in which the predetermined number of sub-pixels are arranged, wherein
   a film thickness of a predetermined portion of the protective film covering the predetermined number of sub-pixels is larger than a film thickness of a portion that is not considered as the predetermined portion.

5. The display device according to claim 1, wherein the connection portion is formed in a portion that is not considered as a rectangular region in the inter-pixel region.

6. The display device according to claim 1, wherein

   the predetermined number of sub-pixels are arranged in the pixel array unit, and
   a width of the second electrode is a value according to a distance from a central portion of the pixel array unit.

7. The display device according to claim 1, wherein

   one end of the connection portion is connected to one of a pair of adjacent sub-pixels among the predetermined number of sub-pixels,
   another end of the connection portion is connected to another one of the pair of sub-pixels, and
   a width of the one end is different from a width of the another end.

8. The display device according to claim 7, wherein

    the predetermined number of sub-pixels are arranged in the pixel array unit, and
    the width is a value according to a distance from a center of the pixel array unit.

9. The display device according to claim 1, wherein

    the connection portion includes first and second connection portions having a rectangular shape, and
    a pair of adjacent sub-pixels among the predetermined number of sub-pixels are connected by the first and second connection portions.

10. The display device according to claim 1, wherein an edge of the connection portion has an arc shape.

11. The display device according to claim 1, wherein a width of a center of the connection portion is wider than widths of both ends of the connection portion.

12. The display device according to claim 11, wherein an opened region in which the organic EL film is not formed is provided in a central portion of the connection portion.

13. The display device according to claim 1, wherein the organic EL film is formed in the predetermined number of sub-pixels, in the connection portion, and in a bridge region mutually connecting the connection portions in the inter-pixel region, when viewed from the vertical direction.

14. The display device according to claim 1, wherein a shape of the sub-pixel is a figure in which a core portion and a plurality of protrusions are combined when viewed from the vertical direction.

15. The display device according to claim 1, wherein a shape of the organic EL film as viewed from the vertical direction is a shape having a predetermined number of bent portions.

16. The display device according to claim 1, wherein unevenness is formed on a side wall of the sub-pixel when viewed from a direction that is parallel to the predetermined plane.

17. The display device according to claim 1, wherein the predetermined number of sub-pixels are arranged in a delta array.

18. The display device according to claim 1, wherein the predetermined number of sub-pixels are arranged in a square array.

19. The display device according to claim 1, wherein the predetermined number of sub-pixels are arranged in a stripe array.

20. The display device according to claim 1, wherein

    the organic EL film is formed in a frame surrounding a predetermined number of the sub-pixels, in a predetermined number of the sub-pixels, and in the connection portion when viewed from the vertical direction,
    a plurality of openings is formed in the organic EL film when viewed from the vertical direction,
    the plurality of openings includes a first opening having at least one edge in contact with the frame and a second opening that is not considered as the first opening, and
    a smallest angle among angles formed by two edges of the first opening does not exceed a smallest angle among angles formed by two edges of the second opening.

# FIG. 1

# FIG. 2

120

a

b

# FIG. 3

a

b

# FIG. 4

a

b

# FIG. 5

a

b

c

# FIG. 6

a

b

# FIG. 7

# FIG. 8

# FIG. 9

# FIG. 10

# FIG. 11

# FIG. 12

# FIG. 13

# FIG. 14

# FIG. 15

# FIG. 16

# FIG. 17

# FIG. 18

# FIG. 19

120

222

223

# FIG. 20

# FIG. 21

# FIG. 22

<u>120</u>

# FIG. 23

# FIG. 24

# FIG. 25

# FIG. 26

# FIG. 27

# FIG. 28

## FIG. 29

## FIG. 30

# FIG. 31

# FIG. 32

# FIG. 33

# FIG. 34

## FIG. 35

## FIG. 36

# FIG. 37

120

a

b

# FIG. 38

# FIG. 39

<u>120</u>

261

262

(B)    (R)    (G)    270

211

221

222

230    223

Z
X
Y

# FIG. 40

a

b

# FIG. 41

201

a

201

b

201

c

201

d

## FIG. 42

201

a

201

b

# FIG. 43

a

b

c

# FIG. 44

a

b

# FIG. 45

<u>a</u>

<u>b</u>

# FIG. 46

201 (R) 202 (G) 203 (B)

(R) (G) (B)

a

201 (R) 202 (G) 203 (B)

(R) (G) (B)

Y

Z X

b

# FIG. 47

a

b

# FIG. 48

a

b

EP 4 495 920 A1

# FIG. 49

a

b

78

# FIG. 50

a

b

# FIG. 51

(R)  222

Xa — · — · — · — · — Xb

(G)

(B)

Y
↑
⊙→X
Z

a

270
211
221
222
223

Z
↑
⊗→X
Y

b

# FIG. 52

211

221
222
223

a

250

211

221
222
223

Z

Y ⊗ → X

b

# FIG. 53

# FIG. 54

222

a

Y1
Y2
Y3

222

b

222

201

202

Y

Z ⊙ → X

c

# FIG. 55

222

a

222

Y

Z

X

b

# FIG. 56

# FIG. 57

# FIG. 58

# FIG. 59

# FIG. 60

# FIG. 61

a

b

# FIG. 62

211

212
221
222
230
223

240

<u>a</u>

211
212

<u>b</u>

270

Z

X

Y

<u>c</u>

# FIG. 63

| SUB-PIXEL (R) | SUB-PIXEL (B) |
| SUB-PIXEL (B) | SUB-PIXEL (G) |

a

| SUB-PIXEL (R) | SUB-PIXEL (W) |
| SUB-PIXEL (B) | SUB-PIXEL (G) |

b

SUB-PIXEL (R), SUB-PIXEL (B), SUB-PIXEL (G)

c

SUB-PIXEL (R), SUB-PIXEL (W), SUB-PIXEL (B), SUB-PIXEL (G)

d

SUB-PIXEL (B), SUB-PIXEL (R), SUB-PIXEL (G)

Y, X, Z

e

SUB-PIXEL (B), SUB-PIXEL (R), SUB-PIXEL (G), SUB-PIXEL (W)

f

# FIG. 64

| SUB-PIXEL (R) | SUB-PIXEL (B) |
|---|---|
| SUB-PIXEL (B) | SUB-PIXEL (G) |

~224

a

| SUB-PIXEL (R) | SUB-PIXEL (W) |
|---|---|
| SUB-PIXEL (B) | SUB-PIXEL (G) |

b

224

SUB-PIXEL (R)

SUB-PIXEL (B)  SUB-PIXEL (G)

c

SUB-PIXEL (R)  SUB-PIXEL (W)

SUB-PIXEL (B)  SUB-PIXEL (G)

d

224

SUB-PIXEL (B)  SUB-PIXEL (R)  SUB-PIXEL (G)

Y
↑
⊙→ X
Z

e

SUB-PIXEL (B)  SUB-PIXEL (R)  SUB-PIXEL (G)  SUB-PIXEL (W)

f

93

# FIG. 65

261

262 (R)  (G)  (B)

270

215
211
212
221
222
230
223

240

Z
↑
⊗→ X
Y

# FIG. 66

211
212
221
222
230
223

240

a

215

240

b

270

Z
X
Y

c

# FIG. 67

a

b

# FIG. 68

# FIG. 69

a

b

c

d

# FIG. 70

# FIG. 71

261

262 (R) (G) (B)

270

211
212
221
222
230
223

240

<u>a</u>

261

262 (R) (G) (B)

270

211
212
221
222
230
223

240

Z

X

Y

<u>b</u>

# FIG. 72

# FIG. 73

a

b

c

# FIG. 74

a

b

# FIG. 75

# FIG. 76

a

b

# FIG. 77

a

b

## FIG. 78

## FIG. 79

LN ⋮ LN'
LN" ⋮

| LENS MEMBER |
| WAVELENGTH SELECTION UNIT |
| LIGHT EMITTING UNIT |

a

LN ⋮ ⋮ LN'
LN" ⋮ ⋮

| LENS MEMBER |
| WAVELENGTH SELECTION UNIT |
| LIGHT EMITTING UNIT |

b

LN ⋮ ⋮ LN'
⋮ ⋮ LN"

| LENS MEMBER |
| WAVELENGTH SELECTION UNIT |
| LIGHT EMITTING UNIT |

c

# FIG. 80

# FIG. 81

LN ┊ LN'
LN" ┊

| WAVELENGTH SELECTION UNIT | |
|---|---|

| LENS MEMBER | |
|---|---|

| LIGHT EMITTING UNIT | |
|---|---|

<u>a</u>

LN ┊ ┊ LN'
┊ ┊ LN"

| WAVELENGTH SELECTION UNIT | |
|---|---|

| LENS MEMBER | |
|---|---|

| LIGHT EMITTING UNIT | |
|---|---|

<u>b</u>

# FIG. 82

LN"

LN'

LN

$d_0$

$D_0$

LL

WAVELENGTH SELECTION UNIT

LENS MEMBER

LIGHT EMITTING UNIT

$LL_1$

$LL_2$

# FIG. 83

|  | 50_R | 50_G | 50_B |
|---|---|---|---|
| 61 | SECOND ELECTRODE | | |
| | 40_R ORGANIC LAYER | SECOND ELECTRODE | |
| 31 | FIRST ELECTRODE | 40_G ORGANIC LAYER | SECOND ELECTRODE |
| | 72_R OPTICAL ADJUSTMENT LAYER | FIRST ELECTRODE | 40_B ORGANIC LAYER |
| | | 72_G OPTICAL ADJUSTMENT LAYER | FIRST ELECTRODE |
| 71 | REFLECTOR | REFLECTOR | 72_B OPTICAL ADJUSTMENT LAYER |
| | | | REFLECTOR |

a

|  | 50_R | 50_G | 50_B |
|---|---|---|---|
| 61 | SECOND ELECTRODE | SECOND ELECTRODE | SECOND ELECTRODE |
| | 40_R ORGANIC LAYER | 40_G ORGANIC LAYER | 40_B ORGANIC LAYER |
| 31 | FIRST ELECTRODE | FIRST ELECTRODE | FIRST ELECTRODE |
| | 72_R OPTICAL ADJUSTMENT LAYER | 72_G OPTICAL ADJUSTMENT LAYER | 72_B OPTICAL ADJUSTMENT LAYER |
| | | | REFLECTOR |
| | | REFLECTOR | 73 |
| 71 | REFLECTOR | | |

b

# FIG. 84

|  | 50R | 50G | 50B |
|---|---|---|---|
| 61 | SECOND ELECTRODE | SECOND ELECTRODE | SECOND ELECTRODE |
|  | 40R ORGANIC LAYER | 40G ORGANIC LAYER | 40B ORGANIC LAYER |
| 31 | FIRST ELECTRODE | FIRST ELECTRODE | FIRST ELECTRODE |
|  | 72R OPTICAL ADJUSTMENT LAYER | 72G OPTICAL ADJUSTMENT LAYER | 72B OPTICAL ADJUSTMENT LAYER |
|  |  | 71G REFLECTOR | 71B REFLECTOR |
|  | 71R REFLECTOR |  |  |

a

|  | 50R | 50G | 50B |
|---|---|---|---|
| 61 | SECOND ELECTRODE | | |
|  | 40R ORGANIC LAYER | SECOND ELECTRODE | |
|  | 31R | 40G ORGANIC LAYER | SECOND ELECTRODE |
|  | FIRST ELECTRODE | 31G | 40B ORGANIC LAYER |
|  | | FIRST ELECTRODE | 31B FIRST ELECTRODE |
| 71 | REFLECTOR | REFLECTOR | REFLECTOR |

b

113

# FIG. 85

$50_R$      $50_G$      $50_B$

| 61 | SECOND ELECTRODE | SECOND ELECTRODE | SECOND ELECTRODE |
|---|---|---|---|
| | $40_R$ ORGANIC LAYER | $40_G$ ORGANIC LAYER | $40_B$ ORGANIC LAYER |
| 31 | FIRST ELECTRODE | FIRST ELECTRODE | FIRST ELECTRODE |
| | $74_R$ OXIDE FILM | $74_G$ OXIDE FILM | $74_B$ OXIDE FILM |
| | | $71_G$ REFLECTOR | $71_B$ REFLECTOR |
| | $71_R$ REFLECTOR | | |

<u>a</u>

$50_R$      $50_G$      $50_B$

| 61 | SECOND ELECTRODE | SECOND ELECTRODE | SECOND ELECTRODE |
|---|---|---|---|
| | $40_R$ ORGANIC LAYER | $40_G$ ORGANIC LAYER | $40_B$ ORGANIC LAYER |
| | $31_R$ FIRST ELECTRODE ALSO SERVING AS REFLECTOR | $31_G$ FIRST ELECTRODE ALSO SERVING AS REFLECTOR | $31_B$ FIRST ELECTRODE ALSO SERVING AS REFLECTOR |

<u>b</u>

# FIG. 86

| 50R | 50G | 50B |
|---|---|---|

| | | SECOND ELECTRODE |
|---|---|---|
| SECOND ELECTRODE | SECOND ELECTRODE | 40B  ORGANIC LAYER |
| 40R  ORGANIC LAYER | 40G  ORGANIC LAYER | 31B  FIRST ELECTRODE |
| 31R  FIRST ELECTRODE ALSO SERVING AS REFLECTOR | 31G  FIRST ELECTRODE ALSO SERVING AS REFLECTOR | 72B  OPTICAL ADJUSTMENT LAYER |
| | | 71B  REFLECTOR |

61

# FIG. 87

a

b

# FIG. 88

320

322

321

# FIG. 89

330

333

332

331

# FIG. 90

## FIG. 91

# FIG. 92

a

b

## INTERNATIONAL SEARCH REPORT

International application No.

**PCT/JP2023/009274**

### A. CLASSIFICATION OF SUBJECT MATTER

*G09F 9/30*(2006.01)i; *G09F 9/302*(2006.01)i; *H05B 33/02*(2006.01)i; *H05B 33/04*(2006.01)i; *H05B 33/12*(2006.01)i; *H05B 33/22*(2006.01)i; *H10K 50/00*(2023.01)i; *H10K 59/00*(2023.01)i

FI: G09F9/30 338; G09F9/30 349Z; G09F9/30 365; G09F9/302 C; H05B33/02; H05B33/04; H05B33/12 B; H05B33/14 A; H05B33/22 Z; H10K59/00

According to International Patent Classification (IPC) or to both national classification and IPC

### B. FIELDS SEARCHED

Minimum documentation searched (classification system followed by classification symbols)

G09F9/30; G09F9/302; H05B33/02; H05B33/04; H05B33/12; H05B33/22; H10K50/00; H10K59/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2019-125501 A (JOLED INC) 25 July 2019 (2019-07-25) paragraphs [0038]-[0069], fig. 1-4 | 1-4, 14, 19 |
| Y | paragraphs [0038]-[0069], fig. 1-4 | 6 |
| X | JP 1-4,14,19 A (SEIKO EPSON CORP) 30 August 2007 (2007-08-30) paragraphs [0015]-[0034], fig. 1-2 | 1-3, 7-11, 14, 18 |
| Y | paragraphs [0015]-[0034], fig. 1-2 | 6 |
| X | JP 2019-067525 A (CANON KABUSHIKI KAISHA) 25 April 2019 (2019-04-25) paragraphs [0015]-[0068], fig. 1-4 | 1-3, 5, 14, 17 |
| Y | paragraphs [0015]-[0068], fig. 1-4 | 6 |
| Y | JP 2014-098909 A (JAPAN DISPLAY INC) 29 May 2014 (2014-05-29) paragraph [0033], fig. 4 | 6 |

☑ Further documents are listed in the continuation of Box C.　　☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **17 April 2023** | **09 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

| | **INTERNATIONAL SEARCH REPORT** | International application No. |
|---|---|---|
| | | **PCT/JP2023/009274** |

**C.** **DOCUMENTS CONSIDERED TO BE RELEVANT**

| Category* | Citation of document, with indication, where appropriate, of the relevant passages | Relevant to claim No. |
|---|---|---|
| A | WO 2019/220948 A1 (SONY SEMICONDUCTOR SOLUTIONS CORPORATION) 21 November 2019 (2019-11-21) entire text, all drawings | 1-20 |
| A | JP 2018-092921 A (LG DISPLAY CO., LTD.) 14 June 2018 (2018-06-14) entire text, all drawings | 1-20 |
| A | US 2019/0006626 A1 (LG DISPLAY CO., LTD.) 03 January 2019 (2019-01-03) entire text, all drawings | 1-20 |
| A | KR 10-2017-0062436 A (LG DISPLAY CO., LTD.) 07 June 2017 (2017-06-07) entire text, all drawings | 1-20 |

INTERNATIONAL SEARCH REPORT
Information on patent family members

International application No.

**PCT/JP2023/009274**

| Patent document cited in search report | | | Publication date (day/month/year) | Patent family member(s) | | | Publication date (day/month/year) |
|---|---|---|---|---|---|---|---|
| JP | 2019-125501 | A | 25 July 2019 | (Family: none) | | | |
| JP | 2007-220580 | A | 30 August 2007 | (Family: none) | | | |
| JP | 2019-067525 | A | 25 April 2019 | US | 2019-0096971 | A1 | |
| | | | | paragraphs [0037]-[0091], fig. 1-4 | | | |
| JP | 2014-098909 | A | 29 May 2014 | (Family: none) | | | |
| WO | 2019/220948 | A1 | 21 November 2019 | US | 2021-0111228 | A1 | |
| | | | | entire text, all drawings | | | |
| | | | | CN | 112088580 | A | |
| | | | | KR | 10-2021-0009313 | A | |
| JP | 2018-092921 | A | 14 June 2018 | US | 2018-0158882 | A1 | |
| | | | | entire text, all drawings | | | |
| US | 2019/0006626 | A1 | 03 January 2019 | CN | 109216579 | A | |
| | | | | entire text, all drawings | | | |
| | | | | KR | 10-2019-0003216 | A | |
| KR | 10-2017-0062436 | A | 07 June 2017 | (Family: none) | | | |

Form PCT/ISA/210 (patent family annex) (January 2015)

**EP 4 495 920 A1**

## REFERENCES CITED IN THE DESCRIPTION

**Patent documents cited in the description**

- JP 2014232568 A